# EUROPEAN PATENT APPLICATION

(11) **EP 4 769 649 A1**
(43) Date of publication of application: **01.07.2026**
(21) Application number: 24869762.5
(22) Date of filing: 21.05.2024
(51) Int. Cl.: H01M 10/613

(54) **ENERGY STORAGE DEVICE AND PHOTOVOLTAIC ENERGY STORAGE SYSTEM**

(30) Priority: 28.09.2023 CN 202311286910
(71) Applicant: Huawei Digital Power Technologies Co., Ltd., Shenzhen, Guangdong 518043 (CN)
(72) Inventor: LI, Malin, Shenzhen, Guangdong 518043 (CN); WONG, Ming Fung, Shenzhen, Guangdong 518043 (CN); LU, Linfeng, Shenzhen, Guangdong 518043 (CN); CHENG, Peng, Shenzhen, Guangdong 518043 (CN)
(74) Representative: Gill Jennings & Every LLP
(86) International application number: PCT/CN2024/094510
(87) International publication number: WO 2025/066196

(57) **Abstract**

This application provides an energy storage device and a photovoltaic energy storage system. The energy storage device includes a heat management module, a battery module, a first power unit, a second power unit, and a radiator module. The heat management module includes a housing, and a multi-way valve, a first evaporator, and a condenser that are disposed in the housing. The housing includes a plurality of first interfaces. Two coolant ports of the first evaporator are connected to the multi-way valve, and two coolant ports of the condenser are connected between the multi-way valve and one of the first interfaces. The battery module includes a battery heat exchange plate, the first power unit includes a first power circuit heat exchange plate, the second power unit includes a second power circuit heat exchange plate, and the radiator module includes a radiator. The battery heat exchange plate, the first power circuit heat exchange plate, the second power circuit heat exchange plate, and the radiator are connected to the multi-way valve through corresponding first interfaces respectively. The energy storage device can efficiently adjust and control temperatures of a battery and the two power circuit heat exchange plates.

## Description

### CROSS-REFERENCE TO RELATED APPLICATIONS

This application claims priority to Chinese Patent Application No. 202311286910.6, filed with the China National Intellectual Property Administration on September 28, 2023 and entitled "ENERGY STORAGE DEVICE AND PHOTOVOLTAIC ENERGY STORAGE SYSTEM", which is incorporated herein by reference in its entirety.

### TECHNICAL FIELD

This application relates to the field of energy technologies, and in particular, to an energy storage device and a photovoltaic energy storage system.

### BACKGROUND

With continuous development and wide application of clean energy, energy storage devices that can store electric energy start to be widely used in a plurality of fields. Currently, there are more large cabinet-level or container-level energy storage devices, to accommodate more batteries, so as to improve electric energy storage capabilities of the energy storage devices.

In addition, to control charging and discharging processes of the battery, the energy storage device further includes a power module. The power module generates a large amount of heat in an operating process. Especially, in some working conditions, overload operation causes a sharp increase in heat generated by the power module. Effective heat dissipation needs to be performed on the power module, to ensure operating reliability and use safety of the power module. In view of this, a set of heat dissipation system is usually disposed for the power module in the energy storage device. However, a heat dissipation system using a conventional air cooling mode is inefficient, and cannot meet a heat dissipation requirement of the power module during overload operation.

### SUMMARY

This application provides an energy storage device and a photovoltaic energy storage system, to implement efficient heat dissipation for a power module, thereby improving use safety of the energy storage device.

According to a first aspect, this application provides an energy storage device. The energy storage device may include a heat management module, a battery module, a first power unit, a second power unit, and a radiator module. The heat management module includes a housing, and a multi-way valve, a first evaporator, and a condenser that are disposed in the housing. The housing includes a plurality of first interfaces. Two coolant ports of the first evaporator are connected to the multi-way valve, and two coolant ports of the condenser are connected between the multi-way valve and one of the first interfaces. The battery module includes a battery and a battery heat exchange plate, the battery is in contact with the battery heat exchange plate, and two coolant ports of the battery heat exchange plate each are connected to the multi-way valve through one of the first interfaces. The first power unit includes a power conversion system and a first power circuit heat exchange plate, the power conversion system is in contact with the first power circuit heat exchange plate, and two coolant ports of the first power circuit heat exchange plate each are connected to the multi-way valve through one of the first interfaces. The second power unit includes a direct current converter and a second power circuit heat exchange plate, the direct current converter is in contact with the second power circuit heat exchange plate, and two coolant ports of the second power circuit heat exchange plate each are connected to the multi-way valve through one of the first interfaces. The radiator module includes a radiator, and two coolant ports of the radiator each are connected to the multi-way valve through one of the first interfaces. In the energy storage device provided in this application, a corresponding coolant port and a coolant path between the corresponding coolant port and the first evaporator or the condenser may be connected or disconnected via the multi-way valve, to exchange heat with the battery heat exchange plate, the first power circuit heat exchange plate, and the second power circuit heat exchange plate through coolant circulation in a plurality of modes. This can effectively improve efficiency of adjusting and controlling temperatures of the battery heat exchange plate, the first power circuit heat exchange plate, and the second power circuit heat exchange plate, improves efficiency of adjusting and controlling temperatures of the battery, the power conversion system, and the direct current converter, and helps improve operating reliability of the energy storage device. In addition, in the energy storage device, structures of the heat management module are integrated into one housing. This can effectively improve an integration level of the heat management module, facilitate connection between the heat management module and another module, and save a pipe for connecting the heat management module to the another module, thereby helping reduce costs of the energy storage device.

In a possible implementation of this application, the heat management system further includes a first throttle valve, and the first throttle valve is disposed in the housing. The energy storage device further includes a compressor. The compressor may be disposed in the housing. This helps improve an integration level of the energy storage device. Alternatively, the compressor may be disposed outside the housing. The housing further includes two second interfaces, and the compressor is connected between the two second interfaces. This can improve flexibility of a position for disposing the compressor. In addition, the compressor, the first evaporator, the first throttle valve, and the condenser are sequentially connected through a refrigerant pipe to form a refrigerant circulation loop. The refrigerant circulation loop may exchange heat with the battery heat exchange plate, the first power circuit heat exchange plate, and the second power circuit heat exchange plate through heat exchange with a coolant flowing through the first evaporator or the condenser, to adjust and control the temperatures of the battery, the power conversion system, and the direct current converter.

In a possible implementation of this application, the multi-way valve is connected between the first power circuit heat exchange plate and the first evaporator, and the multi-way valve is configured to connect or disconnect a coolant path between the first power circuit heat exchange plate and the first evaporator. Therefore, the first power circuit heat exchange plate and the first evaporator may be connected in series to a same coolant circulation loop by connecting a corresponding valve port of the multi-way valve, to dissipate heat of the power conversion system through heat exchange between a coolant cooled by the first evaporator and the first power circuit heat exchange plate. This can meet a heat dissipation requirement of the power conversion system in an overload working condition.

In a possible implementation of this application, the battery heat exchange plate and the first power circuit heat exchange plate are connected in series and connected between two valve ports of the multi-way valve through the first interface. Therefore, the battery heat exchange plate, the first power circuit heat exchange plate, and the first evaporator may be connected in series to a same coolant circulation loop by connecting a corresponding valve port of the multi-way valve, to cool the battery heat exchange plate and the first power circuit heat exchange plate through heat exchange between the first evaporator and a coolant in the coolant circulation loop, so as to dissipate heat of the battery and the power conversion system. This can meet the heat dissipation requirement of the power conversion system in the overload working condition, to improve operating reliability of the energy storage device.

In addition, the battery heat exchange plate and the first power circuit heat exchange plate may alternatively be connected in parallel and connected between two valve ports of the multi-way valve through the first interface. Therefore, the coolant cooled by the first evaporator can separately enter the battery heat exchange plate and the first power circuit heat exchange plate by connecting a corresponding valve port of the multi-way valve, to cool the battery heat exchange plate and the first power circuit heat exchange plate, so as to dissipate heat of the battery and the power conversion system. This can also meet the heat dissipation requirement of the power conversion system in the overload working condition, to improve the operating reliability of the energy storage device.

In the energy storage device provided in this application, the battery heat exchange plate and the first power circuit heat exchange plate may be connected in the foregoing manner. In a possible implementation, the two coolant ports of the first power circuit heat exchange plate and the two coolant ports of the battery heat exchange plate may also be connected to different valve ports of the multi-way valve through different first interfaces respectively, so that the battery heat exchange plate and the first power circuit heat exchange plate are connected in series or in parallel by connecting a corresponding valve port of the multi-way valve.

In a possible implementation of this application, the battery heat exchange plate and the second power circuit heat exchange plate are connected in series and connected between two valve ports of the multi-way valve through the first interface. Therefore, the battery heat exchange plate, the second power circuit heat exchange plate, and the first evaporator may be connected in series to a same coolant circulation loop by connecting a corresponding valve port of the multi-way valve, to cool the battery heat exchange plate and the second power circuit heat exchange plate through heat exchange between the first evaporator and a coolant in the coolant circulation loop, so as to dissipate heat of the battery and the power conversion system. This can meet the heat dissipation requirement of the power conversion system in the overload working condition, to improve the operating reliability of the energy storage device.

In addition, the battery heat exchange plate and the second power circuit heat exchange plate may alternatively be connected in parallel and connected between two valve ports of the multi-way valve through the first interface. Therefore, the coolant cooled by the first evaporator can separately enter the battery heat exchange plate and the second power circuit heat exchange plate by connecting a corresponding valve port of the multi-way valve, to cool the battery heat exchange plate and the second power circuit heat exchange plate, so as to dissipate heat of the battery and the power conversion system. This can also meet the heat dissipation requirement of the power conversion system in the overload working condition, to improve the operating reliability of the energy storage device.

In the energy storage device provided in this application, the battery heat exchange plate and the second power circuit heat exchange plate may be connected in the foregoing manner. In a possible implementation, the two coolant ports of the second power circuit heat exchange plate and the two coolant ports of the battery heat exchange plate may also be connected to different valve ports of the multi-way valve through different first interfaces respectively, so that the battery heat exchange plate and the second power circuit heat exchange plate are connected in series or in parallel by connecting a corresponding valve port of the multi-way valve.

In a possible implementation of this application, the second power circuit heat exchange plate and the condenser are connected in series through the first interface and connected between two valve ports of the multi-way valve. Therefore, the second power circuit heat exchange plate and the condenser may be connected in series to a same coolant circulation loop by connecting a corresponding valve port of the multi-way valve, to dissipate heat of both the second power circuit heat exchange plate and the condenser via a same path of coolant. This helps improve energy efficiency of the energy storage device.

In addition, the second power circuit heat exchange plate and the condenser may alternatively be connected in parallel through the first interface and connected between two valve ports of the multi-way valve. Therefore, a coolant circulation loop in which the second power circuit heat exchange plate is located and a coolant circulation loop in which the condenser is located are connected in parallel by connecting a corresponding valve port of the multi-way valve, to dissipate heat of both the second power circuit heat exchange plate and the condenser via a same path of coolant. This can also improve energy efficiency of the energy storage device.

In addition, the first power circuit heat exchange plate and the second power circuit heat exchange plate may be connected in series or in parallel through the first interface and connected between two valve ports of the multi-way valve, to dissipate heat of the first power circuit heat exchange plate, the second power circuit heat exchange plate, and the condenser via a same path of coolant, to improve energy efficiency of the energy storage device.

In a possible implementation of this application, the energy storage device further includes a first water pump, and the battery heat exchange plate and the first water pump are connected in series and connected between two valve ports of the multi-way valve through the first interface. One coolant port of the first power circuit heat exchange plate, one coolant port of the second power circuit heat exchange plate, and one coolant port of the condenser each are connected to one valve port of the multi-way valve, and the other coolant port of the first power circuit heat exchange plate and the other coolant port of the second power circuit heat exchange plate each are connected to another valve port of the multi-way valve. In addition, a liquid outlet of the first water pump is connected to one coolant port of the first power circuit heat exchange plate and one coolant port of the second power circuit heat exchange plate, and a liquid inlet of the first water pump is connected to the other coolant port of the first power circuit heat exchange plate and the other coolant port of the second power circuit heat exchange plate. Therefore, in a scenario, such as a high-temperature environment or overload operation, in which the first power circuit and the second power circuit have a high heat dissipation requirement, a part of a low-temperature coolant for cooling the battery is guided, via the first water pump, to a coolant circulation loop in which the first power circuit heat exchange plate and the second power circuit heat exchange plate are located, and a part of a coolant flowing through the first power circuit heat exchange plate and the second power circuit heat exchange plate flows back to a coolant circulation loop in which the battery heat exchange plate is located, to ensure balance of coolants in the coolant circulation loops and dissipate heat of the first power circuit heat exchange plate and the second power circuit heat exchange plate, so as to dissipate heat of the first power circuit and the second power circuit.

In a possible implementation of this application, the energy storage device further includes a first three-way valve and a second three-way valve. One coolant port of the first power circuit heat exchange plate, one coolant port of the second power circuit heat exchange plate, and the liquid outlet of the first water pump are respectively connected to three valve ports of the first three-way valve in a one-to-one correspondence, and the other coolant port of the first power circuit heat exchange plate, the other coolant port of the second power circuit heat exchange plate, and the liquid inlet of the first water pump are respectively connected to three valve ports of the second three-way valve in a one-to-one correspondence, to control a state of connection or disconnection between the one coolant port of the first power circuit heat exchange plate, the one coolant port of the second power circuit heat exchange plate, and the liquid outlet of the first water pump, and a state of connection or disconnection between the other coolant port of the first power circuit heat exchange plate, the other coolant port of the second power circuit heat exchange plate, and the liquid inlet of the first water pump by connecting or disconnecting the valve ports of the first three-way valve and the second three-way valve. Therefore, the temperatures of the power conversion system and the direct current converter are separately adjusted and controlled. This helps improve energy efficiency of the energy storage device.

In a possible implementation of this application, the multi-way valve is connected between the battery heat exchange plate and the first evaporator, and configured to connect or disconnect a path between the battery heat exchange plate and the first evaporator. In this case, when the energy storage device operates in a high-temperature mode, the multi-way valve may connect the coolant path between the battery heat exchange plate and the first evaporator, to cool the battery heat exchange plate via the first evaporator, so as to dissipate heat of the battery.

In a possible implementation of this application, the multi-way valve is further connected between the battery heat exchange plate and the condenser, and configured to connect or disconnect a path between the battery heat exchange plate and the condenser. In this case, the multi-way valve may connect the coolant path between the battery heat exchange plate and the condenser, to heat the battery heat exchange plate via heat generated by the condenser, so that the energy storage device operates in a heat pump mode.

In a possible implementation of this application, the radiator module includes two radiators, and two coolant ports of the two radiators are connected to different valve ports of the multi-way valve through different first interfaces respectively. Therefore, the two radiators may be respectively connected to corresponding coolant circulation loops by connecting a corresponding valve port of the multi-way valve. This helps diversify operating modes of the energy storage device.

In a possible implementation of this application, the multi-way valve is further connected between the first power circuit heat exchange plate and one of the radiators, and the multi-way valve is configured to connect or disconnect a path between the first power circuit heat exchange plate and the one of the radiators. When connecting the path between the first power circuit heat exchange plate and the one of the radiators, the multi-way valve may cool the first power circuit heat exchange plate via the one of the radiators, to dissipate heat of the power conversion system.

In a possible implementation of this application, the multi-way valve is further connected between the condenser and the other of the radiators, and the multi-way valve is configured to connect or disconnect a path between the condenser and the other of the radiators. When connecting the path between the condenser and the other of the radiators, the multi-way valve may cool the condenser via the other of the radiators.

In a possible implementation of this application, the first power unit further includes a first bypass valve, and the first bypass valve and the first power circuit heat exchange plate are disposed in parallel. Therefore, a flow rate of a coolant flowing through the first power circuit heat exchange plate may be adjusted via the first bypass valve, to meet heat dissipation requirements of the first power circuit heat exchange plate in different operating modes, to improve operating reliability of the energy storage device.

In addition, the second power unit further includes a second bypass valve, and the second bypass valve and the second power circuit heat exchange plate are disposed in parallel. Therefore, a flow rate of a coolant flowing through the second power circuit heat exchange plate may be adjusted via the second bypass valve, to meet heat dissipation requirements of the second power circuit heat exchange plate in different operating modes. This helps improve the operating reliability of the energy storage device.

According to a second aspect, this application further provides a photovoltaic energy storage system. The photovoltaic energy storage system may include a power generation device, a power conversion device, and the energy storage device according to the first aspect. The power conversion device is connected between the power generation device and the energy storage device. The power generation device is configured to store generated electric energy into a battery of the energy storage device via the power conversion device. The foregoing energy storage device is used, so that operating reliability of the photovoltaic energy storage system can be effectively improved.

### BRIEF DESCRIPTION OF DRAWINGS

FIG. 1 is a block diagram of a structure of an energy storage device according to an embodiment of this application;
FIG. 2a is a diagram of a structure of an energy storage device according to an embodiment of this application;
FIG. 2b is a diagram of another structure of an energy storage device according to an embodiment of this application;
FIG. 2c is a diagram of another structure of an energy storage device according to an embodiment of this application;
FIG. 2d is a diagram of another structure of an energy storage device according to an embodiment of this application;
FIG. 2e is a diagram of another structure of an energy storage device according to an embodiment of this application;
FIG. 2f is a diagram of another structure of an energy storage device according to an embodiment of this application;
FIG. 2g is a diagram of another structure of an energy storage device according to an embodiment of this application;
FIG. 2h is a diagram of another structure of an energy storage device according to an embodiment of this application;
FIG. 2i is a diagram of another structure of an energy storage device according to an embodiment of this application;
FIG. 2j is a diagram of another structure of an energy storage device according to an embodiment of this application;
FIG. 3a is a diagram of a circulation path of the energy storage device provided in FIG. 2a in an operating mode;
FIG. 3b is a diagram of a circulation path of the energy storage device provided in FIG. 2a in another operating mode;
FIG. 3c is a diagram of a circulation path of the energy storage device provided in FIG. 2a in another operating mode;
FIG. 3d is a diagram of a circulation path of the energy storage device provided in FIG. 2a in another operating mode;
FIG. 3e is a diagram of a circulation path of the energy storage device provided in FIG. 2a in another operating mode;
FIG. 4a is a diagram of another structure of an energy storage device according to an embodiment of this application;
FIG. 4b is a diagram of another structure of an energy storage device according to an embodiment of this application;
FIG. 5a is a diagram of a circulation path of the energy storage device provided in FIG. 4a in an operating mode;
FIG. 5b is a diagram of a circulation path of the energy storage device provided in FIG. 4a in another operating mode;
FIG. 5c is a diagram of a circulation path of the energy storage device provided in FIG. 4a in another operating mode;
FIG. 5d is a diagram of a circulation path of the energy storage device provided in FIG. 4a in another operating mode;
FIG. 5e is a diagram of a circulation path of the energy storage device provided in FIG. 4a in another operating mode;
FIG. 6a is a diagram of another structure of an energy storage device according to an embodiment of this application;
FIG. 6b is a diagram of another structure of an energy storage device according to an embodiment of this application;
FIG. 6c is a diagram of another structure of an energy storage device according to an embodiment of this application;
FIG. 6d is a diagram of another structure of an energy storage device according to an embodiment of this application;
FIG. 6e is a diagram of another structure of an energy storage device according to an embodiment of this application;
FIG. 7a is a diagram of another structure of an energy storage device according to an embodiment of this application;
FIG. 7b is a diagram of another structure of an energy storage device according to an embodiment of this application;
FIG. 8a is a diagram of a circulation path of the energy storage device provided in FIG. 7a in an operating mode;
FIG. 8b is a diagram of a circulation path of the energy storage device provided in FIG. 7a in another operating mode;
FIG. 8c is a diagram of a circulation path of the energy storage device provided in FIG. 7a in another operating mode;
FIG. 8d is a diagram of a circulation path of the energy storage device provided in FIG. 7a in another operating mode;
FIG. 8e is a diagram of a circulation path of the energy storage device provided in FIG. 7a in another operating mode;
FIG. 8f is a diagram of a circulation path of the energy storage device provided in FIG. 7a in another operating mode;
FIG. 8g is a diagram of a circulation path of the energy storage device provided in FIG. 7a in another operating mode;
FIG. 9a is a diagram of another structure of an energy storage device according to an embodiment of this application;
FIG. 9b is a diagram of another structure of an energy storage device according to an embodiment of this application;
FIG. 10a is a diagram of a circulation path of the energy storage device provided in FIG. 9a in an operating mode;
FIG. 10b is a diagram of a circulation path of the energy storage device provided in FIG. 9a in another operating mode;
FIG. 10c is a diagram of a circulation path of the energy storage device provided in FIG. 9a in another operating mode;
FIG. 10d is a diagram of a circulation path of the energy storage device provided in FIG. 9a in another operating mode;
FIG. 10e is a diagram of a circulation path of the energy storage device provided in FIG. 9a in another operating mode;
FIG. 10f is a diagram of a circulation path of the energy storage device provided in FIG. 9a in another operating mode;
FIG. 10g is a diagram of a circulation path of the energy storage device provided in FIG. 9a in another operating mode;
FIG. 11a is a diagram of another structure of an energy storage device according to an embodiment of this application;
FIG. 11b is a diagram of another structure of an energy storage device according to an embodiment of this application;
FIG. 12a is a diagram of a circulation path of the energy storage device provided in FIG. 11a in an operating mode;
FIG. 12b is a diagram of a circulation path of the energy storage device provided in FIG. 11a in another operating mode;
FIG. 12c is a diagram of a circulation path of the energy storage device provided in FIG. 11a in another operating mode;
FIG. 13a is a diagram of a structure of an energy storage device group according to an embodiment of this application;
FIG. 13b is a diagram of another structure of an energy storage device group according to an embodiment of this application;
FIG. 14 is a diagram of a structure of a photovoltaic energy storage system according to an embodiment of this application; and
FIG. 15 is a diagram of a structure of a charging network according to an embodiment of this application.

### Reference numerals:

100: energy storage device; 10: container body;
1: heat management module; 101: housing; 1011: first interface; 1012: second interface; 102: multi-way valve;
103: first evaporator; 104: first throttle valve; 105: condenser; 1061: first water pump; 1062: second water pump; 1063: third water pump;
107: electric heater; 108: dehumidification module; 1081: second evaporator; 1082: second throttle valve; 2: compressor;
3: battery module; 301: battery; 302: battery heat exchange plate; 4: power module; 4a: first power unit; 401: first power circuit;
402: first power circuit heat exchange plate; 403: first bypass valve; 4b: second power unit; 404: second power circuit;
405: second power circuit heat exchange plate; 406: second bypass valve;
5: radiator module; 501, 501a, and 501b: radiators; 502: fan; 6: third bypass valve; 7: liquid supply port; 8: liquid return port;
9a: first three-way valve; and 9b: second three-way valve.

### DESCRIPTION OF EMBODIMENTS

To make objectives, technical solutions, and advantages of this application clearer, the following further describes embodiments of this application in detail with reference to accompanying drawings. However, example implementations can be implemented in a plurality of forms, and should not be construed as being limited to implementations described herein. Same reference numerals in the figures indicate same or similar structures. Therefore, repeated descriptions thereof are omitted. Expressions of positions and directions in embodiments of this application are described by using the accompanying drawings as an example. However, changes may be also made as required, and all the changes fall within the protection scope of this application. The accompanying drawings in embodiments of this application are merely used to illustrate a relative position relationship and do not represent an actual scale.

It should be noted that specific details are set forth in the following descriptions for ease of understanding this application. However, embodiments of this application can be implemented in a plurality of manners different from those described herein, and a person skilled in the art can perform similar promotion without departing from the connotation of embodiments of this application. Therefore, this application is not limited to the specific implementations disclosed below.

For ease of understanding an energy storage device provided in embodiments of this application, the following first describes an application scenario of the energy storage device. The energy storage device provided in embodiments of this application may be used in five types of industrial and commercial energy storage scenarios such as a small industrial and commercial scenario (for example, a small factory), a medium industrial and commercial scenario, a large industrial and commercial scenario, a PV+ESS+charger station, and a small or medium microgrid (for example, an island), and three types of power station scenarios such as a wind/solar energy storage power station, a grid energy storage power station, and a large microgrid, to store and release electric energy.

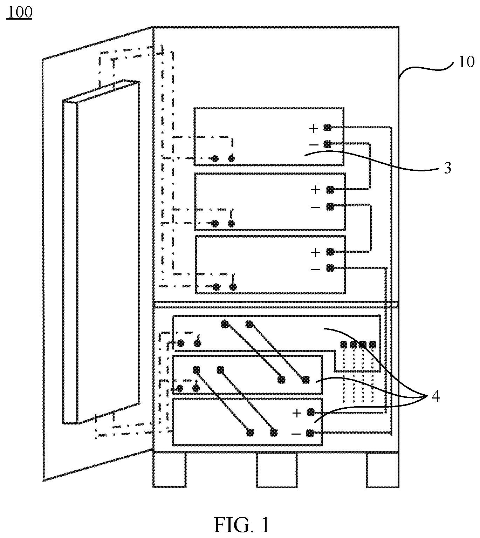

Currently, energy storage devices can be classified into module-level energy storage devices, cabinet-level energy storage devices, and container-level energy storage devices based on different power consumption requirements of application scenarios. FIG. 1 is a block diagram of a structure of an energy storage device 100 according to an embodiment of this application. The energy storage device 100 may include a container body 10, and a battery module 3 and a power module 4 that are disposed in the container body 10. A battery in the battery module 3 is a basic unit of the energy storage device 100 to store and release electric energy. In charging and discharging processes of the battery, a lot of heat is generated. The battery usually needs to be cooled, to ensure charging and discharging performance and use safety of the battery. In addition, the power module 4 may be configured to control the charging and discharging processes of the battery. In this application, a type of the power module is not limited. For example, the power module 4 may include a power conversion system (power conversion system, PCS) or a direct current (direct current, DCDC) converter. The PCS may be configured to convert an alternating current into a direct current and then supply the direct current to the battery, or convert a direct current from the battery into an alternating current. In this application, the PCS may be specifically a direct current-alternating current converter, or may be a direct current-direct current converter. In other words, the PCS may include a direct current-alternating current conversion component, or may include a direct current-direct current conversion component, a control unit, or the like. The DCDC may be configured to boost a voltage of the battery module 3, to ensure that a total voltage of the battery module 3 is not lower than a rated voltage, thereby improving operating stability of the battery module 3. The power module 4 also generates a large amount of heat in an operating process. Especially when the power module operates in some overload working conditions, the power module 4 generates more heat. If heat dissipation cannot be performed on the power module 4 in time, operating reliability and use safety of the power module 4 are affected.

In view of this, a heat dissipation system is further disposed in a present energy storage device. Liquid-cooling heat dissipation is mainly implemented through circulation of a coolant (for example, water) in a coolant pipe for heat exchange, and heat dissipation efficiency of liquid-cooling heat dissipation is high. Therefore, currently, more energy storage devices use a liquid-cooling heat dissipation system.

In view of this, the energy storage device provided in embodiments of this application may dissipate heat of the battery and the power module in a liquid-cooling heat dissipation manner in a plurality of operating modes, to efficiently adjust and control temperatures of the battery and the power module. This helps improve operating energy efficiency of the energy storage device. To make objectives, technical solutions, and advantages of this application clearer, the following further describes this application in detail with reference to accompanying drawings and specific embodiments.

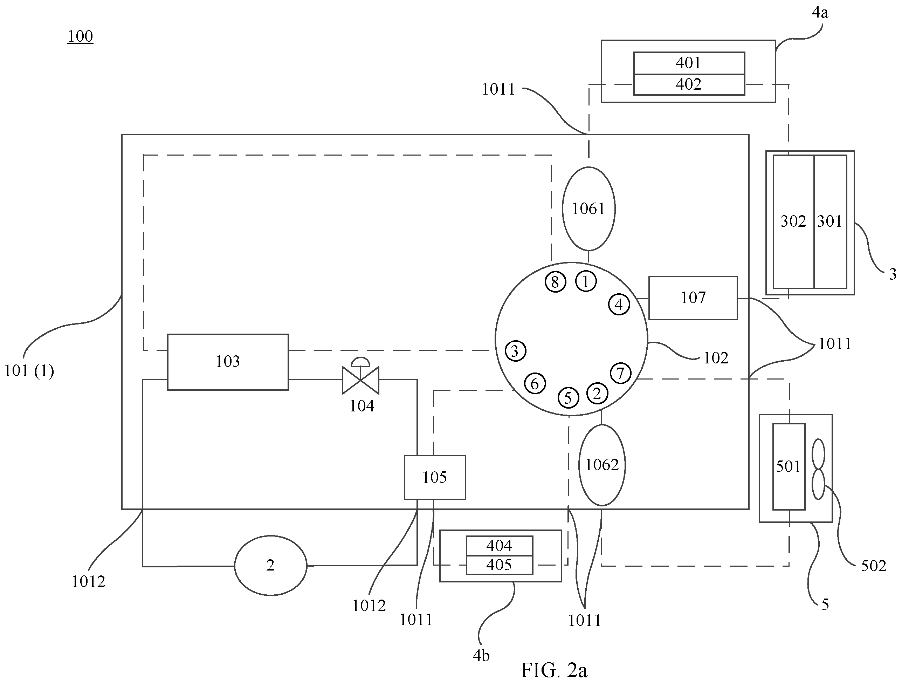

FIG. 2a is a diagram of a structure of an energy storage device according to an embodiment of this application. In this application, the energy storage device 100 may include a heat management module 1, a compressor 2, a battery module 3, a first power unit 4a, a second power unit 4b, and a radiator module 5. The heat management module 1 includes a housing 101, and a multi-way valve 102, a first evaporator 103, a first throttle valve 104, and a condenser 105 that are disposed in the housing 101. The housing 101 includes a plurality of first interfaces 1011 and two second interfaces 1012. The first interface 1011 may be configured to connect to a coolant pipe, and the second interface 1012 may be configured to connect to a refrigerant pipe. The refrigerant pipe is a pipe used for circulation of a refrigerant. The refrigerant may be but is not limited to freon or a liquid ammonia compound. In addition, the coolant pipe is a pipe used for circulation of a coolant. The coolant may be but is not limited to water or glycol. Because the energy storage device 100 provided in embodiments of this application has both a loop formed by connecting through a refrigerant pipe and a loop formed by connecting through a coolant pipe, in each accompanying drawing of embodiments of this application, for ease of distinguishing between different pipes, a dashed line indicates the coolant pipe, and a solid line indicates the refrigerant pipe.

In the energy storage device 100 provided in this embodiment of this application, two coolant ports of the first evaporator 103 are connected to the multi-way valve, and two coolant ports of the condenser 105 are connected between the multi-way valve 102 and one first interface 1011. In this case, the multi-way valve 102 may be configured to connect or disconnect a coolant path between each of the first evaporator 103 and the condenser 105 and another structure.

In addition, in the energy storage device 100 shown in FIG. 2a, the compressor 2 is disposed outside the housing 101 of the heat management module 1, and the compressor 2 is connected between the two second interfaces 1012. In addition, the compressor 2, the condenser 105, the first throttle valve 104, and the first evaporator 103 are sequentially connected through the refrigerant pipe to form a refrigerant circulation loop. In the energy storage device 100 provided in this embodiment of this application, as shown in FIG. 2a, the compressor 2 may be disposed outside the housing 101 of the heat management module 1, or may be disposed in the housing 101 of the heat management module 1. When the compressor 2 is disposed in the housing 101 of the heat management module 1, no second interface 1012 is disposed in the housing 101 of the heat management module 1. This can improve an integration level of the energy storage device 100.

Still refer to FIG. 2a. The battery module 3 includes a battery 301 and a battery heat exchange plate 302. The battery 301 is in contact with the battery heat exchange plate 302. Two coolant ports of the battery heat exchange plate 302 each are connected to the multi-way valve 102 through one first interface 1011. During specific implementation, a coolant inlet port and a coolant outlet port of the battery heat exchange plate 302 each are connected to the multi-way valve 102 through one first interface 1011. In this case, the multi-way valve 102 may be configured to connect or disconnect a coolant path between the battery heat exchange plate 302 and another structure.

It should be noted that, in the energy storage device provided in this embodiment of this application, the battery heat exchange plate 302 may be a cooling plate, or may be another type of heat exchanger such as an immersion heat exchanger, provided that the battery heat exchange plate 302 can be used for coolant circulation, and can be configured to exchange heat with the battery 301. In addition, the two coolant ports of the battery heat exchange plate 302 may be directly or indirectly connected to the corresponding first interfaces 1011 respectively. The direct connection between the coolant port and the corresponding first interface 1011 means that only the coolant pipe is disposed between the coolant port and the corresponding first interface 1011. The indirect connection between the coolant port and the corresponding first interface 1011 means that another component is further connected in series between the coolant port and the corresponding first interface 1011 through the coolant pipe.

In this embodiment of this application, the multi-way valve 102 may be configured to connect or disconnect a coolant path between the first evaporator 103 and the battery heat exchange plate 302. When the multi-way valve 102 connects the coolant path between the battery heat exchange plate 302 and the two coolant ports of the first evaporator 103, a coolant flowing through the first evaporator 103 may be cooled via the refrigerant circulation loop. Therefore, the coolant circulates between the first evaporator 103 and the battery heat exchange plate 302 to dissipate heat of the battery heat exchange plate 302, so as to dissipate heat of the battery 301.

Still refer to FIG. 2a. The first power unit 4a includes a first power circuit 401 and a first power circuit heat exchange plate 402. The first power circuit 401 may include a PCS. The first power circuit heat exchange plate 402 is in contact with the first power circuit 401, to dissipate heat of the first power circuit 401 through circulation of a coolant in the first power circuit heat exchange plate 402. When the first power circuit heat exchange plate 402 is connected to the heat management module 1, two coolant ports of the first power circuit heat exchange plate 402 each are connected to the multi-way valve 102 through one first interface 1011. Specifically, a coolant inlet port and a coolant outlet port of the first power circuit heat exchange plate 402 each are connected to the multi-way valve 102 through one first interface 1011. In this case, the multi-way valve 102 may be configured to connect or disconnect a coolant path between the first power circuit heat exchange plate 402 and another structure. It should be noted that, in the energy storage device 100 provided in this embodiment of this application, the first power circuit heat exchange plate 402 may be a cooling plate, or may be another type of heat exchanger such as an immersion heat exchanger, provided that the first power circuit heat exchange plate 402 can be used for coolant circulation, and can be configured to exchange heat with the first power circuit 401. In addition, when both the battery heat exchange plate 302 and the first power circuit heat exchange plate 402 are immersion evaporators, the battery heat exchange plate 302 and the first power circuit heat exchange plate 402 may also be disposed in an integrated manner. In other words, the battery 301 and the first power circuit 401 may be immersed in a same heat exchanger.

In this embodiment of this application, the two coolant ports of the first power circuit heat exchange plate 402 may also be directly or indirectly connected to the corresponding first interfaces 1011 respectively. For a specific implementation, refer to the foregoing corresponding descriptions. Details are not described herein again. For example, in the energy storage device shown in FIG. 2a, the first power circuit heat exchange plate 402 and the battery heat exchange plate 302 are connected in series and then connected between two first interfaces 1011, so that the two coolant ports of the first power heat exchange plate 402 are indirectly connected to the corresponding first interfaces 1011 respectively, and the two coolant ports of the battery heat exchange plate 302 are indirectly connected to the corresponding first interfaces 1011.

In addition, it may be understood that, in the energy storage device shown in FIG. 2a, the battery heat exchange plate 302 and the first power circuit heat exchange plate 402 are connected in series and are connected between two valve ports of the multi-way valve 102 through the first interfaces 1011, to connect a coolant path between the first power circuit heat exchange plate 402, the battery heat exchange plate 302, and the first evaporator 103 via the multi-way valve 102, so as to connect the first power circuit heat exchange plate 402, the battery heat exchange plate 302, and the first evaporator 103 to a same coolant circulation loop. In this way, the coolant can dissipate heat of the first power circuit heat exchange plate 402 after being cooled via the refrigerant circulation loop. This can improve heat dissipation efficiency for the first power circuit heat exchange plate 402, and can meet a heat dissipation requirement of the first power circuit 401 during operating in a working condition, such as overload, with a large amount of heat, thereby improving operation reliability of the energy storage device 100.

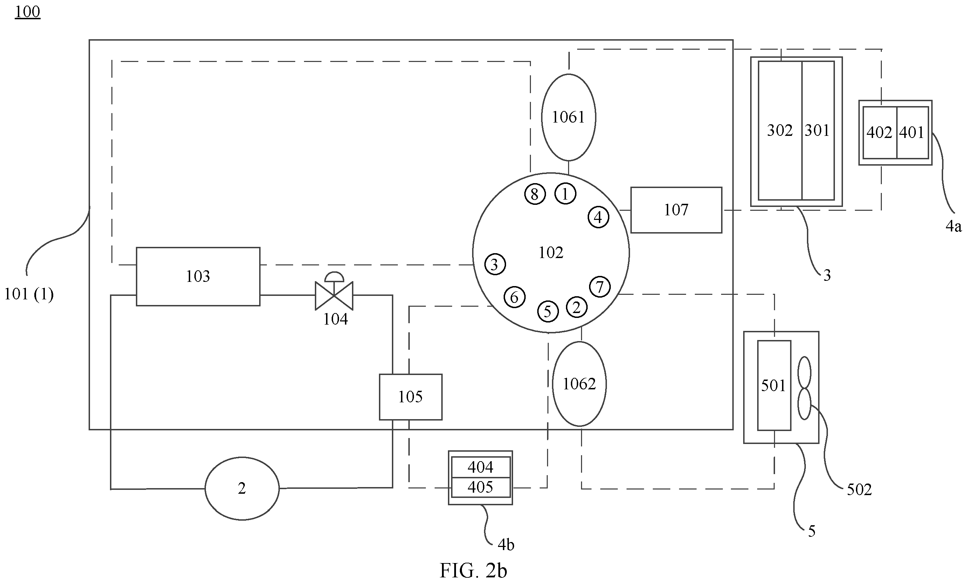

In this application, in addition to the manner shown in FIG. 2a, the coolant path between the first power unit 4a and the first evaporator 103 may be connected in another possible manner. For example, refer to FIG. 2b. FIG. 2b is a diagram of another structure of the energy storage device 100 according to an embodiment of this application. Different from the energy storage device 100 shown in FIG. 2a, in the energy storage device 100 shown in FIG. 2b, the first power circuit heat exchange plate 402 and the battery heat exchange plate 302 are connected in parallel and are connected between two valve ports of the multi-way valve 102 through the first interfaces 1011. Both one coolant port of the first power circuit heat exchange plate 402 and one coolant port of the battery heat exchange plate 302 are connected to one first interface, and both the other coolant port of the first power circuit heat exchange plate 402 and the other coolant port of the battery heat exchange plate 302 are connected to the other first interface, so that the two coolant ports of the first power circuit heat exchange plate 402 and the two coolant ports of the battery heat exchange plate 302 are connected to the two valve ports of the multi-way valve 102 in a one-to-one correspondence, and a coolant path between the first power circuit heat exchange plate 402 and the first evaporator 103 can still be connected via the multi-way valve 102. All other structures of the first power unit 4a of the energy storage device 100 shown in FIG. 2b may be disposed with reference to FIG. 2a. Details are not described herein. A manner of connecting the coolant path between the first power unit 4a and the first evaporator 103 is not limited thereto. For example, when the multi-way valve 102 has a large quantity of valve ports, the two coolant ports of the first power circuit heat exchange plate 402 and the two coolant ports of the battery heat exchange plate 302 are connected to different valve ports of the multi-way valve 102 through different first interfaces 1011 respectively, so that the first power circuit heat exchange plate 402 and the battery heat exchange plate 302 may also be respectively connected to the different valve ports of the multi-way valve 102. Examples are not listed one by one herein.

Still refer to FIG. 2a. The second power unit 4b includes a second power circuit 404 and a second power circuit heat exchange plate 405. The second power circuit 404 includes a DCDC. The second power circuit heat exchange plate 405 is in contact with the second power circuit 404, to dissipate heat of the second power circuit 404 through circulation of a coolant in the second power circuit heat exchange plate 405. When the second power circuit heat exchange plate 405 is connected to the heat management module 1, two coolant ports of the second power circuit heat exchange plate 405 each are connected to the multi-way valve 102 through one first interface 1011. Specifically, a coolant inlet port and a coolant outlet port of the second power circuit heat exchange plate 405 each are connected to the multi-way valve 102 through one first interface 1011. In this case, the multi-way valve 102 may be configured to connect or disconnect a coolant path between the second power circuit heat exchange plate 405 and another structure.

It should be noted that, in the energy storage device 100 provided in this embodiment of this application, the second power circuit heat exchange plate 405 may be a cooling plate, or may be another type of heat exchanger such as an immersion heat exchanger, provided that the second power circuit heat exchange plate 405 can be used for coolant circulation, and can be configured to exchange heat with the second power circuit 404. In addition, when both the battery heat exchange plate 302 and the second power circuit heat exchange plate 405 are immersion evaporators, the battery heat exchange plate 302 and the second power circuit heat exchange plate 405 may also be disposed in an integrated manner. In other words, the battery 301 and the second power circuit 404 may be immersed in a same heat exchanger.

In this embodiment of this application, the two coolant ports of the second power circuit heat exchange plate 405 may also be directly or indirectly connected to the corresponding first interfaces 1011 respectively. For a specific implementation, refer to the foregoing corresponding descriptions. Details are not described herein again.

In addition, in the energy storage device shown in FIG. 2a, the second power circuit heat exchange plate 405 and the condenser 105 may be connected in series through first interfaces 1011 and connected between two valve ports of the multi-way valve 102, so that the second power circuit heat exchange plate 405 and the condenser 105 are connected in series to a same coolant circulation loop.

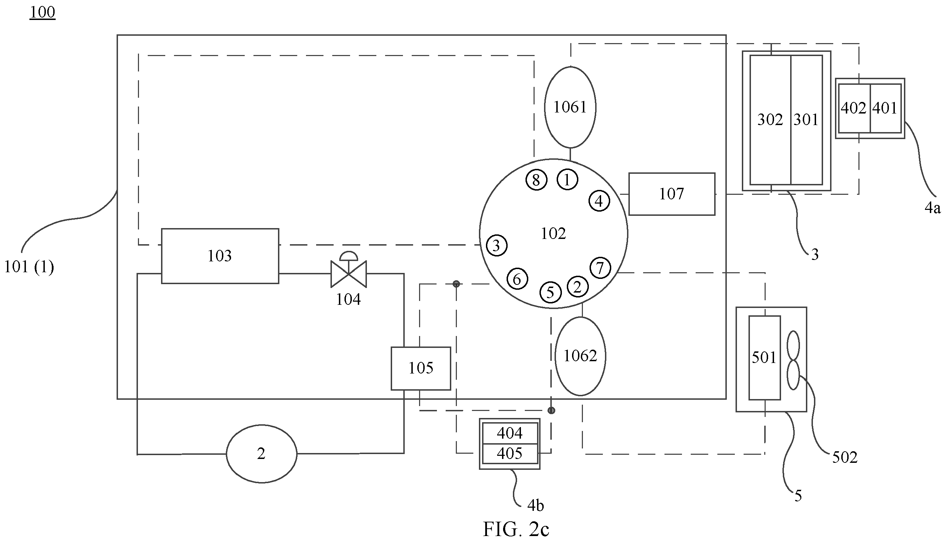

In some possible embodiments of this application, the second power circuit heat exchange plate 405 and the condenser 105 may alternatively be connected in parallel through first interfaces 1011 and connected between two valve ports of the multi-way valve 102, so that the condenser 105 and the second power circuit heat exchange plate 405 are connected in parallel to a same coolant circulation loop. For example, refer to FIG. 2c. FIG. 2c is a diagram of another structure of the energy storage device 100 according to an embodiment of this application. Different from the energy storage device 100 shown in FIG. 2a, in the energy storage device 100 shown in FIG. 2c, both one coolant port of the second power circuit heat exchange plate 405 and one coolant port of the condenser 105 are connected to a same valve port of the multi-way valve 102, and both the other coolant port of the second power circuit heat exchange plate 405 and the other coolant port of the condenser 105 are connected to the other valve port of the multi-way valve 102. Alternatively, when the multi-way valve 102 has a large quantity of valve ports, the other coolant port of the second power circuit heat exchange plate 405 and the other coolant port of the condenser 105 are respectively connected to different valve ports of the multi-way valve 102, or the two coolant ports of the second power circuit heat exchange plate 405 and the two coolant ports of the condenser 105 may be respectively connected to different valve ports of the multi-way valve 102, provided that a coolant circulation loop of the condenser 105 can be connected in parallel to a coolant circulation loop of the second power circuit heat exchange plate 405. Details are not listed one by one herein. In addition, all other structures of the second power unit 4b of the energy storage device 100 shown in FIG. 2c may be disposed with reference to FIG. 2b. Details are not described herein again.

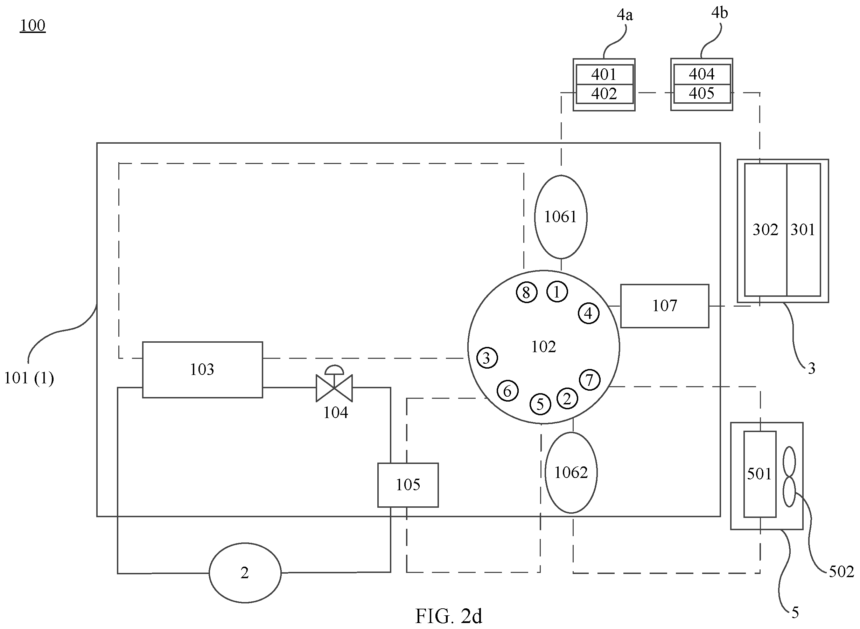

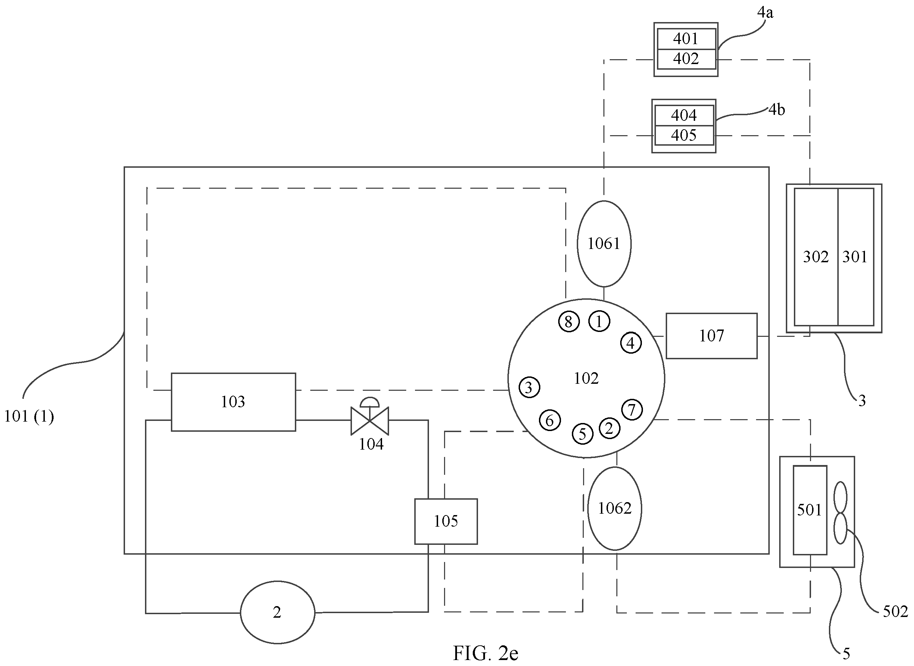

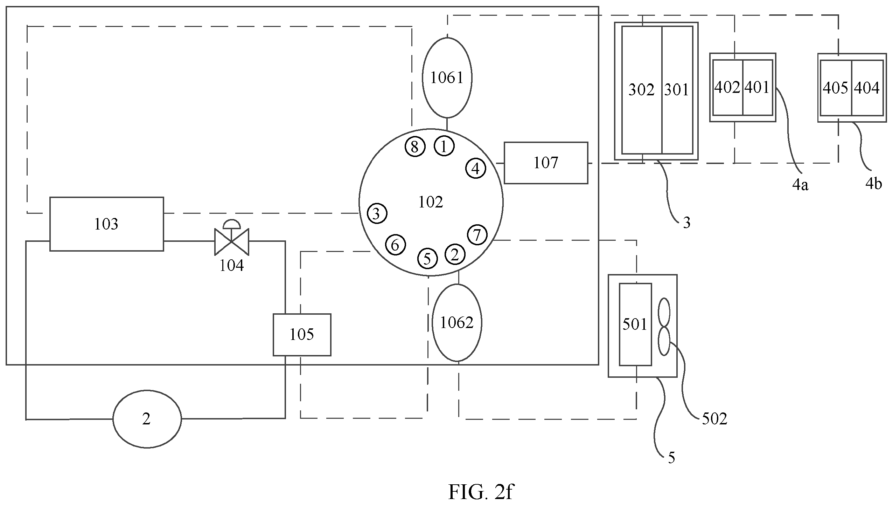

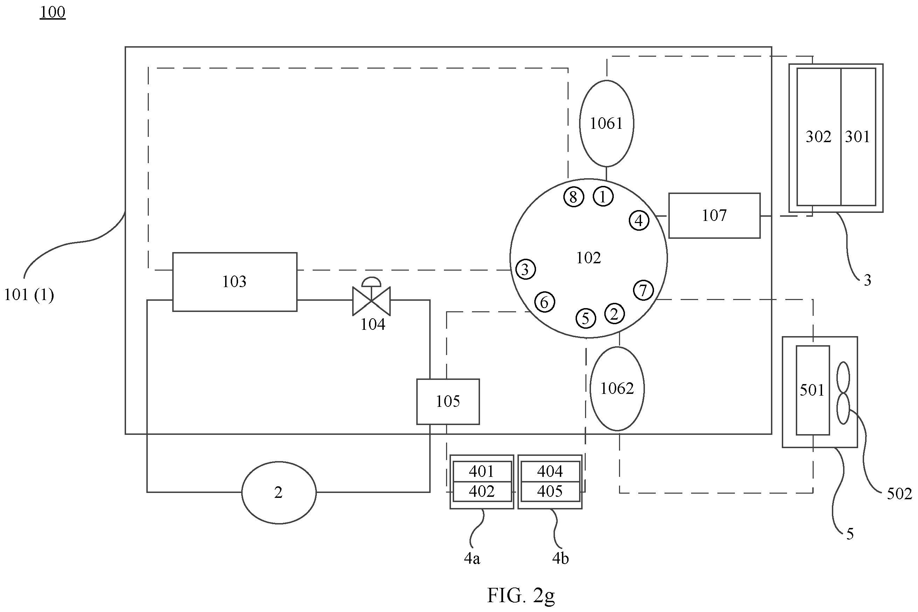

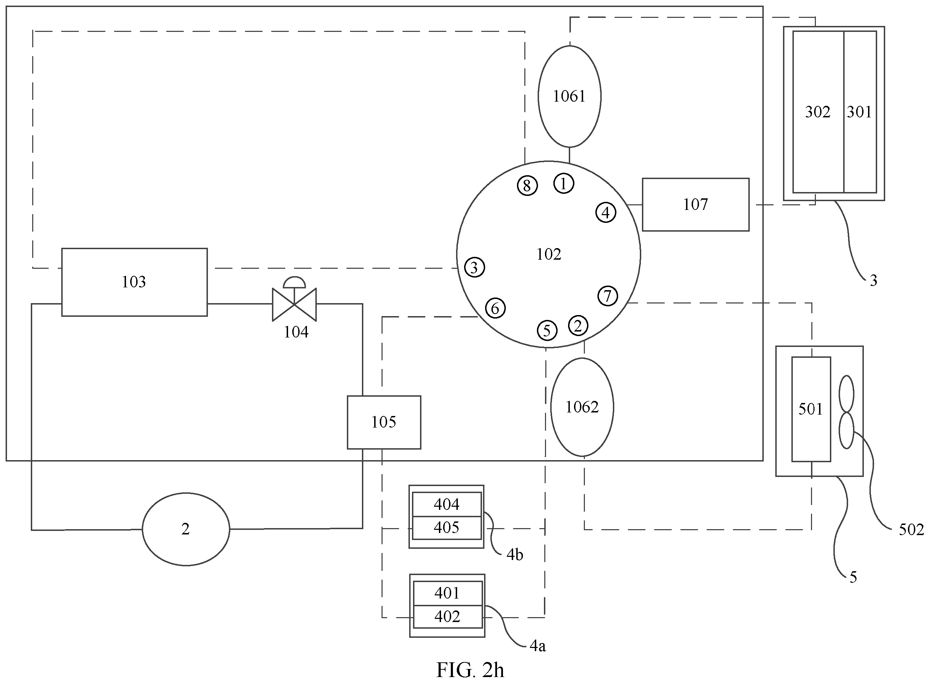

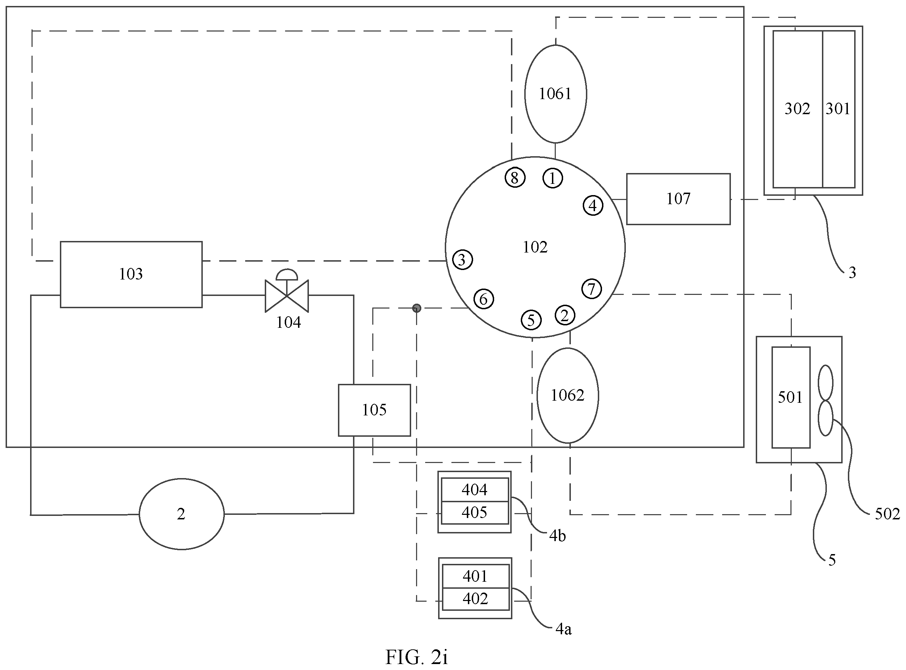

It should be noted that, in this application, in addition to the foregoing disposition manner, the first power unit 4a and the second power unit 4b may also use another possible disposition manner. For example, in the energy storage device 100 shown in FIG. 2d, both the first power circuit heat exchange plate 402 and the second power circuit heat exchange plate 405 may be connected in series to the battery heat exchange plate 302 and then connected between the two valve ports of the multi-way valve 102 through first interfaces. For another example, in FIG. 2e, the first power circuit heat exchange plate 402 and the second power circuit heat exchange plate 405 are connected in parallel, then connected in series to the battery heat exchange plate 302 and connected between the two valve ports of the multi-way valve 102 through first interfaces. For another example, in FIG. 2f, both the first power circuit heat exchange plate 402 and the second power circuit heat exchange plate 405 are connected in parallel to the battery heat exchange plate 302 and connected between the two valve ports of the multi-way valve 102 through first interfaces. For another example, in the energy storage device 100 shown in FIG. 2g, both the first power circuit heat exchange plate 402 and the second power circuit heat exchange plate 405 are connected in series to the condenser 105 and then connected between the two valve ports of the multi-way valve 102 through first interfaces. For another example, in the energy storage device 100 shown in FIG. 2h, the first power circuit heat exchange plate 402 and the second power circuit heat exchange plate 405 are connected in parallel, then connected in series to the condenser 105, and connected between the two valve ports of the multi-way valve 102 through first interfaces. For another example, as shown in FIG. 2i, both the first power circuit heat exchange plate 402 and the second power circuit heat exchange plate 405 are connected in parallel to the condenser 105 and connected between the two valve ports of the multi-way valve 102 through first interfaces. Details are not listed one by one herein.

Still refer to FIG. 2a. The radiator module 5 includes a radiator 501, and two coolant ports of the radiator 501 each are connected to the multi-way valve 102 through one first interface 1011. During specific implementation, a coolant inlet port and a coolant outlet port of the radiator 501 each are connected to the multi-way valve 102 through one first interface 1011. In this case, the multi-way valve 102 may be configured to connect or disconnect a coolant path between the radiator 501 and another structure. It should be noted that, in the energy storage device 100 shown in FIG. 2a, the radiator 501 and the battery heat exchange plate 302 each are connected to two different first interfaces, and the radiator 501, the first power circuit heat exchange plate 402, and the second power circuit heat exchange plate 405 each are connected to two different first interfaces, to improve flexibility of disposing a position of the radiator 501. The radiator 501 may be flexibly connected to or disconnected from another structure via the multi-way valve 102, to connect the radiator 501 to a coolant loop of the another structure, so as to dissipate heat of the another structure via the radiator 501.

For example, in this embodiment of this application, when the multi-way valve 102 connects a coolant path between the radiator 501 and the battery heat exchange plate 302, heat of the battery heat exchange plate 302 may be transferred to the radiator 501 via a coolant in a coolant pipe, and the coolant cooled by the radiator 501 may flow back to the battery heat exchange plate 302, so that the radiator 501 dissipates heat of the battery 301. When the multi-way valve 102 connects a coolant path between the radiator 501 and the second power circuit heat exchange plate 405, heat of the second power circuit heat exchange plate 405 may be transferred to the radiator 501 via a coolant pipe, so that the radiator 501 dissipates heat of the second power circuit 404, and the second power circuit 404 can be within a normal operating temperature range.

In addition, the radiator module 5 may further include a fan 502. The fan 502 is disposed close to the radiator 501. The fan 502 may be configured to increase a circulation speed of air flowing through the radiator 501, to improve heat dissipation performance of the radiator 501. It may be understood that a quantity of fans 502 in the radiator module 5 may be selected based on a specific application scenario. For example, in an environment with a high temperature, the circulation speed of the air flowing through the radiator 501 may be increased by increasing the quantity of fans 502 in the radiator module 5, to improve heat dissipation efficiency of the radiator 501 for the coolant in the coolant pipe.

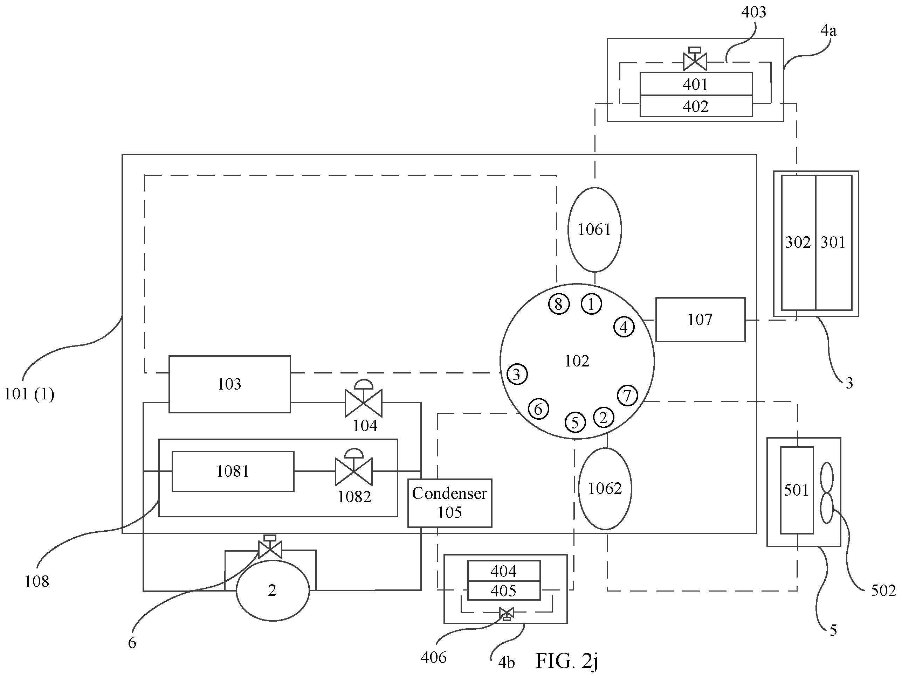

In addition to the foregoing structure, the energy storage device 100 provided in this embodiment of this application may further include another possible structure based on a specific application scenario. For example, refer to FIG. 2j. FIG. 2j is a diagram of another structure of the energy storage device 100 according to an embodiment of this application. In the energy storage device 100 shown in FIG. 2j, the first power unit 4a may further include a first bypass valve 403, and two coolant ports of the first bypass valve 403 may be connected to two coolant ports of the first power circuit heat exchange plate 402 in a one-to-one correspondence, to connect the first bypass valve 403 in parallel to the first power circuit heat exchange plate 402. Therefore, when the energy storage device 100 is in an environment with a low temperature, the first power circuit 401 has a low requirement of heat dissipation by a coolant cooled via a refrigerant circulation loop. In this case, the first bypass valve 403 may be turned on, and when the coolant cooled via the refrigerant circulation loop flows through the first power unit 4a, a part of the coolant flows through the first bypass valve 403, to reduce an amount of the coolant flowing through the first power circuit heat exchange plate 402. This helps improve energy efficiency of the energy storage device 100.

Similarly, in the energy storage device 100 shown in FIG. 2j, the second power unit 4b may further include a second bypass valve 406, and two coolant ports of the second bypass valve 406 may be connected to two coolant ports of the second power circuit heat exchange plate 405 in a one-to-one correspondence, to connect the second bypass valve 406 in parallel to the second power circuit heat exchange plate 405. Therefore, when the energy storage device 100 is in an environment with a low temperature, the second power circuit 404 has a low heat dissipation requirement. In this case, the second bypass valve 406 may be turned on, and when a coolant flows through the second power unit 4b, a part of the coolant flows through the second bypass valve 406, to reduce an amount of the coolant flowing through the second power circuit heat exchange plate 405. This helps improve energy efficiency of the energy storage device 100.

It should be noted that, in the energy storage device 100 provided in this embodiment of this application, the first bypass valve 403 may be disposed or may not be disposed in the first power unit 4a, the second bypass valve 406 may be disposed or may not be disposed in the second power unit 4b, and the first bypass valve 403 and the second bypass valve 406 may be specifically disposed based on a specific application scenario.

In addition, in the energy storage device 100 in FIG. 2j, a third bypass valve 6 is added for the compressor 2, and the third bypass valve 6 and the compressor 2 are disposed in parallel. In this case, when the compressor 2 operates in a heating state, the third bypass valve 6 is turned on, to reduce pressure of the compressor 2, so as to heat the battery 301 via heat generated by the compressor 2. When the compressor operates in a refrigerating state, the third bypass valve 6 is turned off. It may be understood that, when the heat generated by the compressor 2 can meet a heating requirement of the battery 301, an electric heater 107 in the energy storage device 100 may be removed. This helps improve energy efficiency of the energy storage device 100.

It should be noted that, in this application, for example, the first bypass valve 403, the second bypass valve 406, and the third bypass valve 6 may be valves with a cut-off function, such as a solenoid valve, a check valve, or a ball valve; and types of the first bypass valve 403, the second bypass valve 406, and the third bypass valve 6 may be the same or may be different.

In addition, a dehumidification module 108 may be further disposed in the energy storage device 100 shown in FIG. 2j. The dehumidification module 108 includes a second evaporator 1081 and a second throttle valve 1082 that communicate through a refrigerant pipe. In the energy storage device 100 shown in FIG. 2j, the compressor 2, the dehumidification module 108, and the condenser 105 sequentially communicate through a refrigerant pipe to form a dehumidification circulation loop. Because a temperature of the second evaporator 1081 is low when a refrigerant circulates in the circulation loop formed by the compressor 2, the dehumidification module 108, and the condenser 105, water vapor in air is condensed into water drops when ambient humidity is high and the temperature of the second evaporator 1081 is lower than a dew point temperature of the air, and the water drops are discharged through a drainpipe, to reduce humidity in the energy storage device 100.

Because the temperature of the second evaporator 1081 is low, the second evaporator 1081 may further reduce a temperature of air in the energy storage device 100, so that the battery is in a low-temperature environment. In addition, the dehumidification module 108 may further include a fan. The fan may be disposed near the second evaporator 1081, to increase a circulation speed of air flowing through the second evaporator 1081, so as to reduce the temperature of the second evaporator 1081. This helps improve dehumidification effect of the dehumidification module 108.

In the energy storage device 100 provided in FIG. 2j, a circulation loop formed by the battery heat exchange plate 302 and the radiator 501 can effectively reduce a temperature of a surface of the battery 301. In addition, because the temperature of the second evaporator 1081 in the dehumidification module 108 is low, the temperature of the air in the energy storage device 100 may be further effectively reduced. This can effectively improve heat dissipation effect on the battery 301. In addition, the second evaporator 1081 in the dehumidification module 108 can further condense water vapor in the energy storage device 100, to reduce humidity of the air in the energy storage device 100, so that the battery 301 can operate in a dry environment. This helps ensure reliability and a service life of the battery 301.

It may be understood that, in the embodiment provided in FIG. 2j, a combination of the second evaporator 1081 and the second throttle valve 1082 and a combination of the first evaporator 103 and the first throttle valve 104 are disposed in parallel, so that the two combinations do not affect each other. Specifically, during dehumidification, the second throttle valve 1082 may be turned on and the first throttle valve 104 may be turned off. In this case, a refrigerant may circulate in a circulation loop formed by the compressor 2, the condenser 105, the second throttle valve 1082, and the second evaporator 1081. Therefore, the second evaporator 1081 has a low temperature, to implement a dehumidification function. In addition, both the first throttle valve 104 and the second throttle valve 1082 may be turned on. In this case, a refrigerant may circulate in a circulation loop formed by the compressor 2, the condenser 105, the first throttle valve 104, and the first evaporator 103, and may further circulate in the circulation loop formed by the compressor 2, the condenser 105, the second throttle valve 1082, and the second evaporator 1081. Therefore, both the first evaporator 103 and the second evaporator 1081 have a low temperature, to implement a function of cooling the battery 301 via the first evaporator 103, and implement a dehumidification function via the second evaporator 1081. Certainly, during specific implementation, the first throttle valve 104 may be turned on and the second throttle valve 1082 may be turned off. In this case, the refrigerant may circulate in the circulation loop formed by the compressor 2, the condenser 105, the first throttle valve 104, and the first evaporator 103. Therefore, the first evaporator 103 has a low temperature, to implement the function of cooling the battery 301.

In summary, in the energy storage device 100 provided in FIG. 2j in this application, the first evaporator 103 and the second evaporator 1081 in the heat management module 1 are decoupled from each other, so that mutual impact between the first evaporator and the second evaporator can be avoided. In addition, the combination of the first evaporator 103 and the first throttle valve 104 and the combination of the second evaporator 1081 and the second throttle valve 1082 share the same condenser 105 and compressor 2, thereby effectively reducing a quantity of used parts and components. This helps reduce a volume and costs of an adjustment apparatus, and facilitates implementation of an integrated design. Certainly, in another possible embodiment, the first evaporator 103 and the second evaporator 1081 may alternatively be disposed in series, so that the first evaporator 103 and the second evaporator 1081 can share one throttle valve. For example, only the first throttle valve 104 or the second throttle valve 1082 may be disposed, thereby reducing a quantity of used parts and components. This helps reduce manufacturing costs.

It should be noted that, in this embodiment of this application, the dehumidification module 108 is disposed without depending on bypass of the compressor 2, that is, the dehumidification module 108 and the third bypass valve 6 at the compressor 2 may not be disposed at the same time. For example, the third bypass valve 6 is not disposed at the compressor 2, but the dehumidification module 108 is disposed in a heat management system; or the third bypass valve 6 is disposed at the compressor 2, but the dehumidification module 108 is not disposed in a heat management system.

In addition to the foregoing structure, the energy storage device 100 provided in this embodiment of this application may further include a water pump disposed in each coolant circulation loop. A quantity and disposed positions of water pumps may be specifically set based on a specific application scenario. In addition, when the energy storage device 100 operates in an environment with a low temperature, an electric heater may be further disposed in the energy storage device 100, to meet a heating requirement of the battery 301. The electric heater may be connected in series to a coolant loop in which the battery heat exchange plate 302 is located, to be turned on or off based on a specific requirement.

When the energy storage device 100 provided in this embodiment of this application operates, connected states and disconnected states of different first interfaces may be effectively adjusted and controlled via the multi-way valve 102, to flexibly adjust connection statuses of different modules, so that when the energy storage device 100 operates in all modes, temperatures of the battery module 3, the first power unit 4a, and the second power unit 4b can be adjusted and controlled through circulating heat exchange of a coolant between the modules communicating through a coolant pipe. This can effectively improve efficiency of adjusting and controlling the temperatures of the battery module 3, the first power unit 4a, and the second power unit 4b, and helps improve operating energy efficiency of the energy storage device 100. In addition, in the energy storage device 100 provided in this embodiment of this application, structures of the heat management module 1 are integrated into one housing 101. This can effectively improve an integration level of the heat management module 1, facilitates connection between the heat management module 1 and another module, and can save a pipe for connecting the heat management module 1 to the another module, thereby helping reduce costs of the energy storage device 100.

The foregoing describes a basic design principle of a heat dissipation system architecture of the energy storage device 100 provided in this application. The following uses the energy storage device shown in FIG. 2a as an example to describe operating modes of the energy storage device 100 in different operating conditions.

In the energy storage device 100 shown in FIG. 2a, the multi-way valve 102 of the heat management module 1 is an eight-way valve, and the eight-way valve includes eight valve ports. Each valve port may be configured to connect to the first evaporator 103, the condenser 105, or at least one first interface 1011.

In actual application, a connected state or a disconnected state between the first evaporator 103, the condenser 105, and different first interfaces 1011 may be effectively adjusted via the multi-way valve 102 based on an actual requirement, so that the energy storage device 100 can operate in a corresponding operating mode.

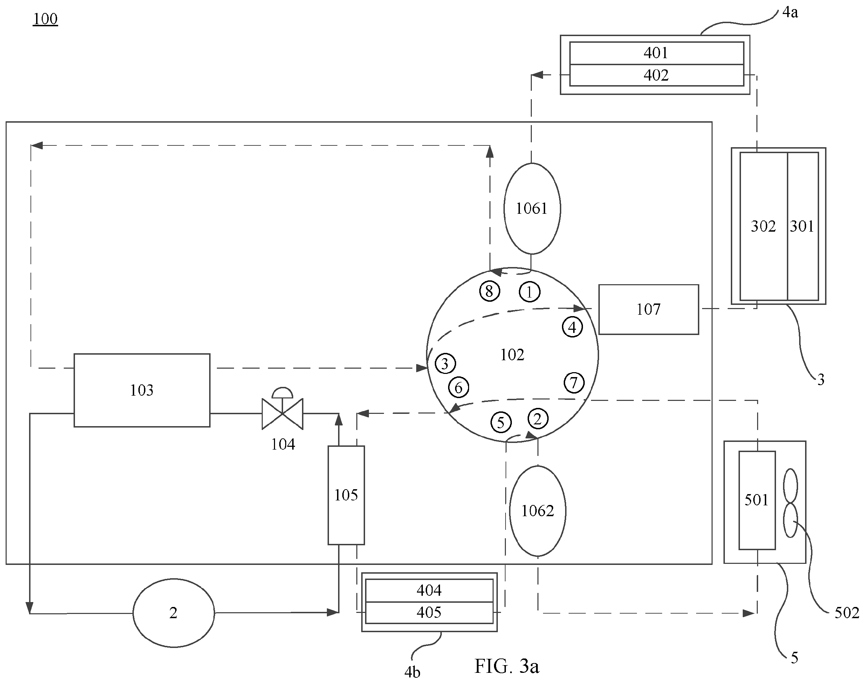

For example, when an ambient temperature is high (for example, in a case of a high temperature and high humidity in summer), refer to FIG. 3a. FIG. 3a is a diagram of a circulation path of the energy storage device 100 provided in FIG. 2a in an operating mode. FIG. 3a shows three circulation loops in the operating mode.

A first circulation loop includes the compressor 2, the condenser 105, the first throttle valve 104, and the first evaporator 103 that sequentially communicate through a refrigerant pipe. In this case, the first circulation loop is a refrigerant circulation loop. When a refrigerant circulates in the circulation loop, the first evaporator 103 may be at a low temperature.

In a second circulation path, the multi-way valve 102 connects a path between the battery heat exchange plate 302, the first power circuit heat exchange plate 402, and the first evaporator 103, so that the battery heat exchange plate 302, the first power circuit heat exchange plate 402, a first water pump 1061, the first evaporator 103, and an electric heater 107 sequentially communicate through the coolant path. Because a temperature of the first evaporator 103 is low in this case, the first evaporator 103 may cool a coolant circulating in the circulation loop, and the coolant cooled by the first evaporator 103 may exchange heat with the battery heat exchange plate 302 and the first power circuit heat exchange plate 402, to cool the battery heat exchange plate 302 and the first power circuit heat exchange plate 402.

In a third circulation path, the multi-way valve 102 connects a path between the condenser 105, the second power circuit heat exchange plate 405, and the radiator 501, so that the condenser 105, the second power circuit heat exchange plate 405, the radiator 501, and a second water pump 1062 sequentially communicate through the coolant path. In this case, when a coolant circulates in the circulation loop, the radiator 501 may cool the condenser 105 and the second power circuit heat exchange plate 405, to cool the condenser 105 and the second power circuit heat exchange plate 405, to dissipate heat of the condenser 105 and the second power circuit heat exchange plate 405. In addition, in the circulation loop, a manner of disposing the second water pump 1062 may be adjusted, so that the coolant cooled by the radiator 501 first flows through the second power circuit heat exchange plate 405 and then flows through the condenser 105, thereby improving heat dissipation efficiency on the second power circuit heat exchange plate 405.

It should be noted that, in the operating mode shown in FIG. 3a, the electric heater 107 is in an off state.

In addition, the battery heat exchange plate 302 and the first power circuit heat exchange plate 402 may also be cooled via the radiator 501. For example, in the multi-way valve 102, a valve port 7 may communicate with a valve port 4, and a valve port 1 may communicate with a valve port 2, to connect a path between the battery heat exchange plate 302, the first power circuit heat exchange plate 402, and the radiator 501 via the multi-way valve 102. In this case, the coolant may circulate in a circulation loop in which the battery heat exchange plate 302, the first power circuit heat exchange plate 402, the first water pump 1061, the second water pump 1062, and the radiator 501 sequentially communicate with each other.

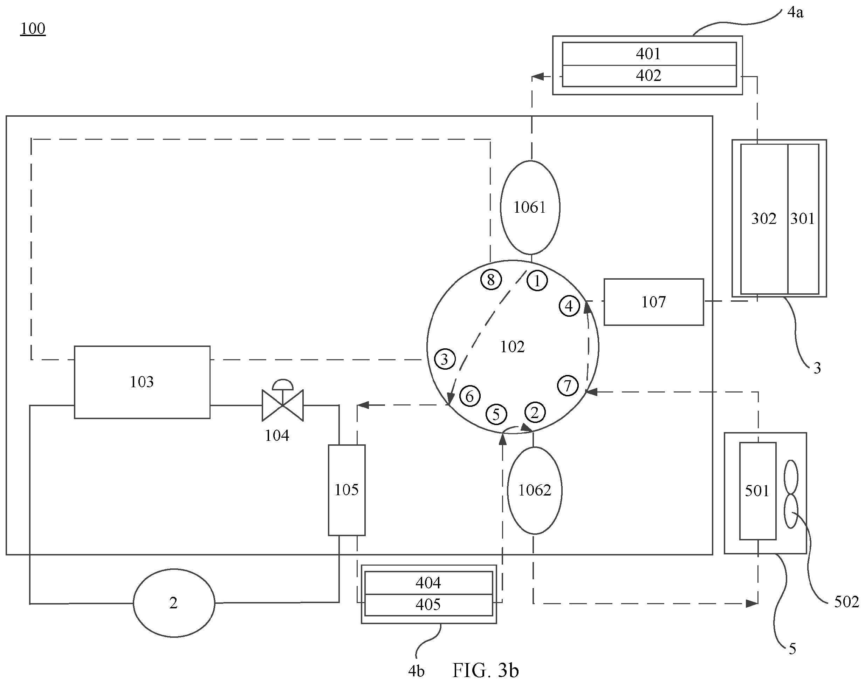

In addition, when an ambient temperature is moderate (for example, in spring or autumn), an operating mode of the energy storage device 100 may be shown in FIG. 3b. FIG. 3b is a diagram of a circulation path of the energy storage device 100 provided in FIG. 2a in another operating mode.

Specifically, one circulation loop is shown in FIG. 3b. The multi-way valve 102 connects a path between the battery heat exchange plate 302, the first power circuit heat exchange plate 402, the condenser 105, and the radiator 501, so that the battery heat exchange plate 302, the first power circuit heat exchange plate 402, the first water pump 1061, the condenser 105, the second power circuit heat exchange plate 405, the second water pump 1062, the radiator 501, and the electric heater 107 sequentially communicate through the coolant path to form a circulation loop. In this case, when a coolant circulates in the circulation loop, the radiator 501 may cool the battery heat exchange plate 302, the first power circuit heat exchange plate 402, and the second power circuit heat exchange plate 405, to dissipate heat of the battery 301 and the power circuit 301.

It should be noted that, in the operating mode shown in FIG. 3b, the electric heater 107 is in an off state. In addition, when the ambient temperature is temperate, heat dissipation requirements of the battery 301, the first power circuit 401, and the second power circuit 404 can be met only via the radiator 501. Therefore, the compressor 2, the first evaporator 103, and the condenser 105 are all in an off state in the operating mode.

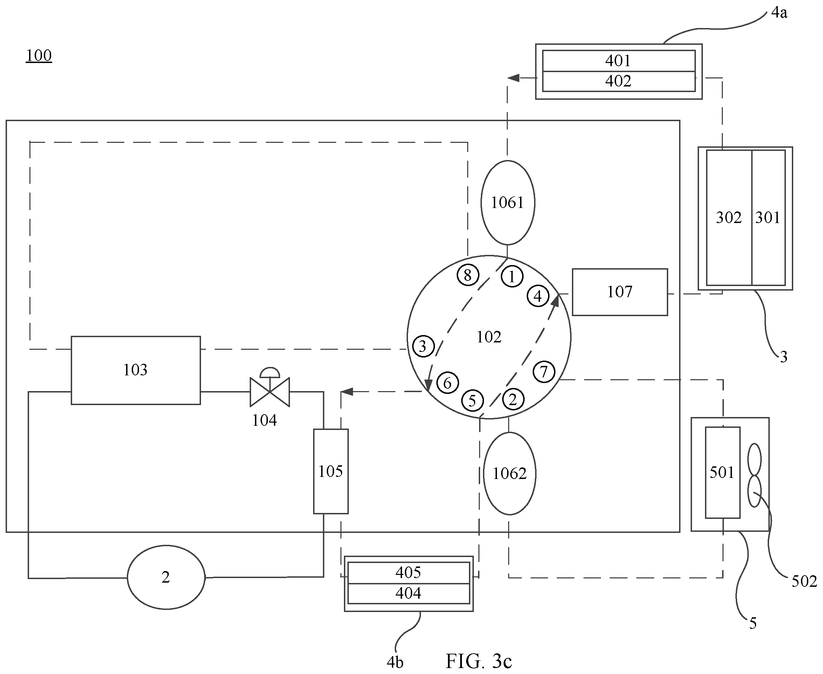

When an ambient temperature is low (for example, in a case of a low temperature in winter), an operating mode of the energy storage device 100 may be shown in FIG. 3c. FIG. 3c is a diagram of a circulation path of the energy storage device 100 provided in FIG. 2a in another operating mode.

In FIG. 3c, the multi-way valve 102 connects a path between the battery heat exchange plate 302, the first power circuit heat exchange plate 402, and the second power circuit heat exchange plate 405, so that the battery heat exchange plate 302, the first water pump 1061, the first power circuit heat exchange plate 402, the second power circuit heat exchange plate 405, and the electric heater 107 sequentially communicate through the coolant path to form a circulation loop. In this case, when a coolant circulates in the circulation loop, heat generated by the first power circuit 401 and heat generated by the second power circuit 404 may be transferred to the battery heat exchange plate 302, to heat the battery 301, thereby implementing efficient heat utilization. In the operating mode, the electric heater 107 may be turned on or off as required. Details are not described herein.

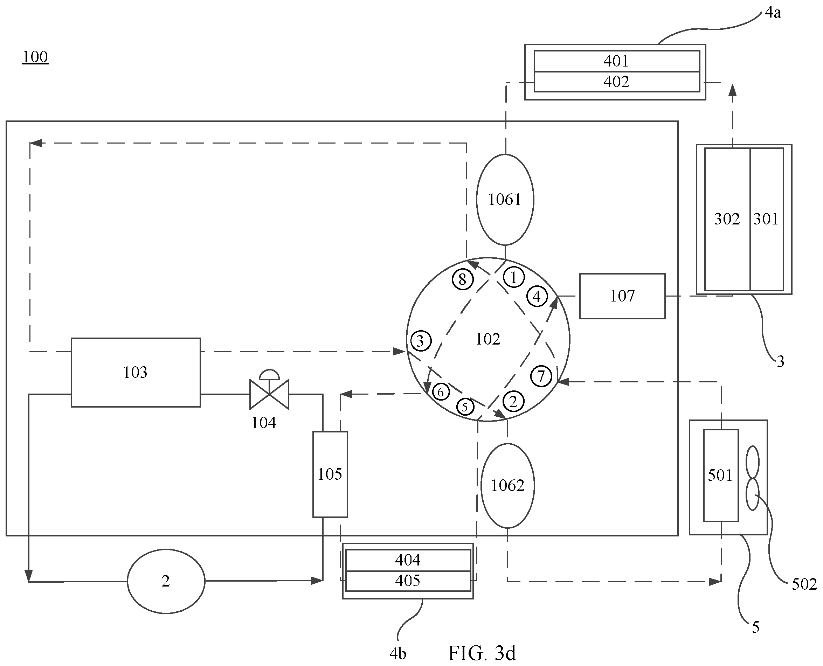

It should be noted that, in actual application, when the ambient temperature is low, both the first throttle valve 104 and the compressor 2 may be set to an on state as required, that is, the condenser 105 has a high temperature according to a working principle of a heat pump, so that the condenser 105 supplies heat energy to the battery heat exchange plate 302. During specific implementation, refer to FIG. 3d. FIG. 3d is a diagram of a circulation path of the energy storage device 100 provided in FIG. 2a in another operating mode. The battery heat exchange plate 302, the electric heater 107, the second power circuit heat exchange plate 405, the condenser 105, the first power circuit heat exchange plate 402, and the first water pump 1061 sequentially communicate through the coolant path to form a circulation loop, so that when the condenser 105 supplies the heat energy to the battery heat exchange plate 302, heat generated by the first power circuit 401 and heat generated by the second power circuit 404 may also be supplied to the battery heat exchange plate 302. This can improve energy efficiency of the energy storage device 100.

In the heat pump mode, heat in the environment may be transferred to the condenser 105 via the first evaporator 103. Therefore, when a temperature of the first evaporator 103 is low, to dissipate cold of the first evaporator 103 to increase the temperature of the first evaporator 103, the first evaporator 103 may be heated by the electric heater 107, and heat of the first evaporator 103 may be increased through heat exchange between the radiator 501 and the first evaporator 103.

In addition, in the operating mode shown in FIG. 3d, the electric heater 107 may also be turned on as required, to increase a temperature of the battery heat exchange plate 302. It may be understood that, when the energy storage device 100 is deployed in a region with a low temperature, the electric heater 107 may be mounted based on an actual requirement, or when the energy storage device 100 is deployed in a region with a high temperature, the electric heater 107 may not be disposed. This can reduce deployment costs.

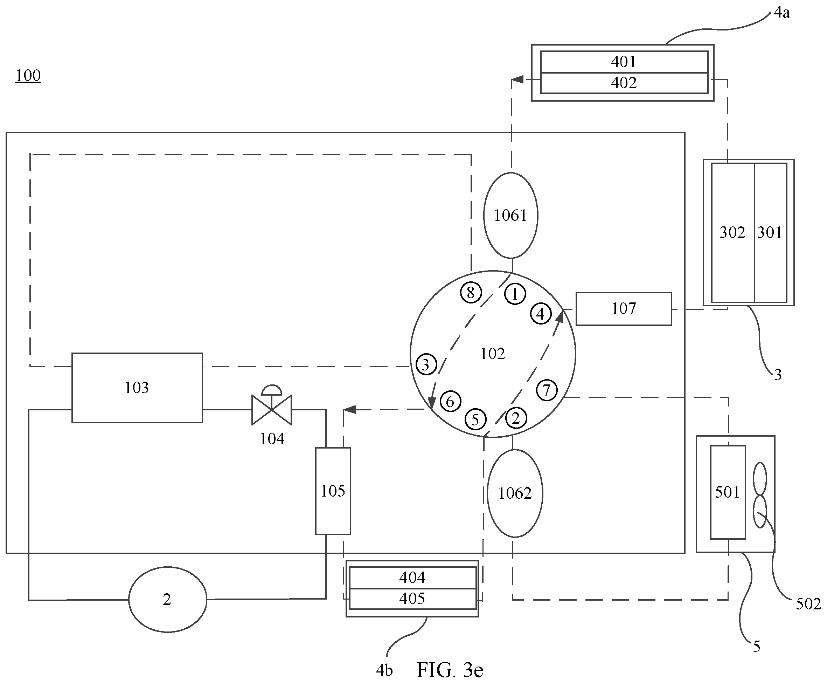

In addition, when the ambient temperature is low (for example, in a case of a low temperature in winter), and neither heat generated by the first power circuit 401 and the second power circuit 404 nor heat generated by the condenser 105 in the heat pump mode can meet a heating requirement of the battery 301, an operating mode of the energy storage device 100 may be shown in FIG. 3e. FIG. 3e is a diagram of a circulation path of the energy storage device 100 provided in FIG. 2a in the another operating mode. In this mode, the electric heater 107 is turned on, and the battery heat exchange plate 302, the first power circuit heat exchange plate 402, the first water pump 1061, the condenser 105, the second power circuit heat exchange plate 405, and the electric heater 107 sequentially communicate through a coolant pipe to form a circulation loop, so that a coolant circulating in the circulation loop is heated via the electric heater 107, to heat the battery 301. In addition, because the first power circuit heat exchange plate 402 and the second power circuit heat exchange plate 405 are also connected in series in the foregoing path, heat generated by the first power circuit heat exchange plate 402 and the second power circuit heat exchange plate 405 may also be transferred to the battery heat exchange plate 302, to heat the battery 301.

It should be noted that, in the operating mode shown in FIG. 3e, the compressor 2, the first evaporator 103, and the condenser 105 are all in an off state.

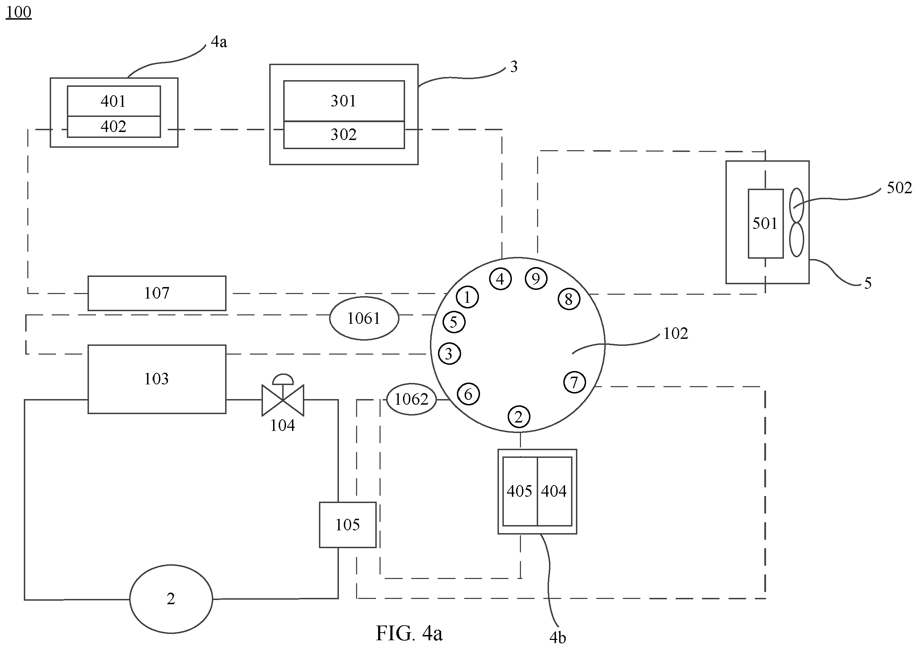

In the foregoing embodiment, the multi-way valve 102 is disposed as the eight-way valve, so that the multi-way valve 102 includes the eight valve ports configured to connect to the first evaporator 103, the condenser 105, or the first interface 1011. However, in actual application, a quantity of interfaces of the multi-way valve 102 may be further adjusted based on a specific requirement. For example, refer to FIG. 4a. FIG. 4a is a diagram of another structure of the energy storage device according to an embodiment of this application. The multi-way valve 102 of the energy storage device 100 shown in FIG. 4a is a nine-way valve, and the multi-way valve 102 includes nine valve ports configured to connect to the first evaporator 103, the condenser 105, or the first interface 1011.

In the energy storage device 100 shown in FIG. 4a, both one coolant port of the second power circuit heat exchange plate and one coolant port of the condenser are connected to a same valve port of the multi-way valve 102, and the other coolant port of the second power circuit heat exchange plate and the other coolant port of the condenser are respectively connected to different valve ports of the multi-way valve 102, so that a coolant circulation loop in which the second power circuit heat exchange plate is located is connected in parallel to a coolant circulation loop in which the condenser is located. In addition, another structure of the energy storage device shown in FIG. 4a is similar to that of the energy storage device shown in FIG. 2f. Details are not described herein again.

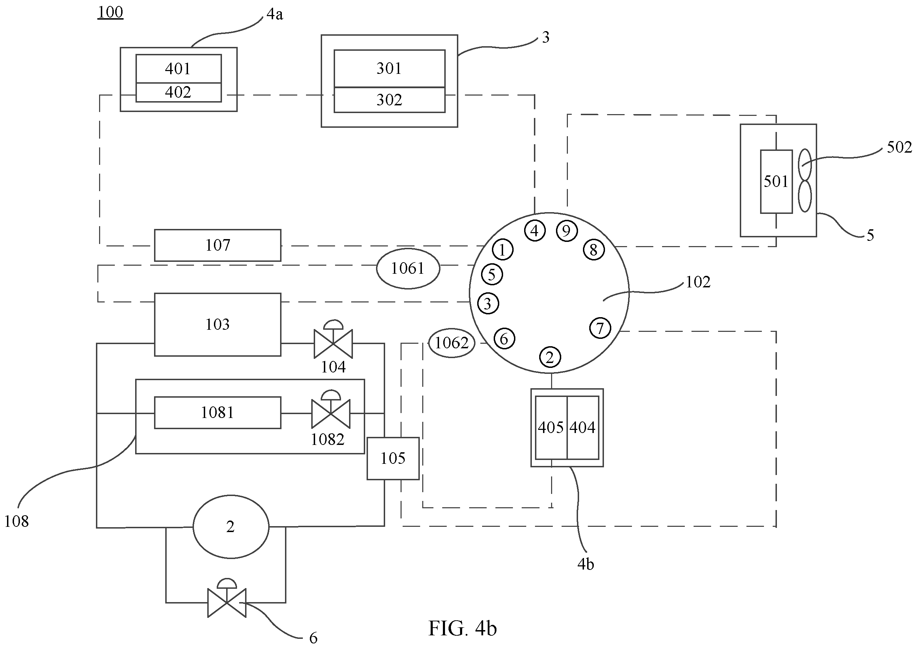

In this application, some adaptive deformation may be further performed on the energy storage device 100 shown in FIG. 4a. For example, refer to FIG. 4b. FIG. 4b is a diagram of another structure of the energy storage device 100 according to an embodiment of this application. Compared with the energy storage device 100 shown in FIG. 4a, in the energy storage device 100 in FIG. 4b, the third bypass valve 6 is added for the compressor 2, and the energy storage device 100 further includes the dehumidification module 108. For specific disposing manners of the third bypass valve 6 and the dehumidification module 108 and functions that can be implemented by the third bypass valve and the dehumidification module, refer to the foregoing embodiment. Details are not described herein again.

In addition, in actual application of the energy storage device shown in FIG. 4a, a state of connection between each of a coolant port of the first evaporator 103 and a coolant port of the condenser 105 and a different first interface may be effectively adjusted via the multi-way valve 102 based on an actual requirement, so that the energy storage device 100 shown in FIG. 4a can operate in a corresponding operating mode.

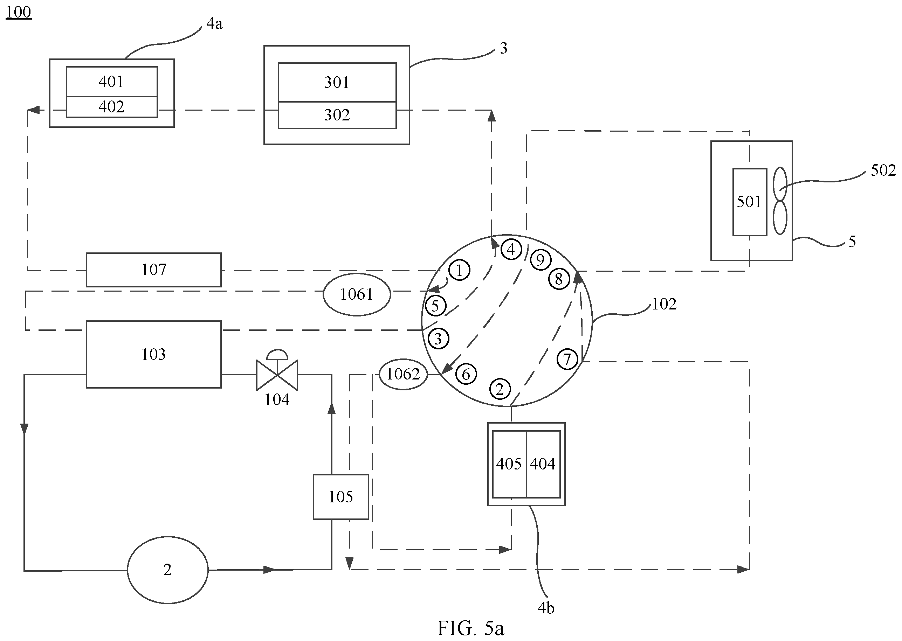

For example, when an ambient temperature is high (for example, in a case of a high temperature and high humidity in summer), refer to FIG. 5a. FIG. 5a is a diagram of a circulation path of the energy storage device 100 shown in FIG. 4a in an operating mode. FIG. 5a shows three circulation loops in the operating mode.

A first circulation loop includes the compressor 2, the condenser 105, the first throttle valve 104, and the first evaporator 103 that sequentially communicate through a refrigerant pipe. In this case, the first circulation loop is a refrigerant circulation loop. When a refrigerant circulates in the circulation loop, the first evaporator 103 may be at a low temperature.

In a second circulation loop, the multi-way valve 102 connects a coolant path between the battery heat exchange plate 302, the first power circuit heat exchange plate 402, and the first evaporator 103, so that the battery heat exchange plate 302, the first power circuit heat exchange plate 402, the electric heater 107, the first water pump 1061, and the first evaporator 103 sequentially communicate through the coolant path. Because a temperature of the first evaporator 103 is low in this case, the first evaporator 103 may cool a coolant circulating in the circulation loop, and the coolant cooled by the first evaporator 103 may exchange heat with the battery heat exchange plate 302 and the first power circuit heat exchange plate 402, to cool the battery heat exchange plate 302 and the first power circuit heat exchange plate 402, so as to dissipate heat of the battery 301 and the first power circuit 401. This can meet a heat dissipation requirement of the first power circuit 401 in an overload working condition, and can ensure reliable operation of the energy storage device 100.

In a third circulation loop, the multi-way valve 102 connects a coolant path between the second power circuit heat exchange plate 405 and the radiator 501, so that the radiator 501, the second water pump 1062, and the second power circuit heat exchange plate 405 sequentially communicate through the coolant path. In this case, when a coolant circulates in the circulation loop, the radiator 501 may cool the second power circuit heat exchange plate 405.

In the third circulation loop, the multi-way valve 102 connects a coolant path between the condenser 105 and the radiator 501, so that the radiator 501, the second water pump 1062, and the condenser 105 sequentially communicate through the coolant path. In this case, when the coolant circulates in the circulation loop, the radiator 501 may cool the condenser 105.

It should be noted that, in the operating mode shown in FIG. 5a, the electric heater 107 is in an off state.

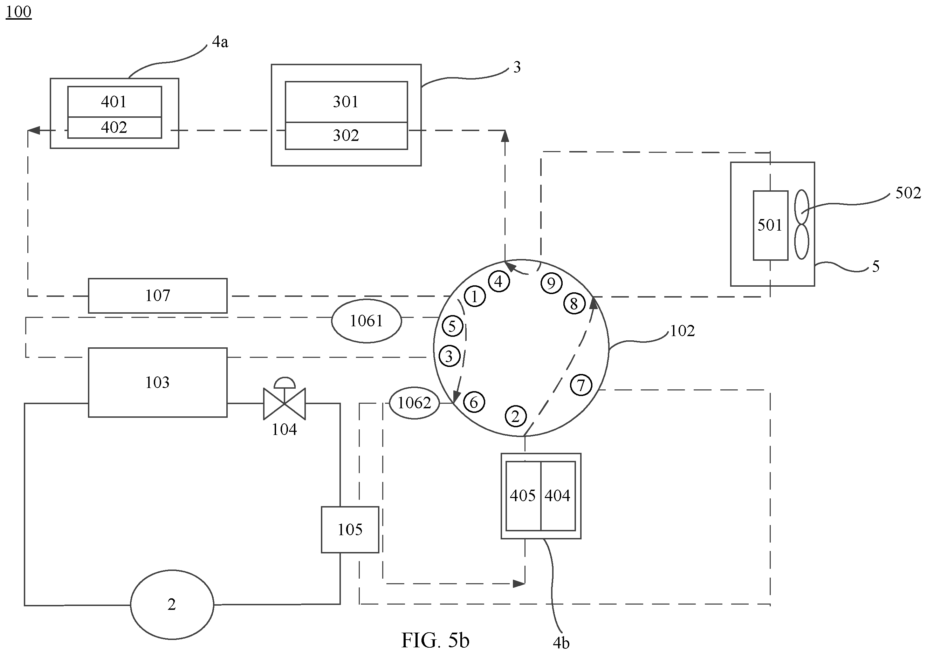

In addition, when an ambient temperature is moderate (for example, in spring or autumn), refer to FIG. 5b. FIG. 5b is a diagram of a circulation path of the energy storage device 100 shown in FIG. 4a in another operating mode. In the operating mode, the multi-way valve 102 connects a coolant path between the battery heat exchange plate 302, the first power circuit heat exchange plate 402, the second power circuit heat exchange plate 405, and the radiator 501, so that the battery heat exchange plate 302, the first power circuit heat exchange plate 402, the electric heater 107, the second water pump 1062, the second power circuit heat exchange plate 405, and the radiator 501 sequentially communicate through the coolant path to form a circulation loop. In this case, when a coolant circulates in the circulation loop, the radiator 501 may cool the battery heat exchange plate 302, the first power circuit heat exchange plate 402, and the second power circuit heat exchange plate 405, to dissipate heat of the battery 301, the first power circuit 401, and the second power circuit 404.

It should be noted that, in the operating mode shown in FIG. 5b, the electric heater 107 is in an off state. In addition, when the ambient temperature is temperate, heat dissipation requirements of the battery 301, the first power circuit 401, and the second power circuit 404 can be met only via the radiator 501. Therefore, the compressor 2, the first evaporator 103, and the condenser 105 are all in an off state in the operating mode.

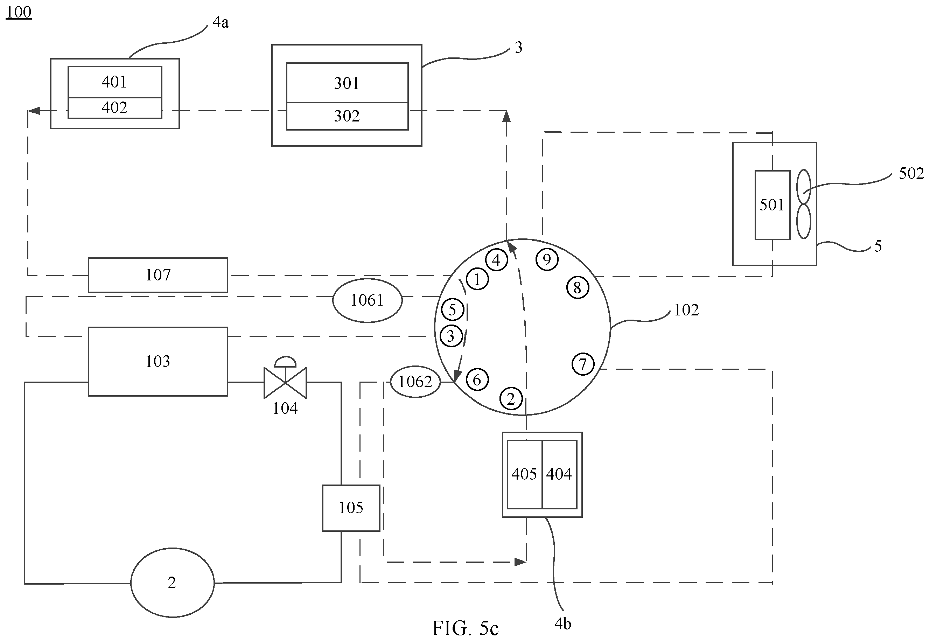

When an ambient temperature is low (for example, in a case of a low temperature in winter), refer to FIG. 5c. FIG. 5c is a diagram of a circulation path of the energy storage device 100 shown in FIG. 4a in another operating mode.

When the energy storage device 100 operates, the first power circuit 401 and the second power circuit 404 always generate a large amount of heat. In the case of the low temperature in winter, to ensure charging and discharging performance of the battery 301, the battery 301 needs to be heated. Therefore, the heat generated by the first power circuit 401 and heat generated by the second power circuit 404 may be used to heat the battery 301. During specific implementation, as shown in FIG. 5c, the multi-way valve 102 connects a coolant path between the battery heat exchange plate 302, the first power circuit heat exchange plate 402, and the second power circuit heat exchange plate 405, so that the battery heat exchange plate 302, the first power circuit heat exchange plate 402, the electric heater 107, the second water pump 1062, and the second power circuit heat exchange plate 405 sequentially communicate through the coolant path to form a circulation loop. In this case, when a coolant circulates in the circulation loop, the heat generated by the first power circuit 401 and heat generated by the second power circuit 404 may be transferred to the battery heat exchange plate 302, to heat the battery 301, thereby implementing efficient heat utilization. In the operating mode, the electric heater 107 may be turned on or off as required. Details are not described herein.

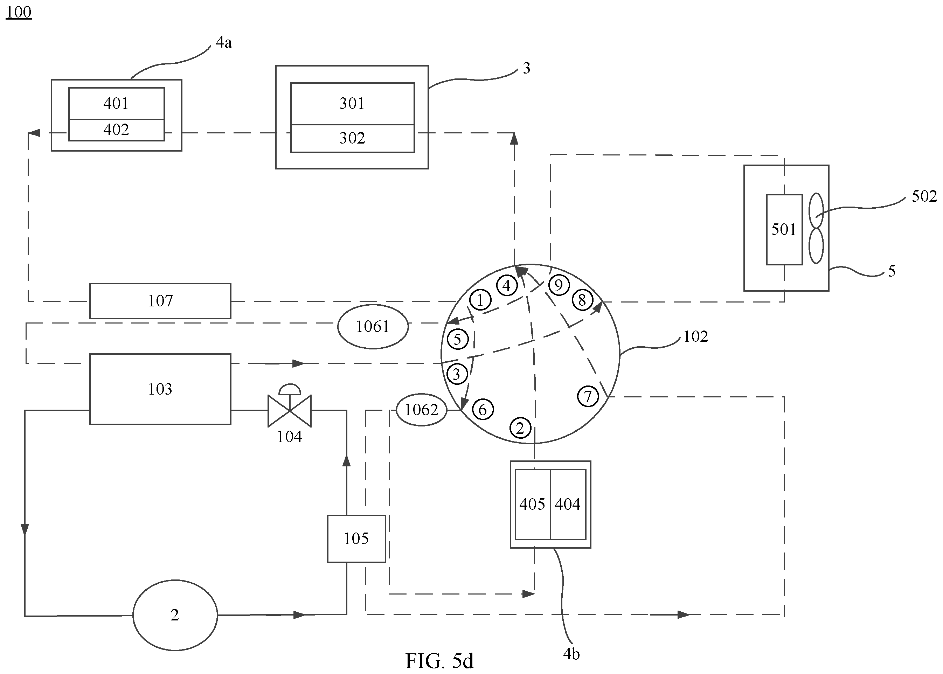

In the operating mode shown in FIG. 5c, the compressor 2, the first evaporator 103, and the condenser 105 are all in an off state. In actual application, as shown in FIG. 5d, both the first throttle valve 104 and the compressor 2 may be set to an on state as required, that is, the condenser 105 has a high temperature according to a working principle of a heat pump, to heat the battery heat exchange plate 302 via the condenser 105. During specific implementation, FIG. 5d shows four circulation loops.

A first circulation loop includes the compressor 2, the condenser 105, the first throttle valve 104, and a first evaporator 103 that sequentially communicate through a refrigerant pipe. In this case, when a refrigerant circulates in the circulation loop, the condenser 105 may have a high temperature.

In a second circulation loop, the multi-way valve 102 connects a coolant path between the battery heat exchange plate 302, the first power circuit heat exchange plate 402, and the condenser 105, so that the battery heat exchange plate 302, the first power circuit heat exchange plate 402, the electric heater 107, the second water pump 1062, and the condenser 105 sequentially communicate through the coolant path. In this case, when a coolant circulates in the circulation loop, both heat generated by the first power circuit 401 and heat generated by the condenser 105 may be transferred to the battery heat exchange plate 302, to heat the battery 301.

In a third circulation loop, the multi-way valve 102 connects a coolant path between the battery heat exchange plate 302, the first power circuit heat exchange plate 402, and the second power circuit heat exchange plate 405, so that the battery heat exchange plate 302, the first power circuit heat exchange plate 402, the electric heater 107, the second water pump 1062, and the second power circuit heat exchange plate 405 sequentially communicate through the coolant path. In this case, when a coolant circulates in the circulation loop, both heat generated by the first power circuit 401 and heat generated by the second power circuit 404 may be transferred to the battery heat exchange plate 302, to heat the battery 301.

In a fourth circulation loop, the multi-way valve 102 connects a coolant path between the first evaporator 103 and the radiator 501, so that the first evaporator 103, the radiator 501, and the first water pump 1061 sequentially communicate through the coolant path. It may be understood that, in the heat pump mode, heat in an environment may be transferred to the condenser 105 via the first evaporator 103. Therefore, when a temperature of the first evaporator 103 is low, to dissipate cold of the first evaporator 103 to increase the temperature of the first evaporator 103, the first evaporator 103 may be heated by the electric heater 107, and heat of the first evaporator 103 may be increased through heat exchange between the radiator 501 and the first evaporator 103.

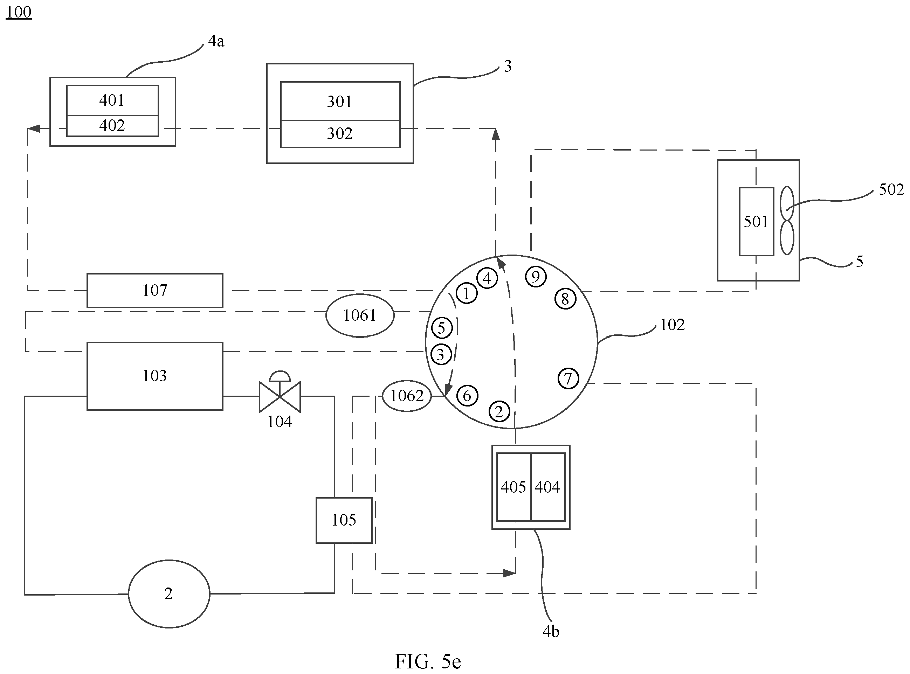

In addition, when the ambient temperature is low (for example, in a case of a low temperature in winter), and neither heat generated by the first power circuit 401 and the second power circuit 404 nor heat generated by the condenser 105 in the heat pump mode can meet a heating requirement of the battery 301, an operating mode of the energy storage device 100 is shown in FIG. 5e. FIG. 5e is a diagram of a circulation path of the energy storage device 100 shown in FIG. 4a in the another operating mode. In the operating mode, the electric heater 107 is turned on, and the battery heat exchange plate 302, the first power circuit heat exchange plate 402, the electric heater 107, the second water pump 1062, and the second power circuit heat exchange plate 405 sequentially communicate through a coolant pipe to form a circulation loop, so that a coolant circulating in the circulation loop is heated via the electric heater 107, the first power circuit 401, and the second power circuit 404, to heat the battery 301.

It should be noted that, in the operating mode shown in FIG. 5e, the compressor 2, the first evaporator 103, and the condenser 105 are all in an off state.

When the energy storage device 100 operates in a working condition with a low ambient temperature, in addition to heating the battery via the electric heater 107, another possible manner may be used. For example, in the energy storage device 100 shown in FIG. 4b, the compressor 2 is connected in parallel to the third bypass valve 6. In this case, when the compressor 2 operates in a heating state, the third bypass valve 6 is turned on, to reduce pressure of the compressor 2, so as to heat the battery 301 via heat generated by the compressor 2. For another operating mode of the energy storage device 100 in FIG. 4b, refer to FIG. 5a to FIG. 5e. Details are not described herein again.

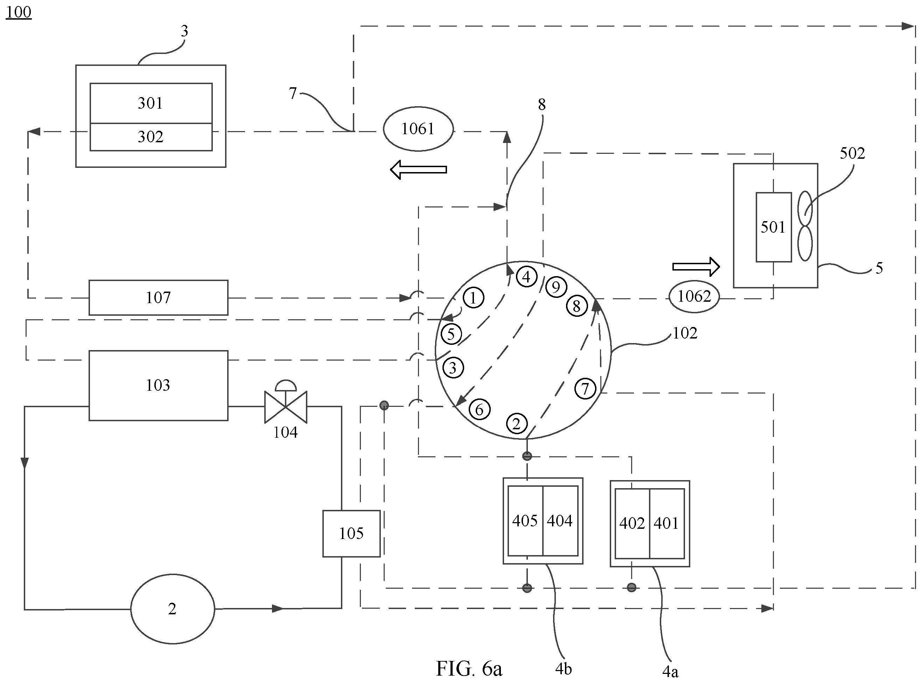

FIG. 6a is a diagram of another structure of the energy storage device according to an embodiment of this application. The multi-way valve of the energy storage device shown in FIG. 6a is also a nine-way valve. However, different from that of the energy storage device shown in FIG. 4a, two coolant ports of the first power circuit heat exchange plate 402 are connected to two coolant ports of the second power circuit heat exchange plate 405 in a one-to-one correspondence. Specifically, one coolant port of the first power circuit heat exchange plate 402, one coolant port of the second power circuit heat exchange plate 405, and one coolant port of the condenser 105 are all connected to a same valve port of the multi-way valve 102, the other coolant port of the first power circuit heat exchange plate 402 and the other coolant port of the condenser 105 are respectively connected to different valve ports of the multi-way valve 102, the other coolant port of the second power circuit heat exchange plate 405 and the other coolant port of the condenser 105 are respectively connected to different valve ports of the multi-way valve 102, and the other coolant port of the first power circuit heat exchange plate 402 and the other coolant port of the second power circuit heat exchange plate 405 are connected to a same valve port of the multi-way valve 102, so that a coolant circulation loop in which the first power circuit heat exchange plate 402 and the second power circuit heat exchange plate 405 are located is connected in parallel to a coolant circulation loop in which the condenser is located.

Still refer to FIG. 6a. The battery heat exchange plate 302 and the first water pump 1061 are connected in series and then connected between two valve ports of the multi-way valve 102. A coolant pipe connecting the battery heat exchange plate 302 and a valve port of the multi-way valve 102 may be further provided with a liquid supply port 7 and a liquid return port 8. The liquid return port 8 communicates with a liquid inlet of the first water pump 1061, and the liquid supply port 7 communicates with a liquid outlet of the first water pump 1061. In addition, the liquid supply port 7 is connected to one coolant port of the first power circuit heat exchange plate 402 and one coolant port of the second power circuit heat exchange plate 405, and the liquid return port 8 is connected to the other coolant port of the first power circuit heat exchange plate 402 and the other coolant port of the second power circuit heat exchange plate 405.

Therefore, in a scenario, such as a high-temperature environment or overload operation, in which the first power circuit 401 and the second power circuit 404 have a high heat dissipation requirement, a part of a low-temperature coolant that flows out of the liquid outlet of the first water pump 1061 and that is used to cool the battery 301 may be guided, via the liquid supply port 7, to the coolant circulation loop in which the first power circuit heat exchange plate 402 and the second power circuit heat exchange plate 405 are located, and a part of a coolant flowing through the first power circuit heat exchange plate 402 and the second power circuit heat exchange plate 405 flows back to the liquid inlet of the first water pump 1061 via the liquid return port 8, and then flows back to the coolant circulation loop in which the battery heat exchange plate 302 is located, to ensure balance of coolants in the coolant circulation loops and dissipate heat of the first power circuit heat exchange plate 402 and the second power circuit heat exchange plate 405, so as to dissipate heat of the first power circuit 401 and the second power circuit 404.

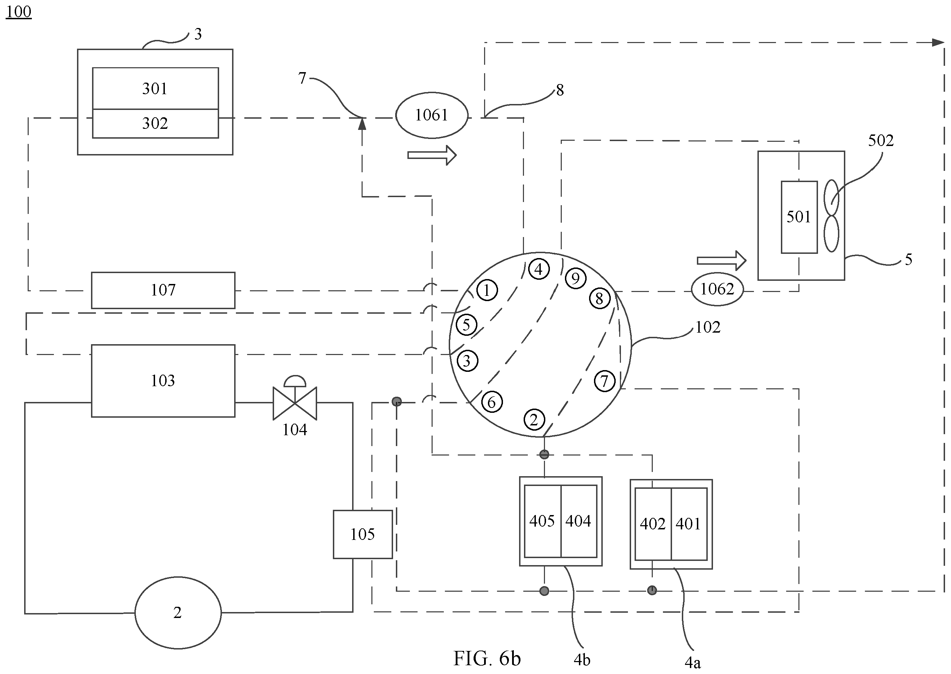

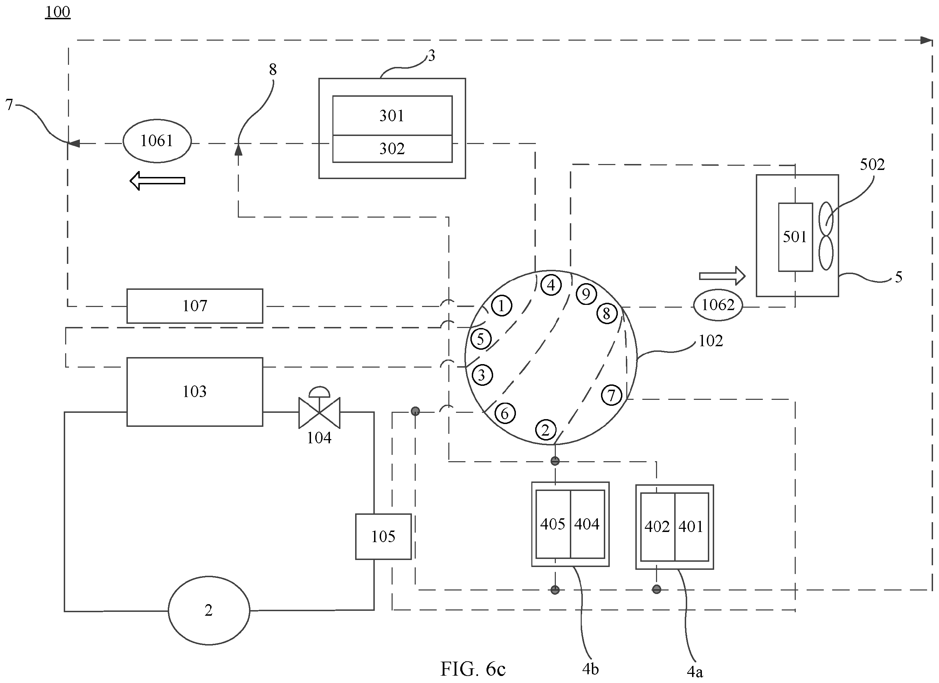

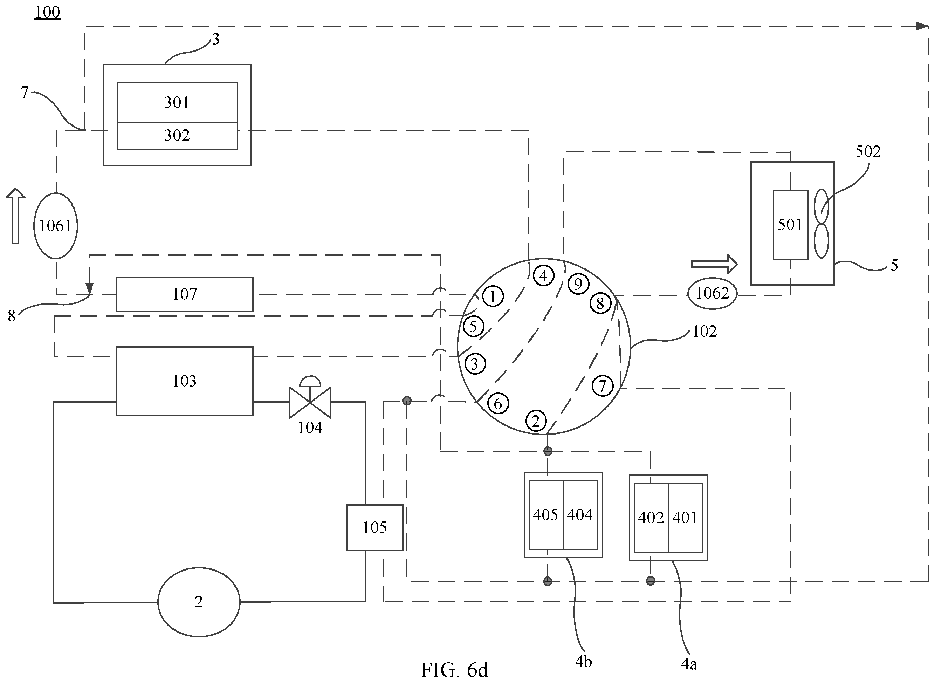

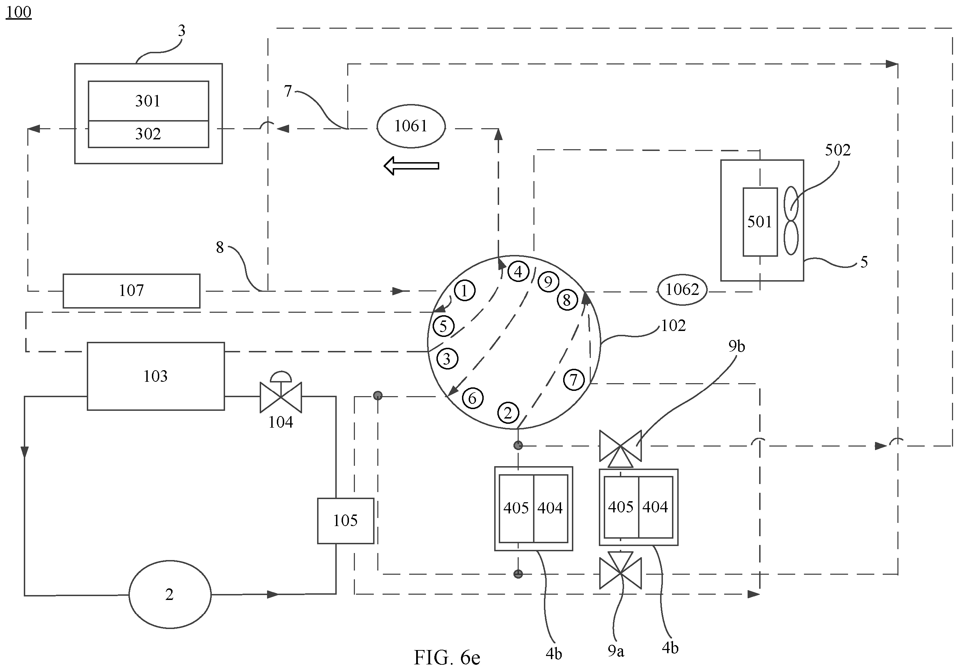

It should be noted that, in this application, specific relative positions of the liquid supply port 7 and the liquid return port 8 relative to the battery heat exchange plate 302 are not limited. For example, in the energy storage device shown in FIG. 6a, both the liquid supply port 7 and the liquid return port 8 are located on a coolant pipe between a coolant inlet port of the battery heat exchange plate 302 and the multi-way valve 102. For another example, in the energy storage device shown in FIG. 6b, both the liquid supply port 7 and the liquid return port 8 are located on a coolant pipe between a coolant inlet port of the battery heat exchange plate 302 and the multi-way valve 102, but the liquid inlet and the liquid outlet of the first water pump 1061 are oppositely disposed in direction in FIG. 6a and FIG. 6b. For another example, in the energy storage device shown in FIG. 6c, both the liquid supply port 7 and the liquid return port 8 are located on a coolant pipe between a coolant outlet port of the battery heat exchange plate 302 and the multi-way valve 102. For another example, in the energy storage device shown in FIG. 6d, both the liquid supply port 7 and the liquid return port 8 are located on a coolant pipe between a coolant outlet port of the battery heat exchange plate 302 and the multi-way valve 102, but the liquid inlet and the liquid outlet of the first water pump 1061 are oppositely disposed in direction in FIG. 6c and FIG. 6d. For another example, in the energy storage device 100 shown in FIG. 6e, the liquid supply port 7 and the liquid return port 8 are respectively located on two sides of the battery heat exchange plate 302.

In addition, the liquid supply port 7 may be directly or indirectly connected to the liquid outlet of the first water pump 1061, and the liquid return port 8 may be directly or indirectly connected to the liquid inlet of the first water pump 1061. This is not specifically limited in this application, provided that a coolant flowing out of the liquid outlet of the first water pump 1061 can flow to the first power circuit heat exchange plate 402 and the second power circuit heat exchange plate 405, and a coolant flowing from the first power circuit heat exchange plate 402 and the second power circuit heat exchange plate 405 to the liquid return port 8 can flow back to the first water pump 1061 via the liquid inlet of the first water pump 1061. In addition, because relative positions of the first water pump 1061 and the battery heat exchange plate 302 are not limited, specific positions for disposing the liquid supply port 7 and the liquid return port 8 may be further adjusted based on a position for disposing the first water pump 1061. Details are not described herein one by one.

In some possible working conditions, the first power circuit 401 and the second power circuit 404 have different heat dissipation requirements. To separately adjust and control temperatures of the first power circuit 401 and the second power circuit 404, reversing valves are also respectively disposed between both one coolant port of the first power circuit heat exchange plate 402 and one coolant port of the second power circuit heat exchange plate 405 and the liquid supply port 7 and between both the other coolant port of the first power circuit heat exchange plate 402 and the other coolant port of the second power circuit heat exchange plate 405 and the liquid return port 8. During specific implementation, still refer to FIG. 6b. The energy storage device 100 further includes a first three-way valve 9a and a second three-way valve 9b. One coolant port of the first power circuit heat exchange plate 402, one coolant port of the second power circuit heat exchange plate 405, and the liquid supply port 7 are respectively connected to three valve ports of the first three-way valve 9a in a one-to-one correspondence, and the other coolant port of the first power circuit heat exchange plate 402, the other coolant port of the second power circuit heat exchange plate 405, and the liquid return port 8 are respectively connected to three valve ports of the second three-way valve 9b in a one-to-one correspondence, to control a state of connection or disconnection between the one coolant port of the first power circuit heat exchange plate 402, the one coolant port of the second power circuit heat exchange plate 405, and the liquid supply port 7 and a state of connection or disconnection between the other coolant port of the first power circuit heat exchange plate 402, the other coolant port of the second power circuit heat exchange plate 405, and the liquid return port 8 by connecting or disconnecting the valve ports of the first three-way valve 9a and the second three-way valve 9b. Therefore, the temperatures of the first power circuit 401 and the second power circuit 404 are separately adjusted and controlled. This helps improve energy efficiency of the energy storage device 100.

All other structures of the energy storage device 100 shown in FIG. 6a to FIG. 6e may be disposed with reference to FIG. 4a and FIG. 4b. In addition, for operating modes of the energy storage device 100 shown in FIG. 6a to FIG. 6e, refer to FIG. 5a to FIG. 5e. Details are not described herein.

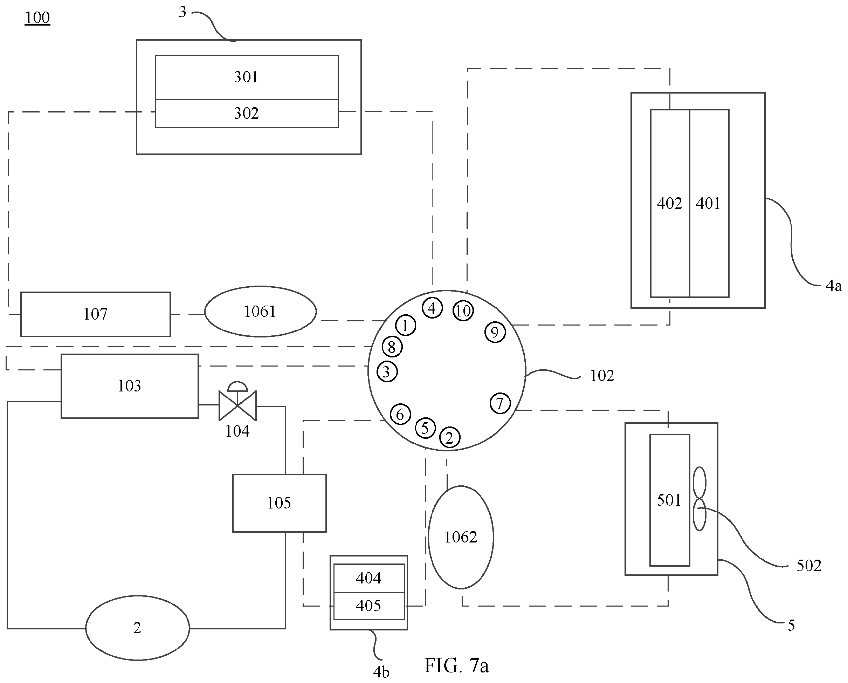

FIG. 7a is a diagram of another structure of the energy storage device 100 according to an embodiment of this application. In the energy storage device 100, the multi-way valve 102 of the heat management module 1 is a 10-way valve, and the 10-way valve may provide 10 valve ports configured to connect to the first evaporator 103, the condenser 105, or the first interface 1011.

In the energy storage device 100 shown in FIG. 7a, the first power circuit heat exchange plate 402 and the battery heat exchange plate 302 each are connected between different first interfaces, so that two coolant ports of the first power circuit heat exchange plate 402 and two coolant ports of the battery heat exchange plate 302 are respectively connected to different valve ports of the multi-way valve 102. As shown in FIG. 7a, the two coolant ports of the battery heat exchange plate 302 are respectively connected to a valve port 1 and a valve port 4 of the multi-way valve 102, and the two coolant ports of the first power circuit heat exchange plate 402 are respectively connected to a valve port 9 and a valve port 10 of the multi-way valve 102. In addition, another structure of the energy storage device shown in FIG. 7a is similar to that of the energy storage device shown in FIG. 2a. Details are not described herein again.

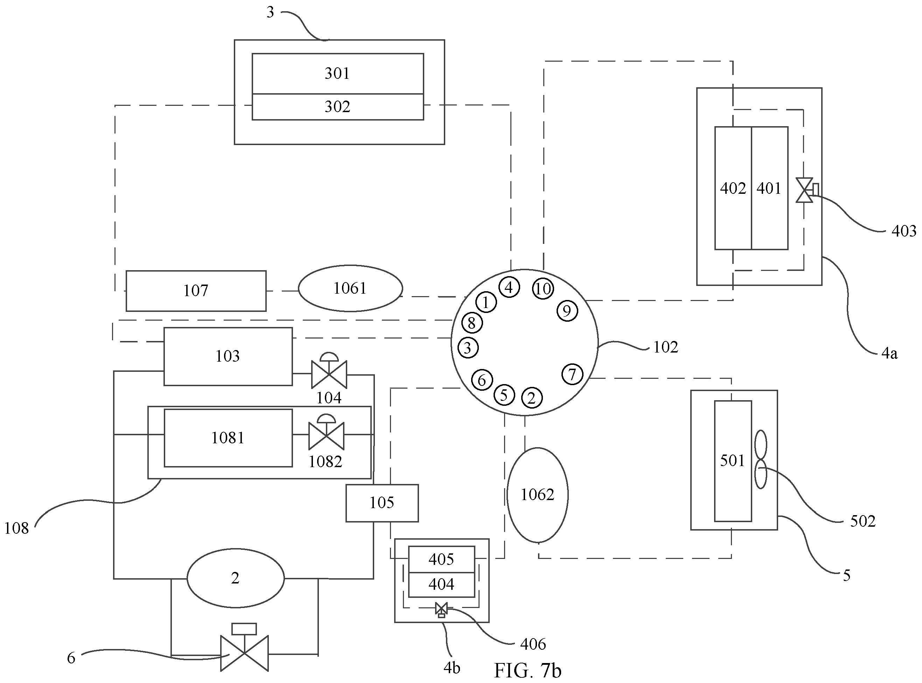

In this application, some adaptive deformation may be further performed on the energy storage device 100 shown in FIG. 7a. For example, refer to FIG. 7b. FIG. 7b is a diagram of another structure of the energy storage device 100 according to an embodiment of this application. Compared with the energy storage device 100 shown in FIG. 7a, in the energy storage device 100 in FIG. 7b, the third bypass valve 6 is added for the compressor 2, and the energy storage device 100 further includes the dehumidification module 108. For specific disposing manners of the third bypass valve 6 and the dehumidification module 108 and functions that can be implemented by the third bypass valve and the dehumidification module, refer to the foregoing embodiment. Details are not described herein again.

In addition, in actual application of the energy storage device 100 shown in FIG. 7a, a state of connection between each of a coolant port of the first evaporator 103 and a coolant port of the condenser 105 and a different first interface 1011 may be effectively adjusted via the multi-way valve 102 based on an actual requirement, so that the energy storage device 100 shown in FIG. 7a can operate in a corresponding operating mode.

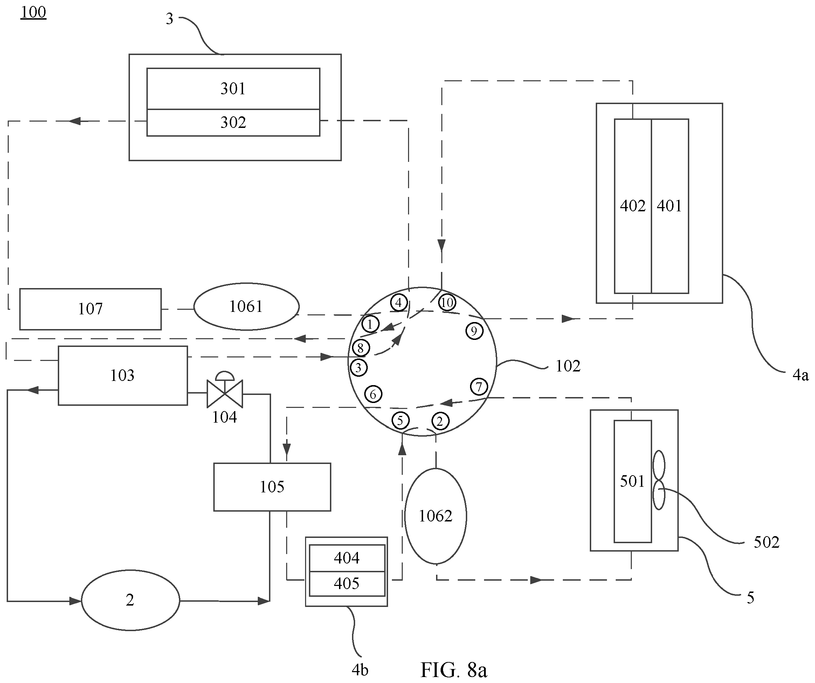

For example, when an ambient temperature is high (for example, in a case of a high temperature and high humidity in summer), refer to FIG. 8a. FIG. 8a is a diagram of a circulation path of the energy storage device 100 shown in FIG. 7a in an operating mode. FIG. 8a shows three circulation loops in the operating mode.

A first circulation loop includes the compressor 2, the condenser 105, the first throttle valve 104, and the first evaporator 103 that sequentially communicate through a refrigerant pipe. In this case, the first circulation loop is a refrigerant circulation loop. When a refrigerant circulates in the circulation loop, the first evaporator 103 may be at a low temperature.

In a second circulation loop, the multi-way valve 102 connects a coolant path between the battery heat exchange plate 302, the first power circuit heat exchange plate 402, and the first evaporator 103, so that the battery heat exchange plate 302, the electric heater 107, the first water pump 1061, the first power circuit heat exchange plate 402, and the first evaporator 103 sequentially communicate through the coolant path. Because a temperature of the first evaporator 103 is low in this case, the first evaporator 103 may cool a coolant circulating in the circulation loop, and the coolant cooled by the first evaporator 103 may exchange heat with the battery heat exchange plate 302 and the first power circuit heat exchange plate 402, to cool the battery heat exchange plate 302 and the first power circuit heat exchange plate 402, so as to dissipate heat of the battery 301 and the first power circuit 401. This can meet a heat dissipation requirement of the first power circuit 401 in an overload working condition, and can ensure reliable operation of the energy storage device 100.

In a third circulation loop, the multi-way valve 102 connects a coolant path between the condenser 105, the second power circuit heat exchange plate 405, and the radiator 501, so that the radiator 501, the condenser 105, the second power circuit heat exchange plate 405, and the second water pump 1062 sequentially communicate through the coolant path. In this case, when a coolant circulates in the circulation loop, the radiator 501 may cool both the condenser 105 and the second power circuit heat exchange plate 405. This can improve energy efficiency of the energy storage device 100.

It should be noted that, in the operating mode shown in FIG. 8a, the electric heater 107 is in an off state.

In addition, in another possible embodiment, the battery heat exchange plate 302 may also be cooled via the radiator 501. For example, in the multi-way valve 102, an interface 7 may communicate with an interface 4, and an interface 1 may communicate with an interface 2. In this case, the battery heat exchange plate 302, the electric heater 107, the first water pump 1061, the second water pump 1062, and the radiator 501 sequentially communicate through a coolant pipe to form a circulation loop, so that a coolant can circulate between the battery heat exchange plate 302 and the radiator 501, to dissipate heat of the battery heat exchange plate 302 via the radiator 501.

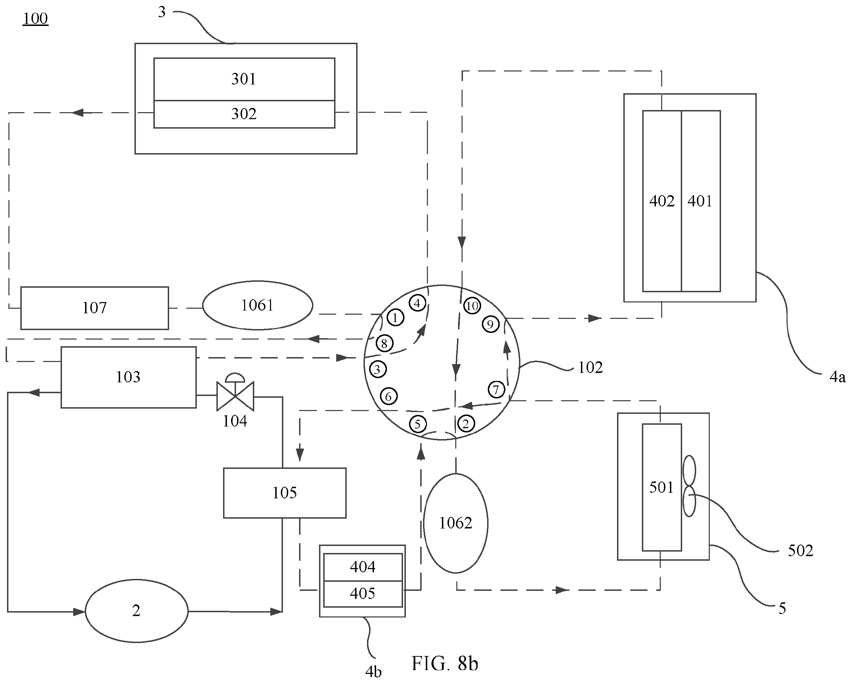

In addition, when an ambient temperature is high (for example, in a case of a high temperature and high humidity in summer), but the first power circuit heat exchange plate 402 operates in a rated load working condition, heat of the first power circuit heat exchange plate 402 may alternatively be dissipated via the radiator module 5. During specific implementation, refer to FIG. 8b. FIG. 8b is a diagram of a circulation path of the energy storage device 100 shown in FIG. 7a in another operating mode. FIG. 8b shows four circulation loops in the operating mode.

A first circulation loop includes the compressor 2, the condenser 105, the first throttle valve 104, and the first evaporator 103 that sequentially communicate through a refrigerant pipe. In this case, the first circulation loop is a refrigerant circulation loop. When a refrigerant circulates in the circulation loop, the first evaporator 103 may be at a low temperature.

In a second circulation loop, the multi-way valve 102 connects a coolant path between the battery heat exchange plate 302 and the first evaporator 103, so that the battery heat exchange plate 302, the electric heater 107, the first water pump 1061, and the first evaporator 103 sequentially communicate through the coolant path. Because a temperature of the first evaporator 103 is low in this case, the first evaporator 103 may cool a coolant circulating in the circulation loop, and the coolant cooled by the first evaporator 103 may exchange heat with the battery heat exchange plate 302, to cool the battery heat exchange plate 302, so as to dissipate heat of the battery 301.

In a third circulation loop, the multi-way valve 102 connects a coolant path between the condenser 105, the second power circuit heat exchange plate 405, and the radiator 501, so that the radiator 501, the condenser 105, the second power circuit heat exchange plate 405, and the second water pump 1062 sequentially communicate through the coolant path. In this case, when a coolant circulates in the circulation loop, the radiator 501 may cool both the condenser 105 and the second power circuit heat exchange plate 405. This can improve energy efficiency of the energy storage device 100.

In a fourth circulation loop, the multi-way valve 102 connects a coolant path between the first power circuit heat exchange plate 402 and the radiator 501, so that the radiator 501, the first power circuit heat exchange plate 402, and the second water pump 1062 sequentially communicate through the coolant path. In this case, when a coolant circulates in the circulation loop, the radiator 501 may also cool the first power circuit heat exchange plate 402. This can improve energy efficiency of the energy storage device 100.

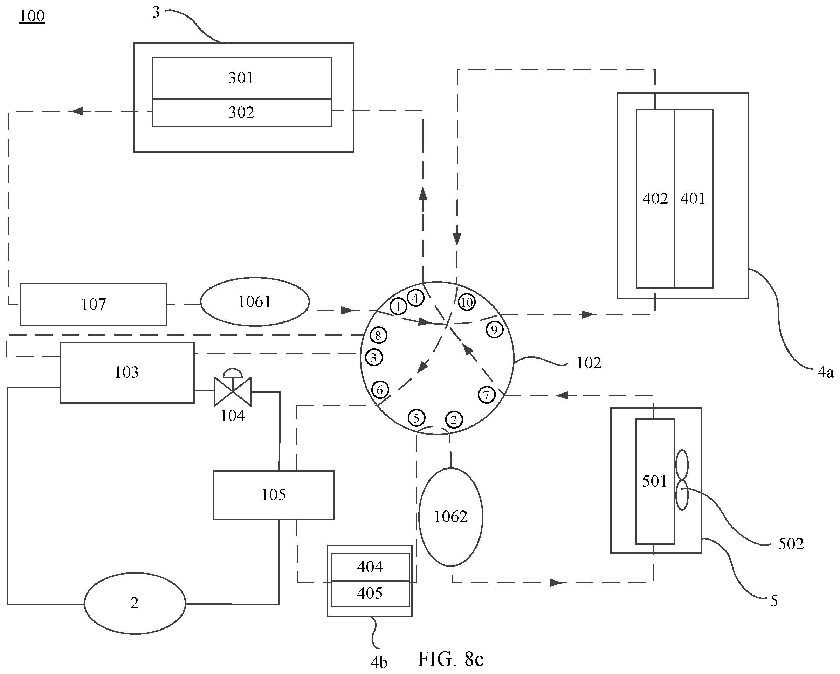

In addition, when an ambient temperature is moderate (for example, in spring or autumn), refer to FIG. 8c. FIG. 8c is a diagram of a circulation path of the energy storage device 100 shown in FIG. 7a in another operating mode. In the operating mode, the multi-way valve 102 connects a coolant path between the battery heat exchange plate 302, the first power circuit heat exchange plate 402, the second power circuit heat exchange plate 405, and the radiator 501, so that the battery heat exchange plate 302, the electric heater 107, the first water pump 1061, the first power circuit heat exchange plate 402, the condenser 105, the second power circuit heat exchange plate 405, the second water pump 1062, and the radiator 501 sequentially communicate through the coolant path to form a circulation loop. In this case, when a coolant circulates in the circulation loop, the radiator 501 may cool the battery heat exchange plate 302, the first power circuit heat exchange plate 402, and the second power circuit heat exchange plate 405, to dissipate heat of the battery 301, the first power circuit 401, and the second power circuit 404.

It should be noted that, in the operating mode shown in FIG. 8c, the electric heater 107 is in an off state. In addition, when the ambient temperature is temperate, heat dissipation requirements of the battery 301, the first power circuit 401, and the second power circuit 404 can be met only via the radiator 501. Therefore, the compressor 2, the first evaporator 103, and the condenser 105 are all in an off state in the operating mode.

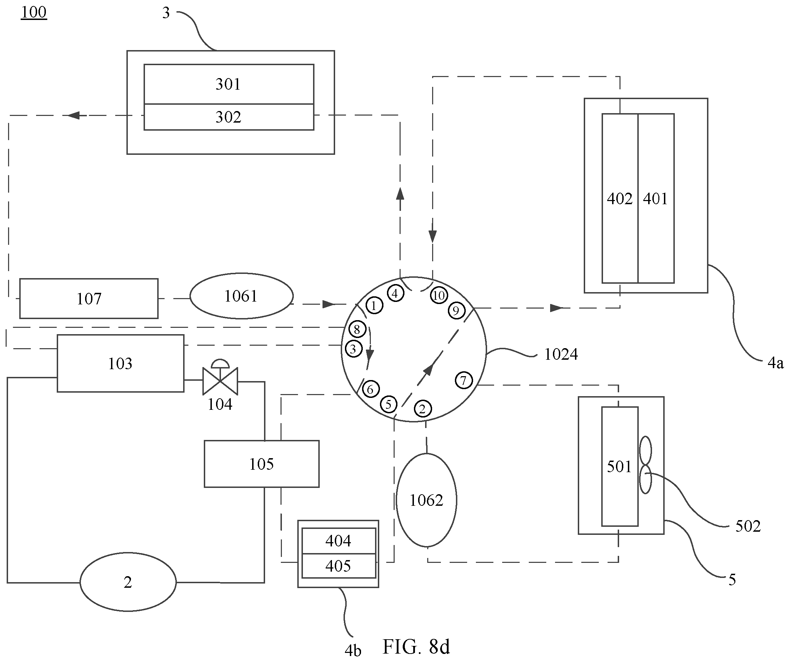

When an ambient temperature is low (for example, in a case of a low temperature in winter), refer to FIG. 8d. FIG. 8d is a diagram of a circulation path of the energy storage device 100 shown in FIG. 7a in another operating mode.

When the energy storage device 100 operates, the first power circuit 401 and the second power circuit 404 always generate a large amount of heat. In the case of the low temperature in winter, to ensure charging and discharging performance of the battery 301, the battery 301 needs to be heated. Therefore, heat generated by the first power circuit 401 and heat generated by the second power circuit 404 may be used to heat the battery 301. During specific implementation, as shown in FIG. 8d, the multi-way valve 102 connects a coolant path between the battery heat exchange plate 302, the first power circuit heat exchange plate 402, and the second power circuit heat exchange plate 405, so that the battery heat exchange plate 302, the electric heater 107, the first water pump 1061, the condenser 105, the second power circuit heat exchange plate 405, and the first power circuit heat exchange plate 402 sequentially communicate through the coolant path to form a circulation loop. In this case, when a coolant circulates in the circulation loop, the heat generated by the first power circuit 401 and the heat generated by the second power circuit 404 may be transferred to the battery heat exchange plate 302, to heat the battery 301, thereby implementing efficient heat utilization. In the operating mode, the electric heater 107 may be turned on or off as required. Details are not described herein.

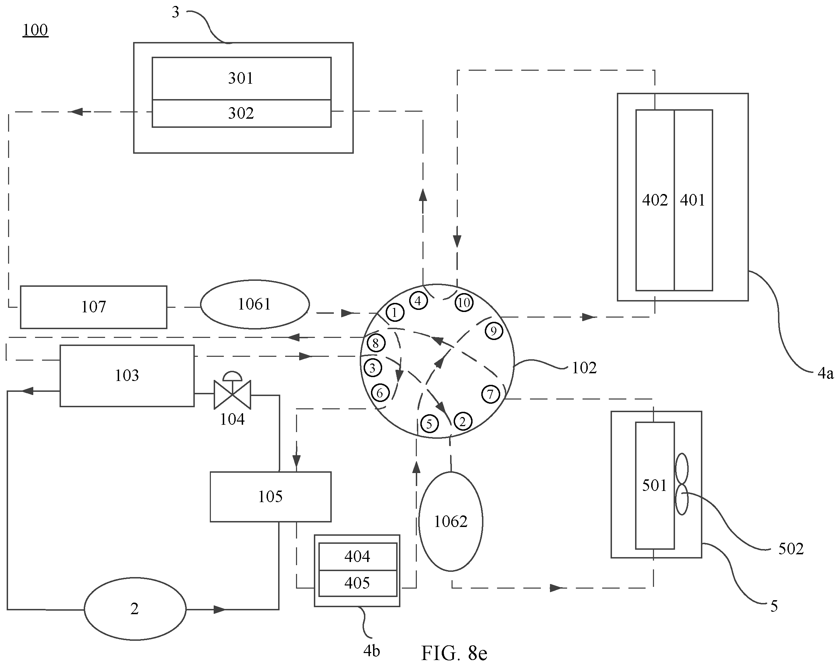

In the operating mode shown in FIG. 8d, the compressor 2, the first evaporator 103, and the condenser 105 are all in an off state. In actual application, as shown in FIG. 8e, both the first throttle valve 104 and the compressor 2 may be set to an on state as required, that is, the condenser 105 has a high temperature according to a working principle of a heat pump, to heat the battery heat exchange plate 302 via the condenser 105. During specific implementation, FIG. 8e shows three circulation loops.

A first circulation loop includes the compressor 2, the condenser 105, the first throttle valve 104, and the first evaporator 103 that sequentially communicate through a refrigerant pipe. In this case, when a refrigerant circulates in the circulation loop, the condenser 105 may have a high temperature.

In a second circulation loop, the multi-way valve 102 connects a coolant path between the battery heat exchange plate 302, the condenser 105, the second power circuit heat exchange plate 405, and the first power circuit heat exchange plate 402, so that the battery heat exchange plate 302, the electric heater 107, the first water pump 1061, the condenser 105, the second power circuit heat exchange plate 405, and the first power circuit heat exchange plate 402 sequentially communicate through the coolant path. In this case, when a coolant circulates in the circulation loop, heat generated by the first power circuit 401, heat generated by the second power circuit 404, and heat generated by the condenser 105 may all be transferred to the battery heat exchange plate 302, to heat the battery 301.

In a third circulation loop, the multi-way valve 102 connects a coolant path between the first evaporator 103 and the radiator 501, so that the first evaporator 103, the radiator 501, and the second water pump 1062 sequentially communicate through the coolant path. It may be understood that, in a heat pump mode, heat in an environment may be transferred to the condenser 105 via the first evaporator 103. Therefore, when a temperature of the first evaporator 103 is low, to dissipate cold of the first evaporator 103 to increase the temperature of the first evaporator 103, the first evaporator 103 may be heated by the electric heater 107, and heat of the first evaporator 103 may be increased through heat exchange between the radiator 501 and the first evaporator 103.

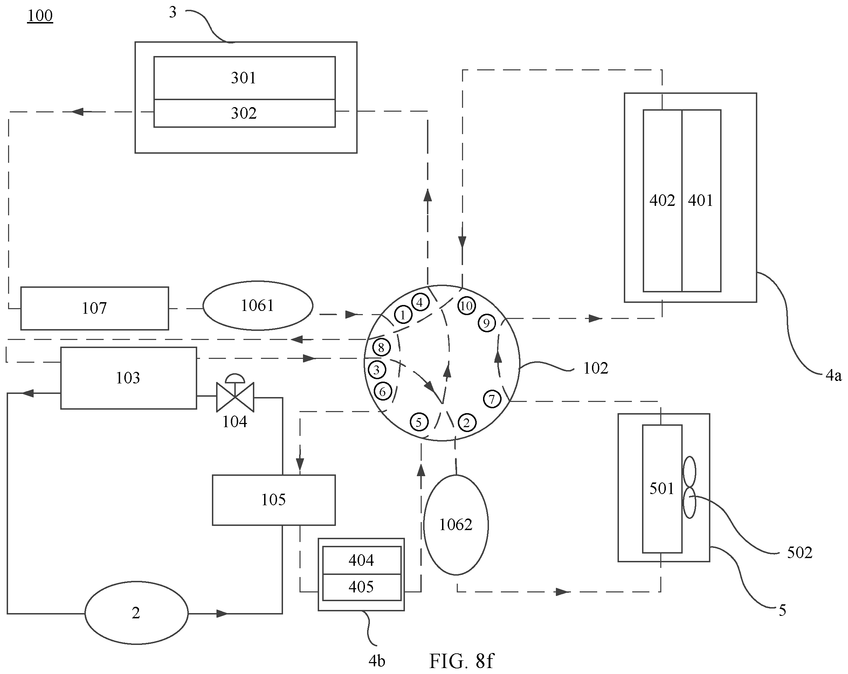

When the energy storage system 100 operates in the heat pump mode, another possible circulation loop may also be formed, provided that the battery heat exchange plate 302 and the condenser 105 are connected in series. For example, refer to FIG. 8f. FIG. 8f shows three circulation loops.

A first circulation loop includes the compressor 2, the condenser 105, the first throttle valve 104, and the first evaporator 103 that sequentially communicate through a refrigerant pipe. In this case, when a refrigerant circulates in the circulation loop, the condenser 105 may have a high temperature.

In a second circulation loop, the battery heat exchange plate 302, the electric heater 107, the first water pump 1061, the condenser 105, and the second power circuit heat exchange plate 405 sequentially communicate through the coolant path. In this case, when a coolant circulates in the circulation loop, both heat generated by the condenser 105 and heat generated by the second power circuit 404 may be transferred to the battery heat exchange plate 302, to heat the battery 301.

In a third circulation loop, the multi-way valve 102 connects a coolant path between the first evaporator 103, the first power circuit heat exchange plate 402, and the radiator 501, so that the first evaporator 103, the second water pump 1062, the radiator 501, and the first power circuit heat exchange plate 402 sequentially communicate through the coolant path. In this way, heat of the first evaporator 103 may be increased through heat exchange between each of the radiator 501 and the first power circuit heat exchange plate 402 and the first evaporator 103, to increase the temperature of the first evaporator 103.

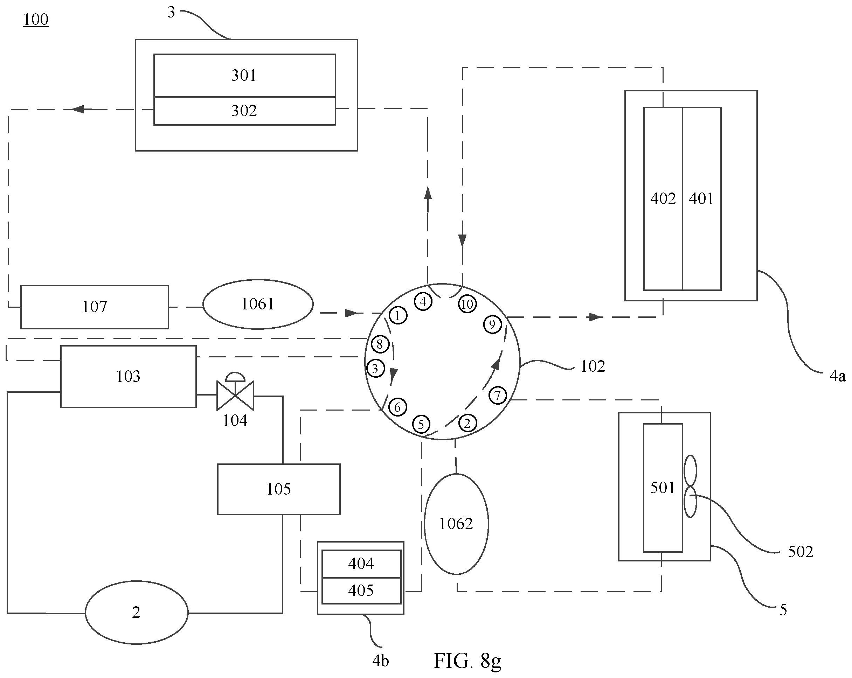

In addition, when the ambient temperature is low (for example, in a case of a low temperature in winter), and neither heat generated by the first power circuit 401 and the second power circuit 404 nor heat generated by the condenser 105 in the heat pump mode can meet a heating requirement of the battery 301, an operating mode of the energy storage device 100 is shown in FIG. 8g. FIG. 8g is a diagram of a circulation path of the energy storage device 100 shown in FIG. 7a in the another operating mode. In the operating mode, the electric heater 107 is turned on, and the battery heat exchange plate 302, the electric heater 107, the first water pump 1061, the condenser 105, the second power circuit heat exchange plate 405, and the first power circuit heat exchange plate 402 sequentially communicate through a coolant pipe to form a circulation loop, so that a coolant circulating in the circulation loop is heated via the electric heater 107, the first power circuit 401, and the second power circuit 404, to heat the battery 301.

It should be noted that, in the operating mode shown in FIG. 8g, the compressor 2, the first evaporator 103, and the condenser 105 are all in an off state.

When the energy storage device 100 operates in a working condition with a low ambient temperature, in addition to heating the battery via the electric heater 107, another possible manner may be used. For example, in the energy storage device 100 shown in FIG. 7b, the compressor 2 is connected in parallel to the third bypass valve 6. In this case, when the compressor 2 operates in a heating state, the third bypass valve 6 is turned on, to reduce pressure of the compressor 2, so as to heat the battery 301 via heat generated by the compressor 2. For another operating mode of the energy storage device 100 in FIG. 7b, refer to FIG. 8a to FIG. 8g. Details are not described herein again.

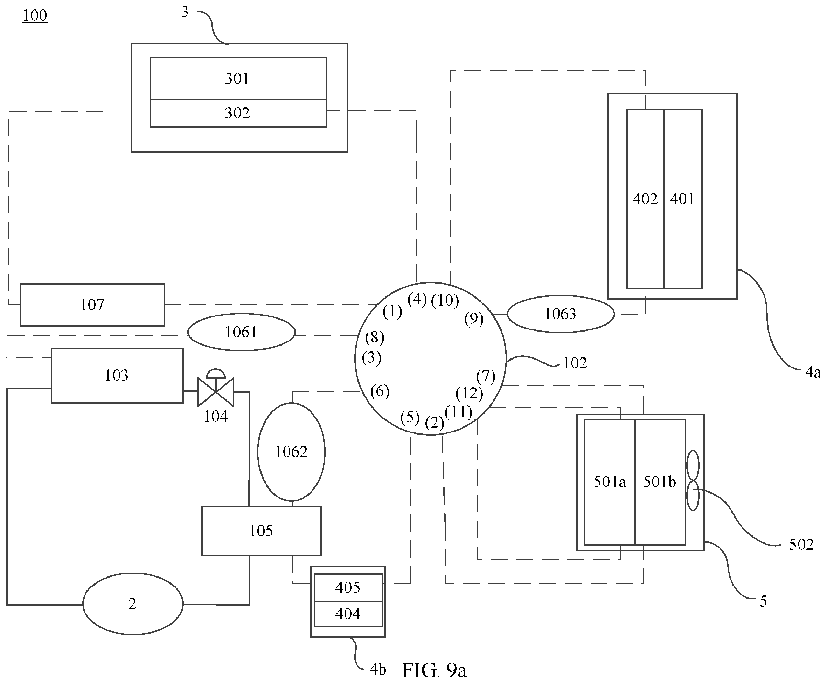

In this embodiment of this application, the multi-way valve may have more than 10 valve ports, to reserve a valve port for connecting to another possible pipe. This helps improve evolvability of the energy storage device 100. For example, refer to FIG. 9a. FIG. 9a is a diagram of another structure of the energy storage device 100 according to an embodiment of this application. In the energy storage device 100, the multi-way valve 102 is a 12-way valve, and the 12-way valve may provide 12 valve ports configured to connect to the first evaporator 103, the condenser 105, or the first interface 1011.

In addition, the radiator module 5 of the energy storage device 100 shown in FIG. 9a includes two radiators, and each radiator may be connected between two first interfaces, so that the two radiators are separately connected to the multi-way valve 102 through different first interfaces. For ease of differentiation, the two radiators may be respectively denoted as a radiator 501a and a radiator 501b. Another structure of the energy storage device shown in FIG. 9a is similar to that of the energy storage device shown in FIG. 7a. Details are not described herein again.

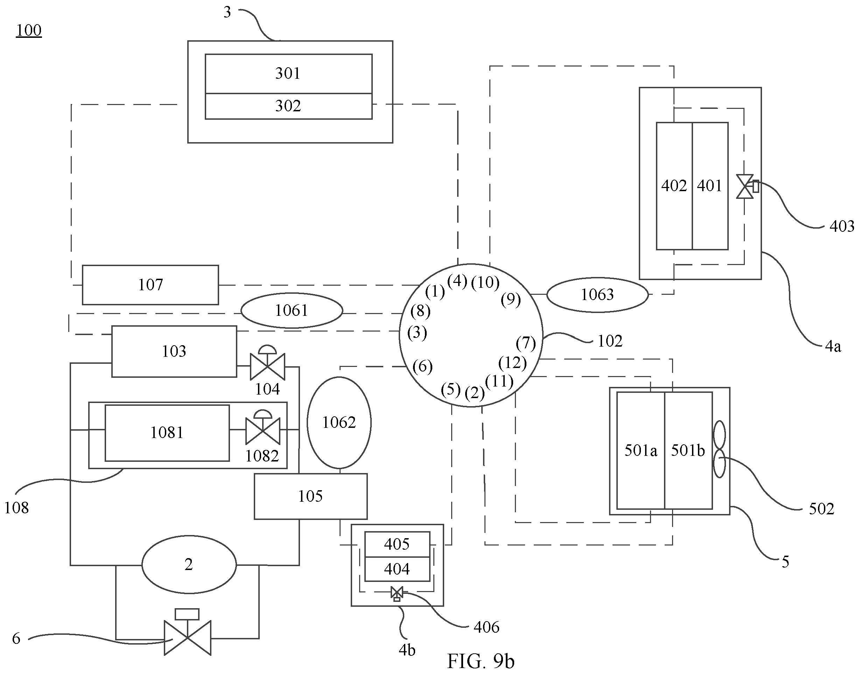

In this application, some adaptive deformation may be further performed on the energy storage device 100 shown in FIG. 9a. For example, refer to FIG. 9b. FIG. 9b is a diagram of another structure of the energy storage device 100 according to an embodiment of this application. Compared with the energy storage device 100 shown in FIG. 9a, in the energy storage device 100 in FIG. 9b, the third bypass valve 6 is added for the compressor 2, and the energy storage device 100 further includes the dehumidification module 108. For specific disposing manners of the third bypass valve 6 and the dehumidification module 108 and functions that can be implemented by the third bypass valve and the dehumidification module, refer to the foregoing embodiment. Details are not described herein again.

In addition, in actual application of the energy storage device 100 shown in FIG. 9a, a state of connection between each of a coolant port of the first evaporator 103 and a coolant port of the condenser 105 and a different first interface may be effectively adjusted via the multi-way valve 102 based on an actual requirement, so that the energy storage device 100 shown in FIG. 9a can operate in a corresponding operating mode.

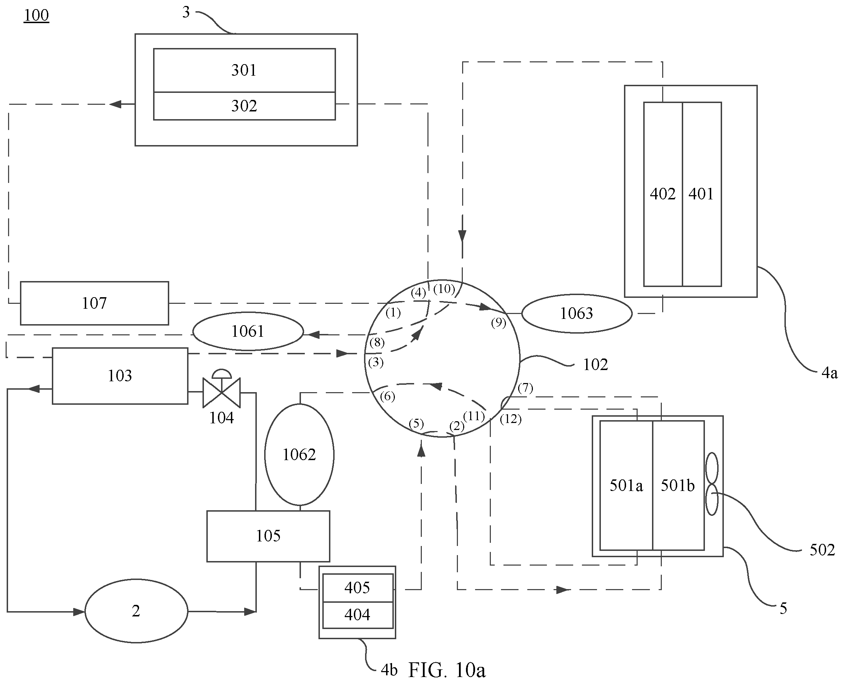

For example, when an ambient temperature is high (for example, in a case of a high temperature and high humidity in summer), refer to FIG. 10a. FIG. 10a is a diagram of a circulation path of the energy storage device 100 shown in FIG. 9a in an operating mode. FIG. 10a shows three circulation loops in the operating mode.

A first circulation loop includes the compressor 2, the condenser 105, the first throttle valve 104, and the first evaporator 103 that sequentially communicate through a refrigerant pipe. In this case, the first circulation loop is a refrigerant circulation loop. When a refrigerant circulates in the circulation loop, the first evaporator 103 may be at a low temperature.

In a second circulation loop, the multi-way valve 102 connects a coolant path between the battery heat exchange plate 302, the first power circuit heat exchange plate 402, and the first evaporator 103, so that the battery heat exchange plate 302, the electric heater 107, a third water pump 1063, the first power circuit heat exchange plate 402, the first water pump 1061, and the first evaporator 103 sequentially communicate through the coolant path. Because a temperature of the first evaporator 103 is low in this case, the first evaporator 103 may cool a coolant circulating in the circulation loop, and the coolant cooled by the first evaporator 103 may exchange heat with the battery heat exchange plate 302 and the first power circuit heat exchange plate 402, to cool the battery heat exchange plate 302 and the first power circuit heat exchange plate 402, so as to dissipate heat of the battery 301 and the first power circuit 401. This can meet a heat dissipation requirement of the first power circuit 401 in an overload working condition, and can ensure reliable operation of the energy storage device 100.

In a third circulation loop, the multi-way valve 102 connects a coolant path between the condenser 105, the second power circuit heat exchange plate 405, the radiator 501b, and the radiator 501a, so that the radiator 501b, the radiator 501a, the second water pump 1062, the condenser 105, and the second power circuit heat exchange plate 405 sequentially communicate through the coolant path. In this case, when a coolant circulates in the circulation loop, the radiator 501b and the radiator 501a may cool both the condenser 105 and the second power circuit heat exchange plate 405. This can improve energy efficiency of the energy storage device 100.

It should be noted that, in the operating mode shown in FIG. 10a, the electric heater 107 is in an off state.

In addition, in another possible embodiment, the battery heat exchange plate 302 may also be cooled via the radiator 501a. For example, in the multi-way valve 102, an interface 12 may communicate with an interface 4, and an interface 1 may communicate with an interface 11. In this case, the battery heat exchange plate 302, the electric heater 107, and the radiator 501a sequentially communicate through a coolant pipe to form a circulation loop, so that a coolant can circulate between the battery heat exchange plate 302 and the radiator 501a, to dissipate heat of the battery heat exchange plate 302 via the radiator 501a.

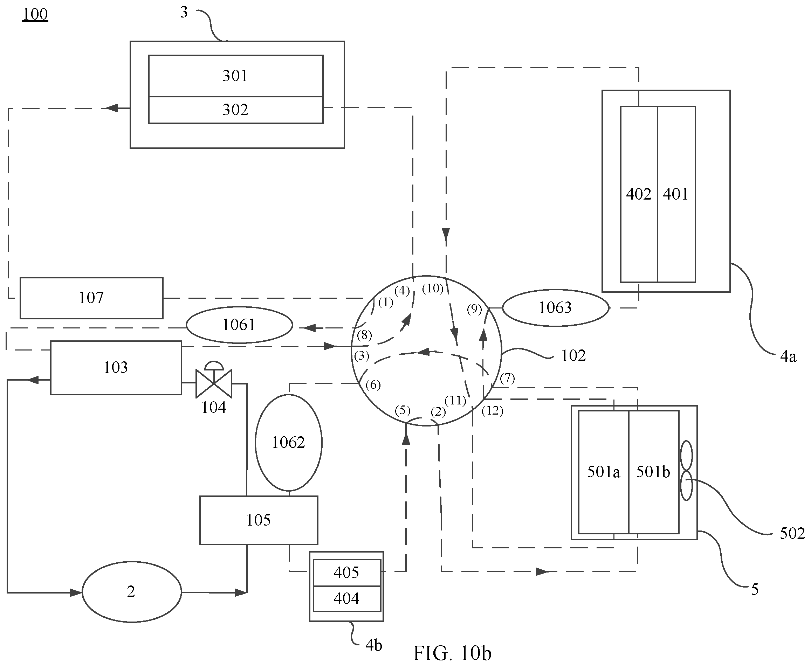

In addition, when an ambient temperature is high (for example, in a case of a high temperature and high humidity in summer), but the first power circuit heat exchange plate 402 operates in a rated load working condition, heat of the first power circuit heat exchange plate 402 may alternatively be dissipated via the radiator module 5. During specific implementation, refer to FIG. 10b. FIG. 10b is a diagram of a circulation path of the energy storage device 100 shown in FIG. 9a in another operating mode. FIG. 10b shows four circulation loops in the operating mode.

A first circulation loop includes the compressor 2, the condenser 105, the first throttle valve 104, and the first evaporator 103 that sequentially communicate through a refrigerant pipe. In this case, the first circulation loop is a refrigerant circulation loop. When a refrigerant circulates in the circulation loop, the first evaporator 103 may be at a low temperature.

In a second circulation loop, the multi-way valve 102 connects a coolant path between the battery heat exchange plate 302 and the first evaporator 103, so that the battery heat exchange plate 302, the electric heater 107, the first water pump 1061, and the first evaporator 103 sequentially communicate through the coolant path. Because a temperature of the first evaporator 103 is low in this case, the first evaporator 103 may cool a coolant circulating in the circulation loop, and the coolant cooled by the first evaporator 103 may exchange heat with the battery heat exchange plate 302, to cool the battery heat exchange plate 302, so as to dissipate heat of the battery 301.

In a third circulation loop, the multi-way valve 102 connects a coolant path between the condenser 105, the second power circuit heat exchange plate 405, and the radiator 501b, so that the radiator 501b, the condenser 105, the second power circuit heat exchange plate 405, and the second water pump 1062 sequentially communicate through the coolant path. In this case, when a coolant circulates in the circulation loop, the radiator 501b may cool both the condenser 105 and the second power circuit heat exchange plate 405. This can improve energy efficiency of the energy storage device 100.

In a fourth circulation loop, the multi-way valve 102 connects a coolant path between the first power circuit heat exchange plate 402 and the radiator 501a, so that the radiator 501a, the third water pump 1063, and the first power circuit heat exchange plate 402 sequentially communicate through the coolant path. In this case, when a coolant circulates in the circulation loop, the radiator 501a may cool the first power circuit heat exchange plate 402. This can improve energy efficiency of the energy storage device 100.

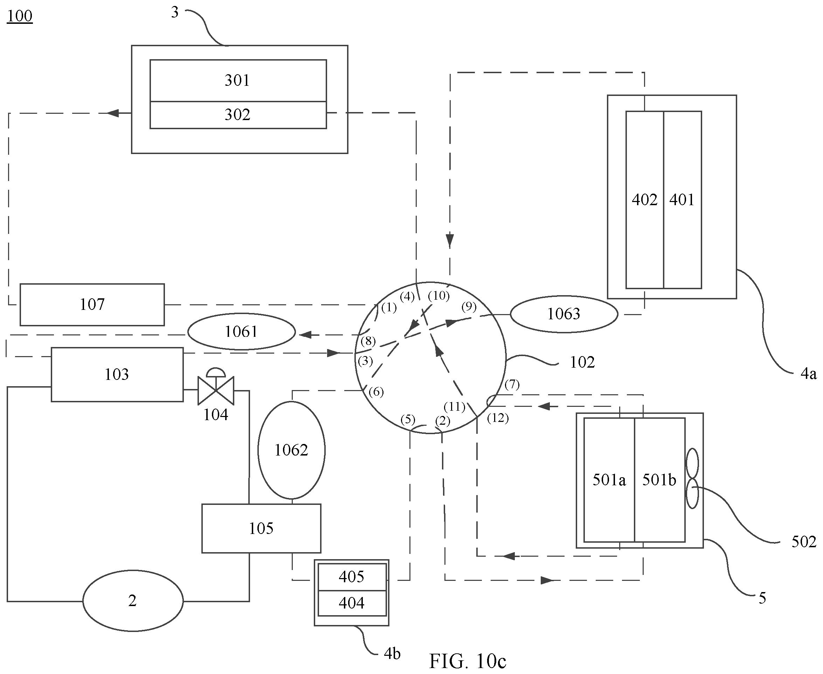

In addition, when an ambient temperature is moderate (for example, in spring or autumn), refer to FIG. 10c. FIG. 10c is a diagram of a circulation path of the energy storage device 100 shown in FIG. 9a in another operating mode. In the operating mode, the multi-way valve 102 connects a coolant path between the battery heat exchange plate 302, the first power circuit heat exchange plate 402, the second power circuit heat exchange plate 405, the radiator 501a, and the radiator 501b, so that the battery heat exchange plate 302, the electric heater 107, the first water pump 1061, the first evaporator 103, the third water pump 1063, the first power circuit heat exchange plate 402, the second water pump 1062, the condenser 105, the second power circuit heat exchange plate 405, the radiator 501b, and the radiator 501a sequentially communicate through the coolant path to form a circulation loop. In this case, when a coolant circulates in the circulation loop, the radiator 501a and the radiator 501b may cool the battery heat exchange plate 302, the first power circuit heat exchange plate 402, and the second power circuit heat exchange plate 405, to dissipate heat of the battery 301, the first power circuit 401, and the second power circuit 404.

It should be noted that, in the operating mode shown in FIG. 10c, the electric heater 107 is in an off state. In addition, when the ambient temperature is temperate, heat dissipation requirements of the battery 301 and the power circuit 301 can be met only via the radiator 501a and the radiator 501b. Therefore, the compressor 2, the first evaporator 103, and the condenser 105 are all in an off state in the operating mode.

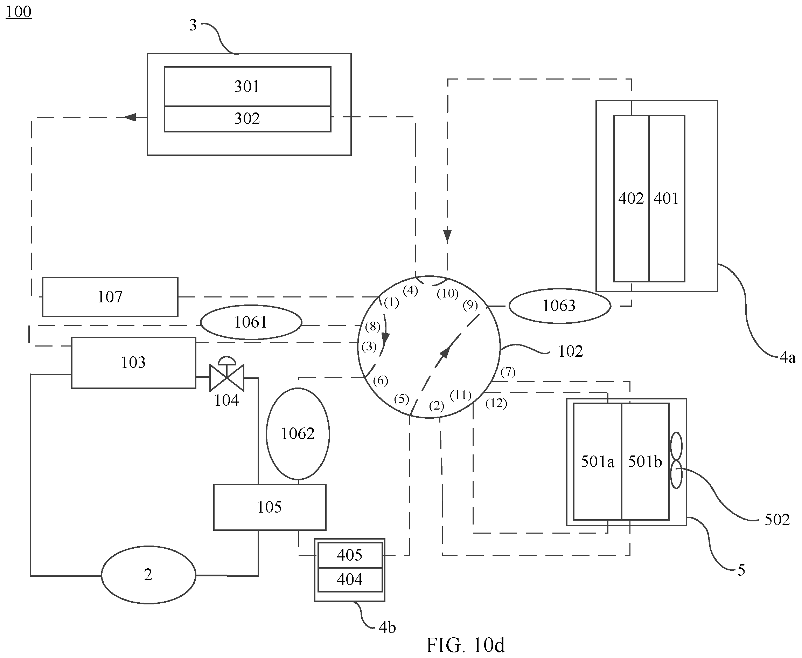

When an ambient temperature is low (for example, in a case of a low temperature in winter), refer to FIG. 10d. FIG. 10d is a diagram of a circulation path of the energy storage device 100 shown in FIG. 9a in another operating mode.

When the energy storage device 100 operates, the first power circuit 401 and the second power circuit 404 always generate a large amount of heat. In the case of the low temperature in winter, to ensure charging and discharging performance of the battery 301, the battery 301 needs to be heated. Therefore, the heat generated by the first power circuit 401 and heat generated by the second power circuit 404 may be used to heat the battery 301. During specific implementation, as shown in FIG. 10d, the multi-way valve 102 connects a coolant path between the battery heat exchange plate 302, the first power circuit heat exchange plate 402, and the second power circuit heat exchange plate 405, so that the battery heat exchange plate 302, the electric heater 107, the first water pump 1061, the condenser 105, the second power circuit heat exchange plate 405, the third water pump 1063, and the first power circuit heat exchange plate 402 sequentially communicate through the coolant path to form a circulation loop. In this case, when a coolant circulates in the circulation loop, the heat generated by the first power circuit 401 and the heat generated by the second power circuit 404 may be transferred to the battery heat exchange plate 302, to heat the battery 301, thereby implementing efficient heat utilization. In the operating mode, the electric heater 107 may be turned on or off as required. Details are not described herein.

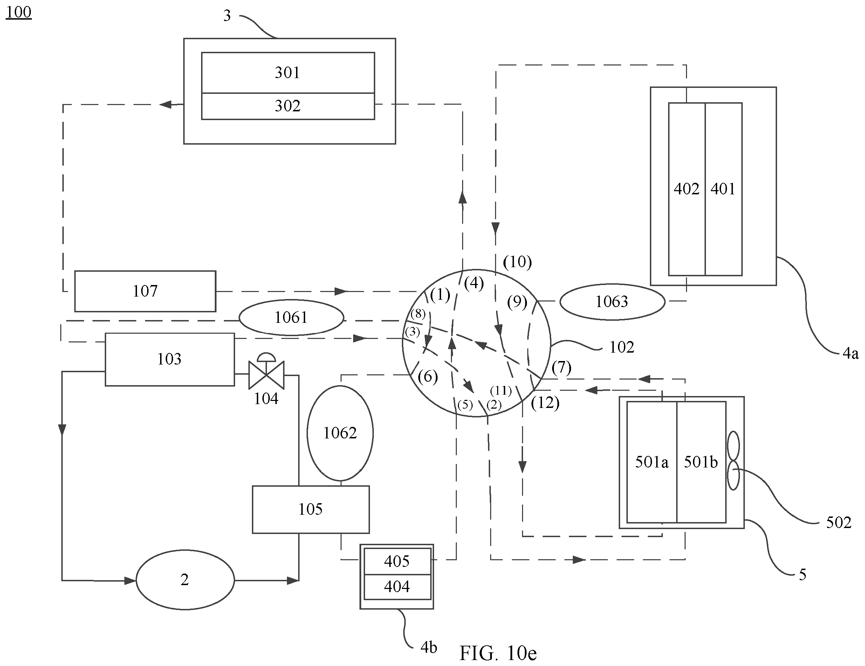

In the operating mode shown in FIG. 10d, the compressor 2, the first evaporator 103, and the condenser 105 are all in an off state. In actual application, as shown in FIG. 10e, both the first throttle valve 104 and the compressor 2 may be set to an on state as required, that is, the condenser 105 has a high temperature according to a working principle of a heat pump, to heat the battery heat exchange plate 302 via the condenser 105. During specific implementation, FIG. 10e shows four circulation loops.

A first circulation loop includes the compressor 2, the condenser 105, the first throttle valve 104, and the first evaporator 103 that sequentially communicate through a refrigerant pipe. In this case, when a refrigerant circulates in the circulation loop, the condenser 105 may have a high temperature.

In a second circulation loop, the multi-way valve 102 connects a coolant path between the battery heat exchange plate 302, the condenser 105, the second power circuit heat exchange plate 405, and the first power circuit heat exchange plate 402, so that the battery heat exchange plate 302, the electric heater 107, the second water pump 1062, the condenser 105, and the second power circuit heat exchange plate 405 sequentially communicate through the coolant path. In this case, when a coolant circulates in the circulation loop, heat generated by the first power circuit 401, heat generated by the second power circuit 404, and heat generated by the condenser 105 may all be transferred to the battery heat exchange plate 302, to heat the battery 301.

In a third circulation loop, the multi-way valve 102 connects a coolant path between the first evaporator 103 and the radiator 501b, so that the first evaporator 103, the radiator 501b, and the first water pump 1061 sequentially communicate through the coolant path. It may be understood that, in a heat pump mode, heat in an environment may be transferred to the condenser 105 via the first evaporator 103. Therefore, when a temperature of the first evaporator 103 is low, to dissipate cold of the first evaporator 103 to increase the temperature of the first evaporator 103, the first evaporator 103 may be heated by the electric heater 107, and heat of the first evaporator 103 may be increased through heat exchange between the radiator 501 and the first evaporator 103.

In a fourth circulation loop, the multi-way valve 102 connects a coolant path between the first power circuit heat exchange plate 402 and the radiator 501a, so that the first power circuit heat exchange plate 402, the radiator 501a, and the third water pump 1063 sequentially communicate through the coolant path. In this case, when a coolant circulates in the circulation loop, the radiator 501a may cool the coolant, to cool the first power circuit heat exchange plate 402, so as to dissipate heat of the power circuit 301.

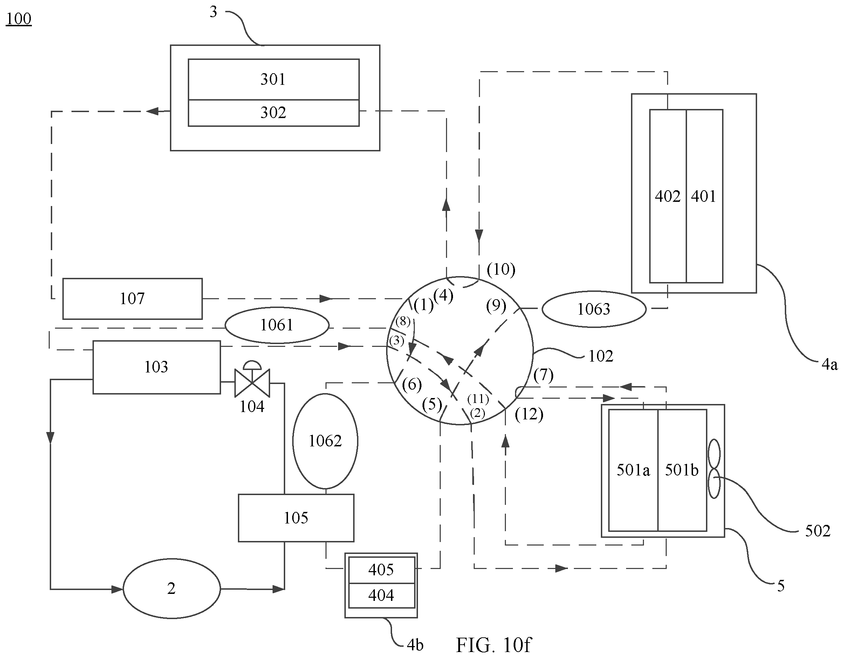

When the energy storage system 100 operates in the heat pump mode, another possible circulation loop may also be formed, provided that the battery heat exchange plate 302 and the condenser 105 are connected in series. For example, refer to FIG. 10f. FIG. 10f shows three circulation loops.

A first circulation loop includes the compressor 2, the condenser 105, the first throttle valve 104, and the first evaporator 103 that sequentially communicate through a refrigerant pipe. In this case, when a refrigerant circulates in the circulation loop, the condenser 105 may have a high temperature.

In a second circulation loop, the battery heat exchange plate 302, the electric heater 107, the second water pump 1062, the condenser 105, the second power circuit heat exchange plate 405, the third water pump 1063, and the first power circuit heat exchange plate 402 sequentially communicate through the coolant path. In this case, when a coolant circulates in the circulation loop, all heat generated by the condenser 105, the first power circuit heat exchange plate 402, and the second power circuit heat exchange plate 405 may be transferred to the battery heat exchange plate 302, to heat the battery 301.

In a third circulation loop, the multi-way valve 102 connects a coolant path between the first evaporator 103, the radiator 501a, and the radiator 501b, so that the first evaporator 103, the radiator 501b, the radiator 501a, and the first water pump 1061 sequentially communicated through the coolant path. In this way, heat of the first evaporator 103 may be increased through heat exchange between each of the radiator 501a and the radiator 501b and the first evaporator 103, to increase the temperature of the first evaporator 103.

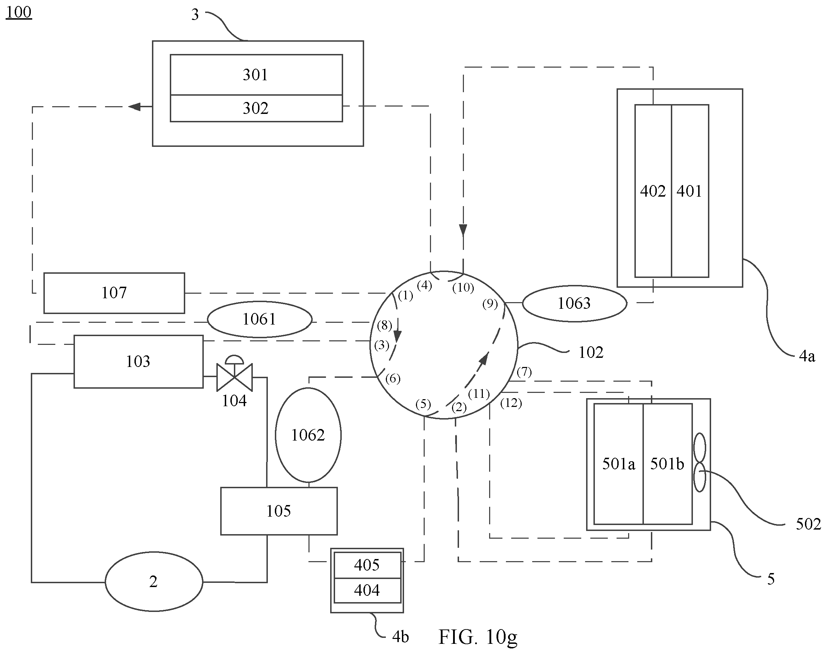

In addition, when the ambient temperature is low (for example, in a case of a low temperature in winter), and neither heat generated by the first power circuit 401 and the second power circuit 404 nor heat generated by the condenser 105 in the heat pump mode can meet a heating requirement of the battery 301, an operating mode of the energy storage device 100 is shown in FIG. 10g. FIG. 10g is a diagram of a circulation path of the energy storage device 100 shown in FIG. 9a in the another operating mode. In this mode, the electric heater 107 is turned on, and the battery heat exchange plate 302, the electric heater 107, the second water pump 1062, the condenser 105, the second power circuit heat exchange plate 405, and the first power circuit heat exchange plate 402 sequentially communicate through a coolant pipe to form a circulation loop, so that a coolant circulating in the circulation loop is heated via the electric heater 107, the first power circuit heat exchange plate 402, and the second power circuit heat exchange plate 405, to heat the battery 301.

It should be noted that, in the operating mode shown in FIG. 10g, the compressor 2, the first evaporator 103, and the condenser 105 are all in an off state.

When the energy storage device 100 operates in a working condition with a low ambient temperature, in addition to heating the battery via the electric heater 107, another possible manner may be used. For example, in the energy storage device 100 shown in FIG. 9b, the compressor 2 is connected in parallel to the third bypass valve 6. In this case, when the compressor 2 operates in a heating state, the third bypass valve 6 is turned on, to reduce pressure of the compressor 2, so as to heat the battery 301 via heat generated by the compressor 2. For another operating mode of the energy storage device 100 in FIG. 9b, refer to FIG. 10a to FIG. 10g. Details are not described herein again.

It may be understood that, according to the energy storage device provided in the foregoing embodiment of this application, in actual application, a quantity of valve bodies of the multi-way valve, a quantity of valve ports, and connection between each valve port and a first interface may be adaptively adjusted based on an actual requirement, and quantities of water pumps and radiators and specific positions for disposing the water pump and the radiator may be adaptively adjusted based on an actual requirement. It should be understood that the adaptive adjustment falls within the protection scope of this application.

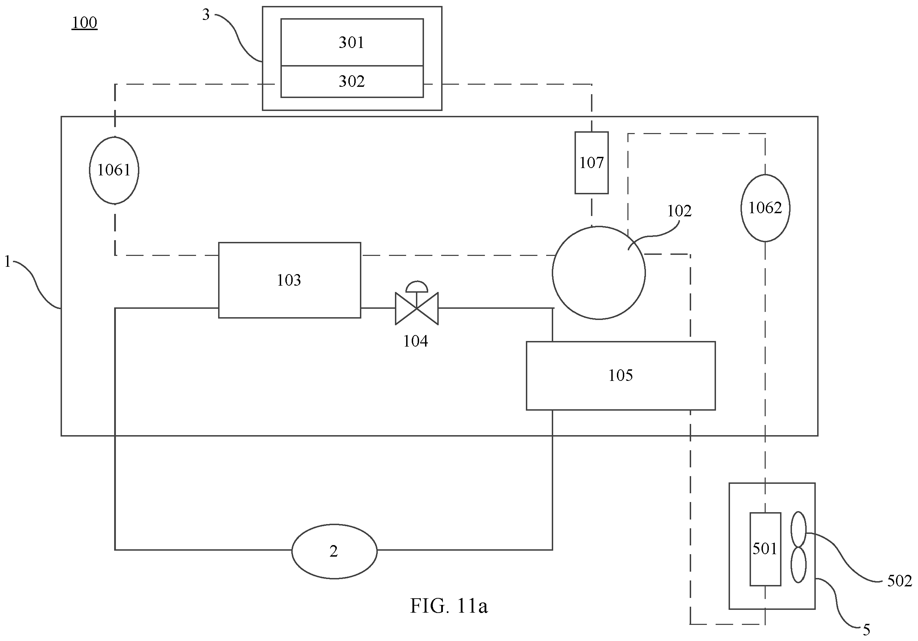

It can be learned from the foregoing descriptions of the energy storage device 100 provided in this embodiment of this application that, based on different operating modes of the energy storage device 100, the battery heat exchange plate 302 may be connected to different coolant circulation loops via the multi-way valve 102, to effectively adjust and control the temperature of the battery 301. For example, when the energy storage device 100 operates in a high-temperature environment, the battery heat exchange plate 302 and the first evaporator 103 may be connected in series to a same coolant circulation loop via the multi-way valve 102, to dissipate heat of the battery heat exchange plate 302 through a refrigerant circulation loop, or the battery heat exchange plate 302 and the radiator 501 may be connected in series to a same coolant circulation loop via the multi-way valve 102, to dissipate heat of the battery heat exchange plate 302 via the radiator 501. During specific implementation, refer to FIG. 11a. FIG. 11a is a diagram of another structure of the energy storage device 100 according to an embodiment of this application. The energy storage device 100 includes the heat management module 1, the compressor 2, the battery module 3, and the radiator module 5. For specific disposing manners and connection relationships of all structures of the energy storage device 100, refer to the foregoing embodiment. Details are not described herein again.

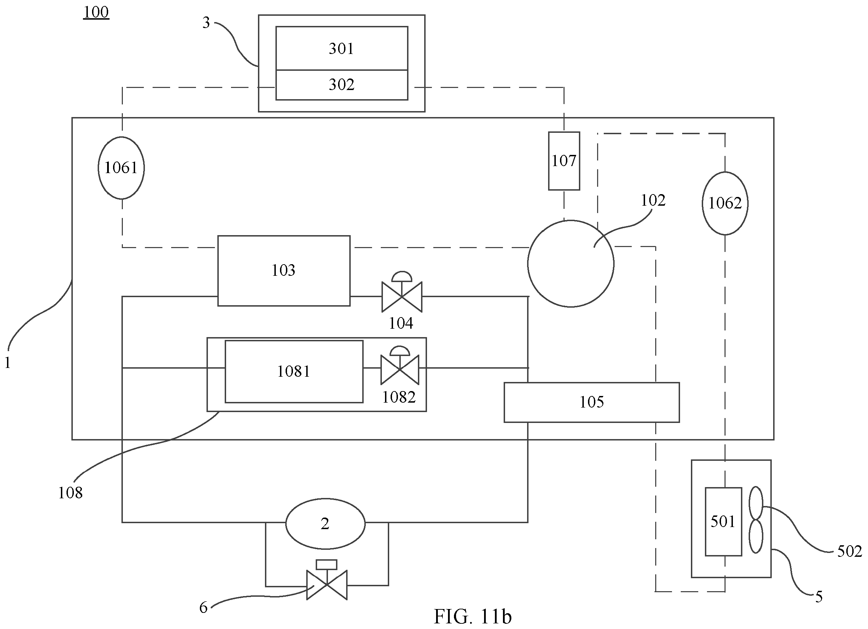

In this application, some adaptive deformation may be further performed on the energy storage device 100 shown in FIG. 11a. For example, refer to FIG. 11b. FIG. 9b is a diagram of another structure of the energy storage device 100 according to an embodiment of this application. Compared with the energy storage device 100 shown in FIG. 9a, in the energy storage device 100 in FIG. 9b, the third bypass valve 6 is added for the compressor 2, and the energy storage device 100 further includes the dehumidification module 108. For specific disposing manners of the third bypass valve 6 and the dehumidification module 108 and functions that can be implemented by the third bypass valve and the dehumidification module, refer to the foregoing embodiment. Details are not described herein again.

In addition, in actual application of the energy storage device 100 shown in FIG. 11a, a state of connection between each of a coolant port of the first evaporator 103 and a coolant port of the condenser 105 and a different first interface may be effectively adjusted via the multi-way valve 102 based on an actual requirement, so that the energy storage device 100 shown in FIG. 11a can operate in a corresponding operating mode.

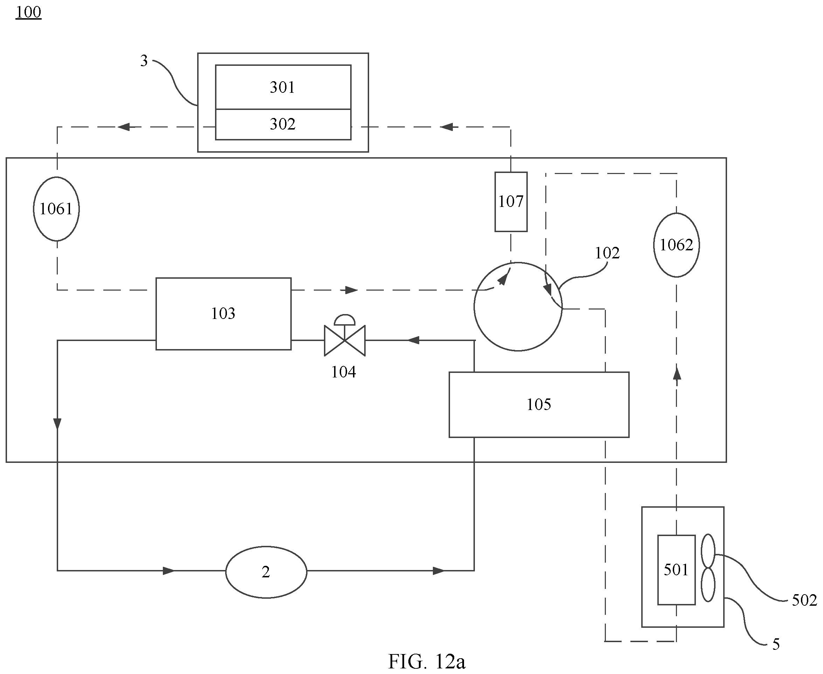

For example, when an ambient temperature is high (for example, in a case of a high temperature and high humidity in summer), refer to FIG. 12a. FIG. 12a is a diagram of a circulation path of the energy storage device 100 shown in FIG. 11a in an operating mode. FIG. 12a shows three circulation loops in the operating mode.

A first circulation loop includes the compressor 2, the condenser 105, the first throttle valve 104, and the first evaporator 103 that sequentially communicate through a refrigerant pipe. In this case, the first circulation loop is a refrigerant circulation loop. When a refrigerant circulates in the circulation loop, the first evaporator 103 may be at a low temperature.

In a second circulation loop, the multi-way valve 102 connects a coolant path between the battery heat exchange plate 302 and the first evaporator 103, so that the battery heat exchange plate 302, the first water pump 1061, the first evaporator 103, and the electric heater 107 sequentially communicate through the coolant path. Because a temperature of the first evaporator 103 is low in this case, the first evaporator 103 may cool a coolant circulating in the circulation loop, and the coolant cooled by the first evaporator 103 may exchange heat with the battery heat exchange plate 302, to cool the battery heat exchange plate 302, so as to dissipate heat of the battery 301. This can meet a heat dissipation requirement of the battery 301 in an overload working condition, and can ensure reliable operation of the energy storage device 100.

In a third circulation loop, the multi-way valve 102 connects a coolant path between the condenser 105 and the radiator 501, so that the radiator 501, the second water pump 1062, and the condenser 105 sequentially communicate through the coolant path. In this case, when a coolant circulates in the circulation loop, the radiator 501 may cool the condenser 105.

It should be noted that, in the operating mode shown in FIG. 12a, the electric heater 107 is in an off state.

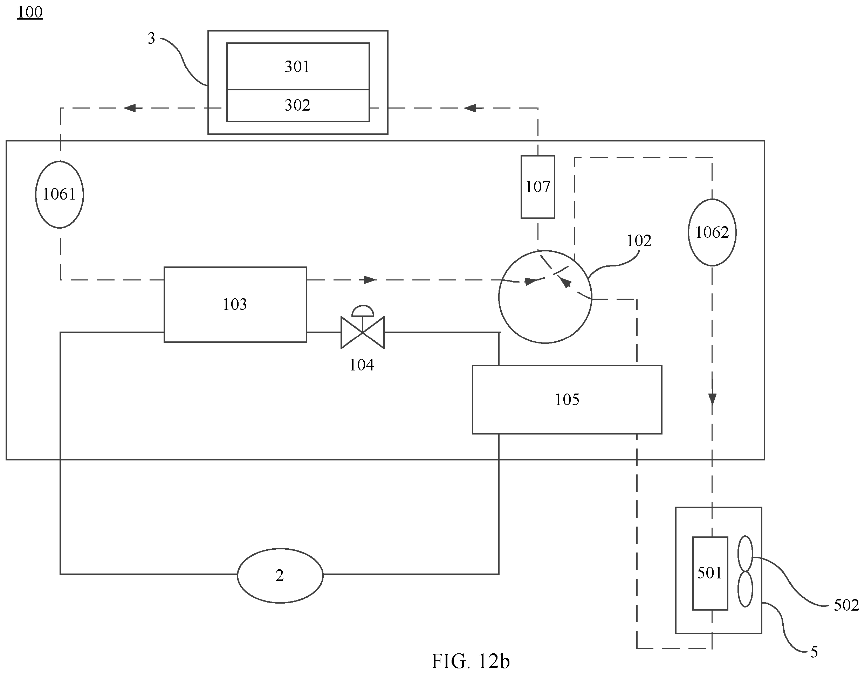

In addition, when an ambient temperature is moderate (for example, in spring or autumn), refer to FIG. 12b. FIG. 12b is a diagram of a circulation path of the energy storage device 100 shown in FIG. 11a in another operating mode. In the operating mode, the multi-way valve 102 connects a coolant path between the battery heat exchange plate 302 and the radiator 501, so that the battery heat exchange plate 302, the first water pump 1061, the first evaporator 103, the second water pump 1062, the radiator 501, and the electric heater 107 sequentially communicate through the coolant path to form a circulation loop. In this case, when a coolant circulates in the circulation loop, the radiator 501 may cool the battery heat exchange plate 302, to dissipate heat of the battery 301.

It should be noted that, in the operating mode shown in FIG. 12b, the electric heater 107 is in an off state. In addition, when the ambient temperature is temperate, heat dissipation requirements of the battery 301 and the power circuit 301 can be met only via the radiator 501. Therefore, the compressor 2, the first evaporator 103, and the condenser 105 are all in an off state in the operating mode. In addition, when the battery 301 operates in an overload condition, an amount of heat generated by the battery is large. Therefore, a plurality of fans 502 may be disposed in the radiator module 5, to dissipate heat of the radiator 501 via the plurality of fans 502, so as to improve cooling efficiency of the radiator 501 for the coolant. This can meet a heat dissipation requirement of the battery 301.

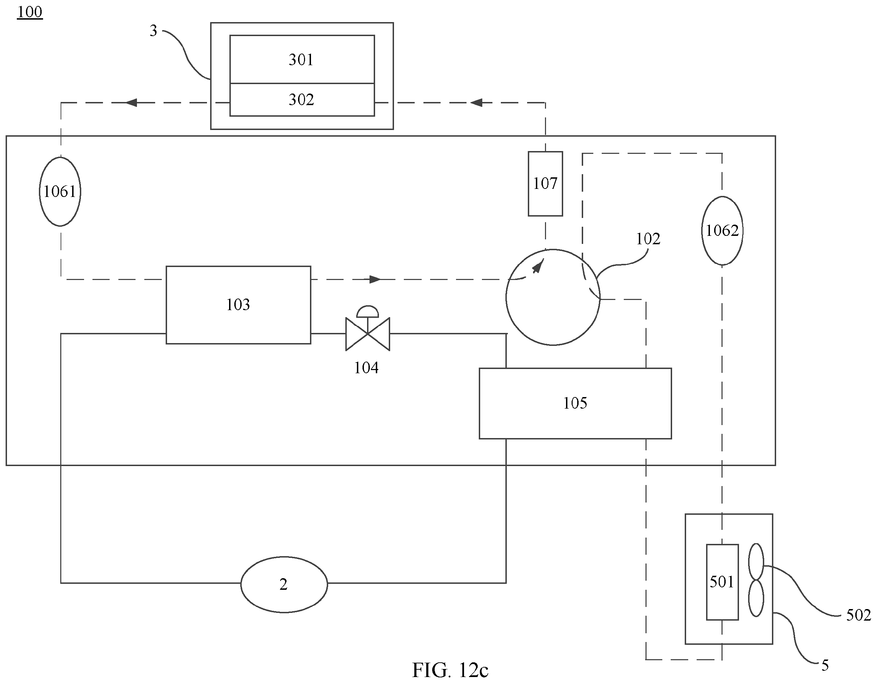

When an ambient temperature is low (for example, in a case of a low temperature in winter), refer to FIG. 12c. FIG. 12c is a diagram of a circulation path of the energy storage device 100 shown in FIG. 11a in another operating mode. In this mode, the electric heater 107 is turned on, and the battery heat exchange plate 302, the first water pump 1061, the first evaporator 103, and the electric heater 107 sequentially communicate through a coolant pipe to form a circulation loop, so that a coolant circulating in the circulation loop is heated via the electric heater 107, to heat the battery 301.

When the energy storage device 100 operates in a working condition with a low ambient temperature, in addition to heating the battery via the electric heater 107, another possible manner may be used. For example, in the energy storage device 100 shown in FIG. 11b, the compressor 2 is connected in parallel to the third bypass valve 6. In this case, when the compressor 2 operates in a heating state, the third bypass valve 6 is turned on, to reduce pressure of the compressor 2, so as to heat the battery 301 via heat generated by the compressor 2. For another operating mode of the energy storage device 100 in FIG. 11b, refer to FIG. 12a to FIG. 12c. Details are not described herein again.

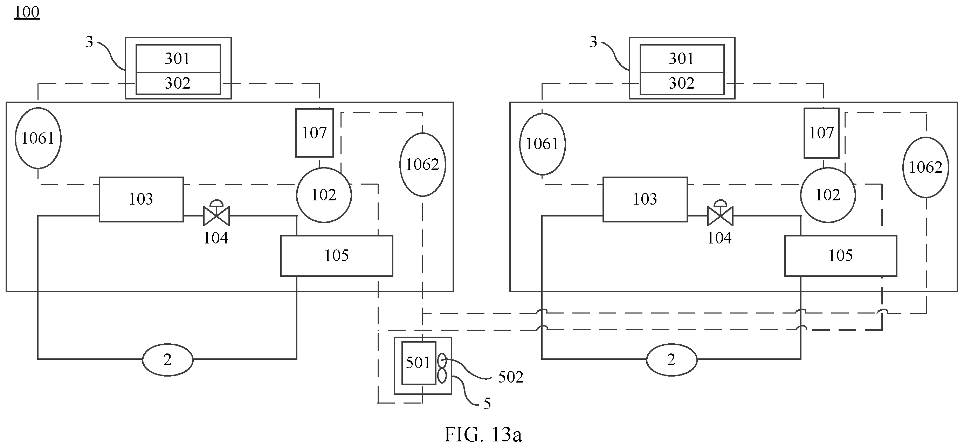

In some application scenarios, a plurality of energy storage devices 100 may be disposed at the same time, and the plurality of energy storage devices 100 form an energy storage device group. To ensure operating reliability and safety of the energy storage device group, heat management needs to be performed on each energy storage device 100. FIG. 13a is a diagram of a structure of an energy storage device group according to an embodiment of this application. The energy storage device group includes two energy storage devices 100, and the two energy storage devices 100 share one radiator module 5. Other structures of the two energy storage devices 100 may be disposed with reference to FIG. 11a. Details are not described herein again.

In the energy storage device group, two energy storage devices 100 share one radiator module 5, to adjust and control temperatures of the two energy storage devices 100 via the one radiator module 5. This can effectively reduce costs of the energy storage device group, and synchronously adjust and control the energy storage devices 100 in the energy storage device group, to implement temperature adjustment control consistency for the energy storage devices, thereby improving operating reliability of the energy storage device group.

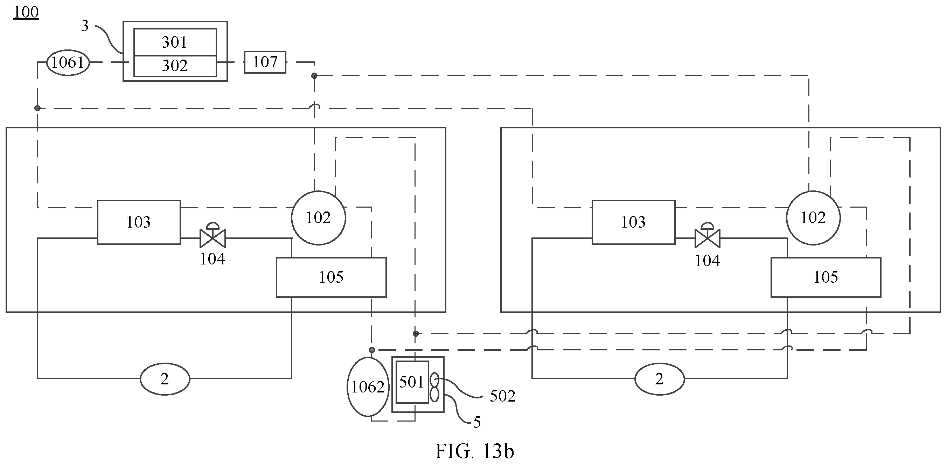

In addition, refer to FIG. 13b. FIG. 13b is a diagram of another structure of the energy storage device group according to an embodiment of this application. Different from the energy storage device group shown in FIG. 13a, in the energy storage device group shown in FIG. 13b, positions of the first water pump 1061, the second water pump 1062, and the electric heater 107 are adjusted, so that energy storage devices can share the water pump and the electric heater. This can reduce quantities of water pumps and electric heaters while adjusting and controlling a temperature of the battery 301, and further reduce costs of the energy storage device group.

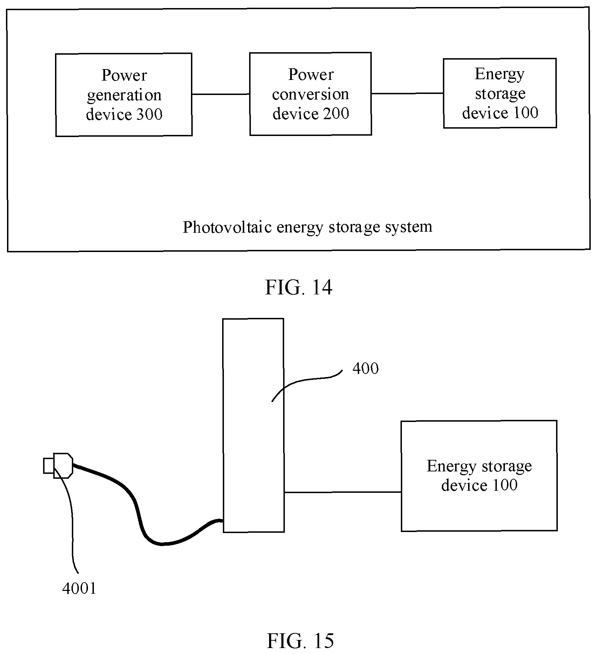

The energy storage device provided in the foregoing embodiment of this application may be used in various energy storage scenarios. FIG. 14 is a diagram of a structure of a photovoltaic energy storage system according to an embodiment of this application. The photovoltaic energy storage system may include a power conversion device 200, a power generation device 300, and the foregoing energy storage device 100. The power conversion device 200 is connected between the power generation device 300 and the energy storage device 100. The power generation device 300 is configured to store generated electric energy into a battery of the energy storage device 100 via the power conversion device 200. The photovoltaic energy storage system is applied to the energy storage device 100 provided in the foregoing embodiment. This can effectively improve operating safety of the photovoltaic energy storage system.

In addition, the energy storage device 100 provided in embodiments of this application may be further used in a charging network. For example, refer to FIG. 15. FIG. 15 is a diagram of a structure of a charging network according to an embodiment of this application. The charging network includes a charging pile 400 and the foregoing energy storage device 100. The charging pile 400 is electrically connected to a battery in the energy storage device 100 through a cable, and the battery may supply electric energy stored in the battery to the charging pile 400. The charging pile 400 includes a connector 4001, and the connector 4001 may be connected to a powered device (for example, a vehicle), to supplement energy to the powered device. The energy storage device 100 provided in the foregoing embodiment is used in the charging network. This can effectively improve safety of the charging network, and helps improve flexibility of deploying the charging network.

During specific disposition, the charging network may include a plurality of charging piles 400, and each energy storage device 100 may supply electric energy to the plurality of charging piles 400, thereby effectively improving flexibility of deployment.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An energy storage device, comprising a heat management module, a battery module, a first power unit, a second power unit, and a radiator module, wherein
the heat management module comprises a housing, and a multi-way valve, a first evaporator, and a condenser that are disposed in the housing, the housing comprises a plurality of first interfaces, two coolant ports of the first evaporator are connected to the multi-way valve, and two coolant ports of the condenser are connected between the multi-way valve and one of the first interfaces;
the battery module comprises a battery and a battery heat exchange plate, the battery is in contact with the battery heat exchange plate, and two coolant ports of the battery heat exchange plate each are connected to the multi-way valve through one of the first interfaces;
the first power unit comprises a power conversion system and a first power circuit heat exchange plate, the power conversion system is in contact with the first power circuit heat exchange plate, and two coolant ports of the first power circuit heat exchange plate each are connected to the multi-way valve through one of the first interfaces;
the second power unit comprises a direct current converter and a second power circuit heat exchange plate, the direct current converter is in contact with the second power circuit heat exchange plate, and two coolant ports of the second power circuit heat exchange plate each are connected to the multi-way valve through one of the first interfaces; and
the radiator module comprises a radiator, and two coolant ports of the radiator each are connected to the multi-way valve through one of the first interfaces.

2. The energy storage device according to claim 1, wherein the heat management module further comprises a first throttle valve, the first throttle valve is disposed in the housing, the energy storage device further comprises a compressor, and the compressor, the first evaporator, the first throttle valve, and the condenser are sequentially connected through a refrigerant pipe.

3. The energy storage device according to claim 1 or 2, wherein the battery heat exchange plate and the first power circuit heat exchange plate are connected in series or in parallel and connected between two valve ports of the multi-way valve through the first interface; or
the two coolant ports of the first power circuit heat exchange plate and the two coolant ports of the battery heat exchange plate are connected to different valve ports of the multi-way valve through different first interfaces in the first interfaces respectively.

4. The energy storage device according to any one of claims 1 to 3, wherein the battery heat exchange plate and the second power circuit heat exchange plate are connected in series or in parallel and connected between two valve ports of the multi-way valve through the first interface; or
the two coolant ports of the second power circuit heat exchange plate and the two coolant ports of the battery heat exchange plate are connected to different valve ports of the multi-way valve through different first interfaces in the first interfaces respectively.

5. The energy storage device according to any one of claims 1 to 4, wherein the multi-way valve is connected between the first power circuit heat exchange plate and the first evaporator, and the multi-way valve is configured to connect or disconnect a coolant path between the first power circuit heat exchange plate and the first evaporator.

6. The energy storage device according to claim 1, wherein the second power circuit heat exchange plate and the condenser are connected in series or in parallel through the first interface and connected between two valve ports of the multi-way valve.

7. The energy storage device according to claim 6, wherein the first power circuit heat exchange plate and the second power circuit heat exchange plate are connected in series or in parallel through the first interface and connected between two valve ports of the multi-way valve.

8. The energy storage device according to claim 1, wherein the energy storage device further comprises a first water pump, and the battery heat exchange plate and the first water pump are connected in series and connected between two valve ports of the multi-way valve through the first interface;
one coolant port of the first power circuit heat exchange plate, one coolant port of the second power circuit heat exchange plate, and one coolant port of the condenser each are connected to one valve port of the multi-way valve, and the other coolant port of the first power circuit heat exchange plate and the other coolant port of the second power circuit heat exchange plate each are connected to another valve port of the multi-way valve; and
a liquid outlet of the first water pump is connected to one coolant port of the first power circuit heat exchange plate and one coolant port of the second power circuit heat exchange plate, and a liquid inlet of the first water pump is connected to the other coolant port of the first power circuit heat exchange plate and the other coolant port of the second power circuit heat exchange plate.

9. The energy storage device according to claim 8, wherein the energy storage device further comprises a first three-way valve and a second three-way valve, one coolant port of the first power circuit heat exchange plate, one coolant port of the second power circuit heat exchange plate, and the liquid outlet of the first water pump are respectively connected to three valve ports of the first three-way valve in a one-to-one correspondence, and the other coolant port of the first power circuit heat exchange plate, the other coolant port of the second power circuit heat exchange plate, and the liquid inlet of the first water pump are respectively connected to three valve ports of the second three-way valve in a one-to-one correspondence.

10. The energy storage device according to any one of claims 1 to 9, wherein the multi-way valve is connected between the battery heat exchange plate and the first evaporator, and the multi-way valve is configured to connect or disconnect a coolant path between the battery heat exchange plate and the first evaporator.

11. The energy storage device according to any one of claims 1 to 10, wherein the multi-way valve is connected between the battery heat exchange plate and the condenser, and the multi-way valve is configured to connect or disconnect a path between the battery heat exchange plate and the condenser.

12. The energy storage device according to any one of claims 1 to 11, wherein the radiator module comprises two radiators, and two coolant ports of each of the two radiators are connected to different valve ports of the multi-way valve through different first interfaces respectively.

13. The energy storage device according to claim 12, wherein the multi-way valve is connected between the first power circuit heat exchange plate and one of the radiators, and the multi-way valve is configured to connect or disconnect a path between the first power circuit heat exchange plate and the one of the radiators.

14. The energy storage device according to claim 12 or 13, wherein the multi-way valve is further connected between the condenser and the other of the radiators, and the multi-way valve is configured to connect or disconnect a path between the condenser and the other of the radiators.

15. The energy storage device according to any one of claims 1 to 14, wherein the first power unit further comprises a first bypass valve, and the first bypass valve and the first power circuit heat exchange plate are disposed in parallel; or the second power unit further comprises a second bypass valve, and the second bypass valve and the second power circuit heat exchange plate are disposed in parallel.

16. A photovoltaic energy storage system, comprising a power generation device, a power conversion device, and the energy storage device according to any one of claims 1 to 15, wherein the power conversion device is connected between the power generation device and the energy storage device, and the power generation device is configured to store generated electric energy into a battery of the energy storage device via the power conversion device.
